(19)

**Europäisches Patentamt**
**European Patent Office**
**Office européen des brevets**

(11) **EP 4 207 317 A1**

(12) **EUROPEAN PATENT APPLICATION**

(43) Date of publication:
05.07.2023 Bulletin 2023/27

(21) Application number: 22217226.4

(22) Date of filing: 29.12.2022

(51) International Patent Classification (IPC):
*H01L 31/05* (2014.01)        *H01L 31/0352* (2006.01)
*H01L 31/054* (2014.01)       *H02S 40/22* (2014.01)
*H02S 40/30* (2014.01)        *H02S 40/34* (2014.01)

(52) Cooperative Patent Classification (CPC):
**H01L 31/035281; H01L 31/0504; H01L 31/0516;**
**H01L 31/054; H02S 40/22; H02S 40/30;**
**H02S 40/34**

(84) Designated Contracting States:
**AL AT BE BG CH CY CZ DE DK EE ES FI FR GB**
**GR HR HU IE IS IT LI LT LU LV MC ME MK MT NL**
**NO PL PT RO RS SE SI SK SM TR**
Designated Extension States:
**BA**
Designated Validation States:
**KH MA MD TN**

(30) Priority: **30.12.2021 US 202163295177 P**

(71) Applicant: **Solaredge Technologies Ltd.**
**Herzeliya 4673335 (IL)**

(72) Inventors:
• **YOSCOVICH, Ilan**
**4673335 Herzeliya (IL)**
• **LOEWENSTERN, Yakir**
**4673335 Herzeliya (IL)**

(74) Representative: **V.O.**
**P.O. Box 87930**
**2508 DH Den Haag (NL)**

(54) **MIXED PHOTOVOLTAIC MODULES**

(57)    Aspects of the present disclosure relate to configurations of mixed photovoltaic cell arrays and mixed photovoltaic modules having substrings of monofacial photovoltaic cells and bifacial photovoltaic cells. Further aspects relate to mixed photovoltaic cell arrays and mixed photovoltaic modules having substrings of differently sized and/or cut photovoltaic cells. Substrings of electrically serially connected photovoltaic cells may be connected to one another in parallel or series-parallel. Mixed photovoltaic cell arrays may be disposed upon mixed photovoltaic module backsheets having various regions of varying levels of transparency.

*FIG. 1*

EP 4 207 317 A1

**Description**

CROSS-REFERENCE TO RELATED APPLICATIONS

This application claims priority to U.S. Provisional Application No. 63/295,177, filed on December 30, 2021, titled "Mixed Photovoltaic Modules," the contents of which are incorporated herein by reference in their entirety.

FIELD

Aspects of the present disclosure relate generally to photovoltaic (PV) cell arrays in PV modules. In particular, one or more aspects of the present disclosure relate to apparatuses systems and methods for arrangements of monofacial and bifacial PV cell substrings and multi-sized PV cells in a PV cell array and PV module.

BACKGROUND

As the world moves from non-renewable energy sources, efficient and reliable renewable energy sources grow ever more important. One important renewable energy source is photovoltaic (PV) electrical energy. As a relatively cheap and clean energy option, photovoltaics are crucial to the shift away from non-renewable energy.
However, current PV solutions have their limitations. One major limitation in PV energy production is low PV conversion efficiency (the percentage of incident solar energy converted to electricity). An additional issue is the mismatch or partial shading condition problem. In order to obtain useful power from a PV module, multiple PV cells are generally connected serially in a string to provide a useful electrical potential and current output from the string. However, if one or more PV cells in a series connected string experiences reduced irradiation and/or reduced current production due to partial or complete shading, the production of the entire series connected string may be reduced.
Therefore improved apparatuses, systems, and methods are needed to address the aforementioned deficiencies.

SUMMARY

Aspects of the disclosure provide technical solutions that overcome one or more of the problems described above and/or other technical challenges. For example aspects of the present disclosure novel PV cell array topologies to maximize and improve efficiency of photovoltaic (PV) modules and PV cell arrays. For instance, one or more aspects of the disclosure relate to PV modules including a first plurality of PV cells arranged in one or more first substrings and a second plurality of PV cells arranged in one or more second substrings. The first plurality of PV cells and second plurality of PV cells may include differently sized PV cells.

One or more additional aspects of the present disclosure may relate to a photovoltaic module that may include a first plurality of photovoltaic cells arranged in one or more first substrings, and a second plurality of photovoltaic cells arranged in one or more second substrings. The first plurality of photovoltaic cells may be configured to receive a first irradiance and the second plurality of photovoltaic cells may be configured to receive a second irradiance. The first irradiance level may be greater than the second irradiance level.
These and other features and advantages are described in greater detail below.

BRIEF DESCRIPTION OF THE DRAWINGS

These and other features, aspects, and advantages of the present disclosure will become better understood with regard to the following description, claims, and drawings. The present disclosure is depicted by way of example, and not limited by, the accompanying figures. A more complete understanding of the present disclosure and the advantages thereof may be acquired by referring to the following description in consideration of the accompanying drawings, in which like reference numbers indicate like features, and wherein:

FIG. 1 depicts an example mixed PV cell array according to one or more aspects of the present disclosure as described herein.

FIG. 2 depicts an example mixed PV cell array and its associated example mixed backsheet according to one or more aspects of the present disclosure as described herein.

FIG. 3A depicts an example mixed PV cell array according to one or more aspects of the present disclosure as described herein.

FIG. 3B depicts an example PV cell array according to one or more aspects of the present disclosure as described herein.

FIG. 4 depicts an example mixed PV cell array according to one or more aspects of the present disclosure as described herein.

FIGS. 5A - 5E depict example mixed PV cell arrays according one or more aspects of the present disclosure as described herein.

FIG. 6A depicts an example mixed PV cell array according to one or more aspects of the present disclosure as described herein.

FIG. 6B depicts an example mixed PV cell array according to one or more aspects of the present disclosure as described herein.

FIG. 6C depicts an example mixed PV module array of mixed PV modules of mixed PV cell arrays of either FIGS. 6A and/or 6B according to one or more embodiments as described herein.

FIG. 6D depicts an example mixed PV module array of mixed PV modules according to one or more aspects of the present disclosure as described herein.

FIG. 6E depicts an example mixed PV module array of mixed PV modules according to one or more aspects of the present disclosure as described herein.

FIG. 7 depicts an example mixed PV cell array according to one or more aspects of the present disclosure as described herein.

FIGS. 8A - 8E depict example mixed PV cell arrays according to one or more aspects of the present disclosure as described herein.

FIG. 9 depicts an example mixed PV cell array according to one or more aspects of the present disclosure as described herein.

FIG. 10 depicts an example mixed PV cell array according to one or more aspects of the present disclosure as described herein.

FIG. 11 depicts an example conductive backsheet of PV cell array of FIG. 1 according to one or more aspects of the present disclosure as described herein.

FIG. 12 depicts example power electronics (PEs) according to one or more aspects of the present disclosure as described herein.

FIGS. 13A - 13D depict various illustrations of module level power electronic (MI,PE) integration according to one or more aspects of the present disclosure as described herein.

FIG. 14A depicts an example mixed PV module and example mixed PV cell array circuit with PE integration on the PV module, or multi-module level according to one or more aspects of the present disclosure as described herein.

FIG. 14B depicts an example mixed PV module and example mixed PV cell array circuit with PE integration on the substring level and PV module or multi-PV module level according to one or more aspects of the present disclosure as described herein.

## DETAILED DESCRIPTION

In the following description, reference is made to the accompanying drawings, which form a part hereof, and in which is shown, by way of example. It is understood that other configurations may be utilized and structural and functional modifications may be made, without departing from the scope of the present disclosure.

Photovoltaic (PV) generators, for example, PV cells, strings of PV cells, PV cell arrays, PV modules and PV module arrays may create electrical power when irradiated by solar energy. It may be advantageous to increase the electrical energy production and/or efficiency of any given PV generator to produce the maximum amount of electrical energy from incident solar energy. For the present disclosure, a plurality of PV cells may be electrically serially connected to form substrings. A plurality of substrings may be arranged in relation to one another to form PV cell arrays (e.g., mixed PV cell array as described herein). A PV cell array may be disposed upon a backsheet (e.g., backsheets and or mixed backsheets as described herein). One or more layers may or may not be disposed between the PV cell array and backsheet. Additional layers and components may be added to the PV cell array and backsheet to form a PV module (e.g., mixed PV module as described herein).

PV cells may produce electrical energy when irradiated with solar energy on either a frontside face and/or a backside face. In some installations, PV cells are used in a monofacial application. In such applications, the PV cells, the PV cell array, and the PV module may be designed to facilitate single face irradiance (e.g., frontside face irradiance). For example, a PV module designed for a monofacial irradiance application, may include a clear frontsheet but an opaque backsheet (such that no external irradiance may reach the PV cells from the backside). Additionally, a PV cell designed for monofacial irradiance (e.g., monofacial suited PV cell) may include metallized fingers to facilitate current collection on only a single face (e.g., frontside face). Alternatively, monofacial PV cells may include metallized fingers to facilitate current collection on both a frontside face and a backside face. In some installations, PV cells may be used in a bifacial irradiance application. In such applications, the PV cells, PV cell arrays, and PV modules may be designed to facilitate frontside face irradiance and backside face irradiance. For example, a PV module designed for bifacial irradiance, may include a clear, or otherwise increased transparency, frontsheet and backsheet such that the PV cells may be irradiated on their frontside faces and/or their backside faces. Further, in some applications, it may be advantageous to utilize monofacial suited or bifacial suited PV cells with only a single increased transparency sheet (e.g., clear glass topsheet) and a decreased transparency but reflective backsheet. Such a reflective backsheet may reflect some frontside irradiance back at the PV cells increasing the PV cell electrical production. Additionally, a PV cell designed for bifacial irradiance (e.g., a bifacial suited PV cell) may include metallized fingers on both a frontside face and a backside face to facilitate current collection produced by the PV cell. However, variously designed PV cells may be variously used in various PV cell arrays and various PV modules. With regards to bifacial irradiance suited PV modules, on the backside of such PV modules, due to PV module installation considerations, more solar energy may be incident on the PV cells around the edges of the PV module than on the PV cells of the inner portion of the PV module. This may be because, for example, the inner portion of a PV module may have less exposure to direct solar radiation and/or reflected solar radiation.

Therefore, it may be advantageous for the present disclosure to define two categories of PV cells and substrings: "enhanced" PV cells and substrings, and "standard" PV cells and substrings. Enhanced PV cells and substrings may refer to monofacial suited PV cells and/or bifacial suited PV cells disposed upon a reflective backsheet in particular areas of mixed PV cell array as will be described herein. Alternatively, enhanced PV cells and substrings may refer to bifacial suited PV cells and substrings disposed upon an increased transparency backsheet in particular areas of mixed PV cell array as will be described herein (e.g., around a perimeter of a mixed PV cell array that may experience increased backside irradiance). Standard PV cells and substrings may refer to monofacial suited PV cells and substrings disposed upon a decreased transparency and non-reflective backsheet in particular areas of a mixed PV cell array. Alternatively, standard PV cells and substrings may refer to bifacial suited PV cells disposed upon an increased transparency backsheet in areas of decreased backside irradiance. There may be advantages to a mixed PV module or mixed PV cell array having both standard and enhanced regions. Enhanced PV cells and substrings may experience increased irradiance as compared to standard PV cells and standard substrings. The mixed PV cell arrays and topologies of the present disclosure may relate to achieving increased irradiance and production of certain substrings (e.g., enhanced substrings) in a mixed PV cell array as compared to others (e.g., standard substrings). Further, the mixed PV cell arrays and topologies of the present disclosure may relate to the electrical interconnection of such differently producing substrings in a single mixed PV cell array.

PV cells of the present disclosure may include, but are not limited to, monocrystalline silicon, polycrystalline silicon, thin film, gallium arsenide, multi-junction, perovskite, organic solar cells, dye-sensitized solar cells, quantum dots, etc. Further, PV cells of the present disclosure may be ribbon connected (as described herein), shingled connected (as described herein), and/or rear contact and conductive backsheet connected (as described herein).

PV cell arrays may typically contain strings (e.g., substrings herein) of serially connected PV generators (e.g., PV cells). A mismatch condition may exist where a portion of the string is producing less electrical energy than other portions of the string. This may happen, for example where a portion of a string experiences reduced irradiance, for example, if a portion of the string (e.g., a single PV cell) is shaded. This may also be referred to as the partial shade condition. In this mismatch condition, a string of PV generators may operate according to the weakest member. Therefore, a reduced irradiated PV cell may absorb the production of the others in the string. One way of mitigating the effects of mismatch to electrically connect serially connected strings in parallel. In that event, the negative effects of mismatch may be more limited to the single effected string. When designing mixed PV modules, the bifacial strings produce more energy than the monofacial strings under similar conditions. Therefore, similar factors and design constraints may be considered. In designing PV cell arrays and PV modules it may further prove advantageous, for such mixed PV modules and other PV modules (e.g., monofacial only PV modules), to contain PV cell arrays including multiple sized PV cells. Multiple sized PV cells incorporated into a single PV cell array and PV cell module may allow for great design flexibility as described in more detail herein.

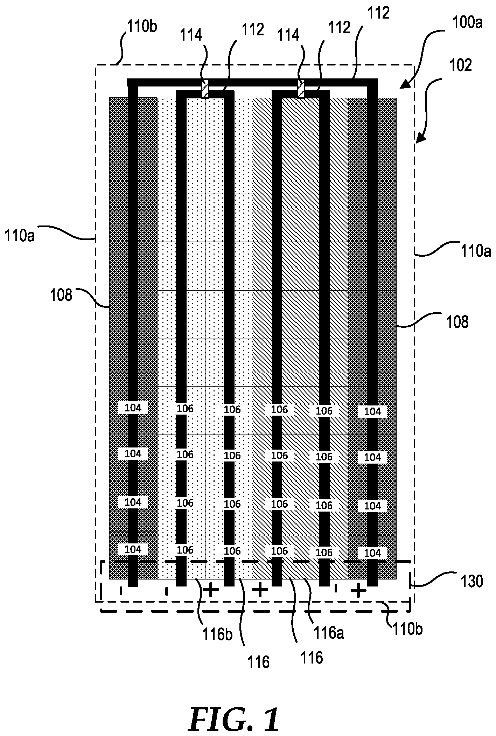

FIG. 1 depicts an example mixed PV cell array 100a and backsheet 102 according to one or more aspects of the present disclosure. As described herein, often, much of the backside solar incidence in a bifacial suited PV module may occur along the edges of PV modules as more solar radiation may reach the backside PV module edges rather than the backside PV module inner portions. This is due to a number of factors. First, depending on the angle of the PV module, often, the sun may directly irradiate the backside edge. For example, in the northern hemisphere, if a PV module is facing east with a tilt angle of 45 degrees, the sun may rise in the east and set in the west. Therefore, when the sun is setting, the top backside edge of the PV module may be directly irradiated by the setting sun. Additionally, PV modules are often installed on support structures or near the ground. The sun may reflect off of these support structures back to the backside of the PV module. However, since the inner backside portion of the PV module may be covered by the PV module itself and, often, neighboring PV modules, the reflective incidence may also be greater along the PV module backside edges. Further, even with a module including an opaque but reflective backsheet, the edges of such a PV cell array may similarly experience increased reflected irradiance as compared to inner portions. This may be due to a number of factors. One such factor may be, for example, that the inner portions may be crowded by neighboring PV cells, whereas the perimeter and edge portions may not be so. Therefore, to take advantage of the increased edge backside irradiance and reflective irradiance, advantages of mixed PV cell arrays and mixed module may be recognized. Referring to FIG. 1, a mixed PV cell array 100a may contain enhanced substrings 108 of electrically serially connected enhance PV cells 104 and standard substrings 116a, 116b of electrically serially connected standard PV cells 106. Enhanced substrings 108 may be disposed along and/or near one or more of mixed PV cell array edges. Standard substrings 116a, 116b may be disposed further towards the middle of mixed PV cell array 100a.

PV modules, including mixed PV modules, may include the following layers: a protective backsheet (e.g., a double fluoropolymer backsheet, a single fluoropolymer backsheet, a non-fluoropolymer backsheet (e.g., polyethylene terephthalate (PET) backsheet, ethylene vinyl acetate (EVA) backsheet, etc.), etc.); a bottom encapsulant or backsheet (e.g., glass, clear EVA, etc.), a conductive backsheet, PV cells (e.g., monofacial PV cells 106, bifacial PV cells 104, etc.), insulation layers, a topsheet (e.g., glass, EVA, etc.). PV modules including mixed PV modules may have a similar construction, may contain extra layers, or may not contain one or more of the above-mentioned layers. Additionally, some layers (e.g., backsheet and topsheet) may be fabricated from similar materials.

Referring to FIG. 1, backsheet 102 of the present disclosure may be constructed of uniform, entirely increased transparency material (e.g., glass, clear EVA, etc.). The type of glass used may include, but is not limited to, tempered glass, borosilicate glass, Gorilla™ Glass, anti-reflective (AR) coated glass, etc. In such exampes, an increased transparency material may back the entire PV cell array 100. Additionally or alternatively, it may be advantageous to construct the entire backsheet 102 of a uniform increased transparency material and to cover the areas backing standard PV cell portions of the mixed PV cell array 100 with an opaque or less transparent material (e.g., white EVA). Additionally or alternatively, it may be advantageous to construct the entire backsheet 102 of a uniform increased transparency material and to cover the areas backing the enhanced portions with an opaque or less transparent reflective material such that topside irradiance may be reflected back toward the enhanced PV cells.

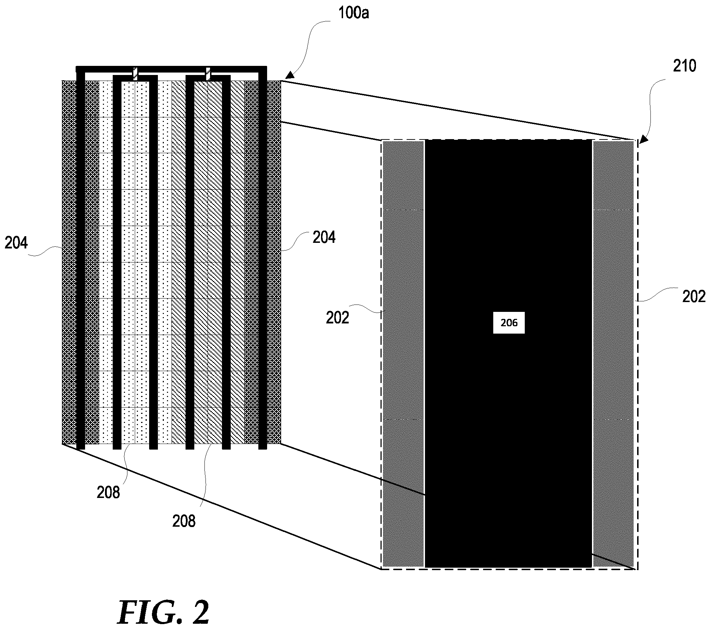

Alternatively, it may be advantageous to include mixed backsheets of multiple materials and/or multiple transparencies. FIG. 2 depicts an example mixed PV cell array 100 and its associated illustrative mixed backsheet 210 according to one or more aspects. Mixed PV modules of the present disclosure may include a mixed backsheet 210. Mixed backsheet 210 may include increased transparency portions 202 backing the enhanced portions 204 of mixed PV cell array 100 (e.g., portions of mixed PV cell array 100 including enhanced PV cells and enhanced substrings), and mixed backsheet 210 may include reduced transparency portions 206 backing the standard portions 208 of mixed PV cell array 100 (e.g., portions of mixed PV cell array 100 including standard PV cells and standard substrings). The portions of mixed backsheet 210 backing standard PV cells 106 may otherwise be opaque or substantially so.

Referring to FIG. 2, mixed backsheet 210 may be constructed of two or more materials. For example, mixed backsheet 210 may include white EVA backing the standard portions 208 of mixed PV cell array 100, and may include clear EVA or glass backing the enhanced portions 204 of mixed PV cell array 100. The type of glass used may include, but is not limited to, tempered glass, borosilicate glass, Gorilla™ Glass, anti-reflective (AR) coated glass, etc. In the exampes of the present disclosure where multi-material mixed backsheets 210 are implemented, the materials may be joined variously. For example, the materials may be joined with an H-channel joiner of various materials (e.g., aluminum, vinyl, etc.). Additionally or alternatively, the materials may be joined and coupled with the assistance of adhesives, adhesive strips, epoxies, etc. Methods of joining two such materials will be known to those or ordinary skill in the art and are contemplated herein.

Discussion and description of backsheets herein may be considered to describe uniform backsheets 102 (as described above) and mixed backsheet 210 unless explicitly stated or described otherwise. Backsheets 102 and mixed PV cell arrays 100 herein may be substantially rectangular having two short edges 110b (e.g., sides) (a top short edge 110b and a bottom short edge 110b) and having two long edges 110a (e.g., sided) (a right long edge 110a and a left long edge 110a). Further, two example midlines may divide the mixed PV cell arrays 100, backsheets 102, and mixed backsheets 210 of the present disclosure: a longitudinal midline, dividing the mixed PV cell array 100, backsheets 102 and mixed backsheets 210 in a right portion (e.g., half) and a left portion (e.g., half); and a transversal midline dividing mixed PV cell array 100, backsheet 102, and mixed backsheet 210 in a top portion (e.g., half) and a bottom portion (e.g., half). Additionally or alternatively, mixed PV cell arrays 100, backsheets 102, and mixed backsheets 210 may have a substantially square aspect ratio. In such examples, mixed PV cell arrays 100 and backsheets 102 may have four substantially equal length edges. Such substantially square mixed PV cell arrays 100 and mixed backsheets 102 may similarly be divided for purposed of example and description by a longitudinal midline, dividing the mixed PV cell array 100 and mixed backsheet 102 in a right portion (e.g., half) and a left portion (e.g., half); and a transversal midline dividing mixed PV cell array 100 and mixed backsheet 102 in a top portion (e.g., half) and a bottom portion (e.g., half). In such examples of square shaped mixed backsheet 102 and/or square shaped PV cell arrays 100, reference in the present disclosure to long edges 110a and short edges 110b may be understood as reference to edges 110 generally. The terms top, bottom, right, and left as used herein are merely relative terms intended for purposes of example only and do not limit the present disclosure in any way.

Referring back to FIG. 1, mixed PV array 100a may contain enhanced PV cells 104 and standard PV cells 106 (reference numerals 104 and 106 are not depicted on every enhanced PV cell 104 and standard PV cell 106 for clarity of depiction and description). Solid black lines through substrings in FIG. 1, may depict substring electrical and or conductive connection paths and are used for purposes of example only. The conductive path may be through any number of different conductive media, for example, through PV cells, silver fingers, busbars, conductive backsheets, ribbon wire, etc. Each substring of FIG. 1 (and the remainder of this disclosure) may be depicted with or without patterns (e.g., crosshatch pattern, diagonal line pattern, no fill, etc.). Patterns, or lack thereof, do not depict or describe inter-substring relationships (e.g., relationships between substrings) other than depicting that differently patterned (or differently non-patterned) adjacent PV cells are PV cells of different substrings. Rather patterns may depict intra-substring relationships such that similarly patterned adjacent PV cells are PV cells of the same substring. In other words, substring patterns of FIG. 1, and the remainder of the present disclosure, may only serve to delineate between adjacent substrings unless explicitly described differently herein. The above is true for the disclosure herein unless explicitly stated otherwise. Enhanced PV cells 104 (and enhanced substrings 108) may be disposed adjacent to, and along, one or more edges 110 (e.g., long edge 110a, short edge 110b) of backsheet 102. Standard PV cells 106 (and standard substrings 116) may be disposed inward relative to at least a portion of the enhanced PV cells 104 along at least one edge 110 (e.g., long edge 110a, short edge 1 10b) of mixed PV module. Referring to FIG. 1, enhanced substring 108 may include two enhanced substring rows (or columns depending on orientation) including substantially half of enhanced substring 108 (and substantially half the length of each standard substring 116a) and disposed on backsheet 102 in rows (or columns, depending on orientation) of half substrings. Each enhanced substring 108 row may be disposed opposite each other, and adjacent to and parallel with a backsheet long edge 1 10a. Mixed PV cell array 100a may further include standard substrings 116a and 116b. The standard substrings 116a and 116b may be disposed between the two enhanced substring 108 rows. Standard substrings 116a and 116b may similarly be disposed on backsheet 102 in rows (or columns depending on orientation) of substantially half of each of standard substrings 116a and 116b. FIG.1 depicts a mixed PV cell array 100a having two standard substrings 116 disposed between the two enhanced substring 108 rows. However, mixed PV cell arrays may contain more or less standard substrings 116 (e.g., one, three, four, five, etc. standard substrings 116) disposed between the two enhanced substring 108 rows.

Still referring to FIG. 1, the opposing enhanced substring 108 rows (disposed on opposite edges 110a of backsheet 102) may be electrically serially connected to each other forming a single enhanced substring 108 of two enhanced substring 108 rows, disposed on opposing edges 110a of backsheet 102. Enhanced substring 108 may be substantially the same length as standard substrings 116a and 116b including the same number of electrically serially connected PV cells as standard substrings 116a and 116b. For example, each enhanced substring 108 row may contain ten electrically serially connected enhanced PV cells 104. Similarly, each standard substring 116 row may contain ten electrically serially connected standard PV cells 106. Therefore, two enhanced substring 108 rows, serially connected, may include twenty enhanced PV cells 104; and, similarly, two standard substring 116 rows, serially connected, may contain twenty standard PV cells 106. The number of enhanced PV cells 104 per enhanced substring 108 and enhanced PV substring 108 rows, and the number of standard PV cells 106 per standard substrings 116a and standard substrings 116a rows in FIG. 1 are for purposes of description only. Rather enhanced substrings 108 may include any number of enhanced PV cells 104, and standard substrings 116 may similarly include any number of standard PV cells 106. For example, enhanced substring 108 and standard substrings 116a and 116b may include, ten, twenty, twenty-four, forty-eight, sixty, ninety, etc. PV cell per substrings. Enhanced substring 108 rows and standard substring 116 rows may include half the respective PV cells in the respective substrings.

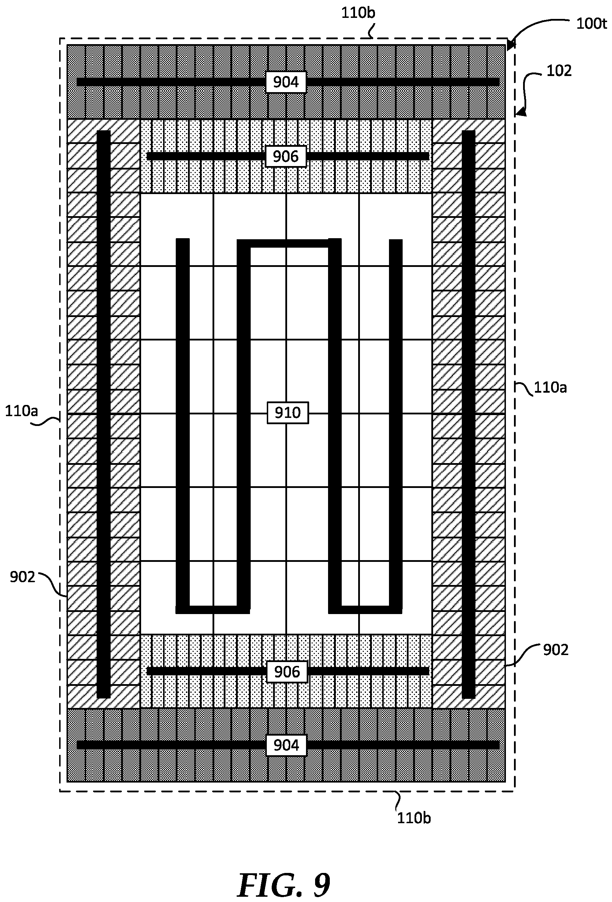

Each PV cell (e.g., enhanced PV cell 104, standard PV cell 106) of the present disclosure may have positive and negative terminals, across which respective electric potentials produced by the PV cells may be measured in relation to ground. When irradiated, each PV cell of the present disclosure (e.g., enhanced PV cell 104, standard PV cell 106) may produce an electric potential that may be measured between the PV cell positive and negative terminals as an open circuit voltage ($V_{OC}$). When irradiated, PV cells of the present disclosure may also produce an electrical current that may be measured in a closed circuit as short-circuit current ($I_{SC}$). Even when differently irradiated, PV cells (e.g., enhanced PV cell 104, standard PV cell 106), even of a different type (e.g., standard and enhanced), may produce substantially similar $V_{OC}$. However, the same may not hold true for $I_{SC}$, and when even substantially similar PV cells of the present disclosure are differently irradiated, they may produce dissimilar $I_{SC}$. Therefore, substrings including the same number of PV cells (e.g., enhanced substring 108 and standard substrings 116 of FIG. 1; or standard substring 910, 1/3 cut enhanced substring 902, ¼ cut substrings 904, and 1/6 cut enhanced substrings 906 of FIG. 9; etc.), may produce substantially the same $V_{OC}$. For example, assuming an example nominal PV cell $V_{OC}$ of 0.5 volts (V) for both standard PV cell 106 and enhanced PV cell 104 (actual nominal $V_{OC}$ of PV cells may vary and 0.5V is used for purposed of example only). Taking an example enhanced substring 108 or standard substring 116 of twenty PV cells, the nominal substring $V_{OC}$ may equal the sum of $V_{OC}$ of all of its PV cells. The example twenty PV cell substrings of the above example may produce (0.5 $V$)(20) = 10$V$ for both the twenty PV cell enhanced substring 108 and standard substring 116 under varying irradiance conditions. However, differently irradiated substrings (even of the same length) may produce substantially different $I_{SC}$. For example, enhanced substring 108 (and other enhanced PV cells and enhanced substrings herein) may experience increased irradiance as compared to standard substrings 116a and 116b under similar conditions. Therefore, under similar irradiance conditions (e.g., conditions causing substrings 106 and 108 to produce current of similar magnitude to $I_{SC}$, for example, conditions where cells of substrings 106 and 108 operate at near their maximum-power-point currents), enhanced substring 108 may produce more current than standard substrings 116. Therefore, there may be concern for the mismatch condition mentioned above. To address these concerns, and others (e.g., the partial shade condition), all substrings of a mixed PV array 100 of the present disclosure (e.g., enhanced substring 108 and standard substrings 116a) of substantially the same number of PV cells may be electrically connected to each other in parallel (which may only require similar $V_{OC}$). In such a connection, the various $I_{sc}$ of the various substrings may be summed.

Referring to FIG. 1, all substrings of the mixed PV cell array 100a may include substantially the same number of PV cells and may be electrically connected in parallel. Parallel connection of substrings of FIG. 1 (and other substrings of the present disclosure) may also act to mitigate mismatch from a partial shade or other reduced irradiation condition. For example, if one standard PV cell 106 of standard substring 116a is partially shaded, the current production of the entire standard substring 116a may be reduced ($V_{OC}$, however may remain substantially unchanged). However, since standard substring 116a may be electrically connected to the other substrings in parallel, the other substrings may continue producing and may not be affected by the reduced standard PV cell 104 in the reduced standard substring 116a.

Each substring of the present disclosure may terminate in a positive electric potential terminal and negative electric potential terminal, across which electric potentials produced by the individual substrings may be measured. Referring to FIG. 1, all substrings may terminate proximate to the same backsheet edge 110. Having the substring terminals in close proximity (as in FIG. 1) may be advantageous for electrically inter-connecting the substrings. Some or all of the electrical connections to complete the electrical parallel inter-connection of the substrings of mixed PV cell array 100a may take place in a junction box. Additionally or alternatively, some or all of the electrical inter-connections of all or some of the substrings of mixed PV cell array 100a may be effectuated outside of the junction box, for example, on PV cell substrate and/or along the backsheet 102. It may therefore be advantageous, depending on production concerns, and mismatch mitigation concerns (as discussed below) to differently orient standard substring 116 and enhanced substring 108 terminals. For example, FIG. 1 depicts the following arrangement of substring terminal polarity from right to left: -, -, +, +, -, +. Under some circumstances, such a layout may be advantageous. For example, the negative terminal of enhanced substring 108 may be adjacent to the negative terminal of standard substring 116b. Therefore, connecting the two substrings to effectuate a parallel connection between the two substrings may prove simplified as the close proximity of the two negative terminals may facilitate connection. The same may hold true for the positive terminal of enhanced substring 108 and the positive terminal of standard substring 116a. However, depending on environmental conditions surrounding mixed PV module of mixed PV cell array 100a installation, as discussed in more detail below, mismatch and partial shade condition mitigation may benefit from other terminal arrangements (e.g., -, +, -, +, -, +). Therefore, all possible terminal arrangements are contemplated herein.

As described above, because substring $V_{OC}$ is substantially a product of the number of PV cells in the substring (among other factors, e.g., temperature), the $V_{OC}$ of the same point (e.g., midpoint) of each identically sized substring may be substantially similar. For example, the $V_{OC}$ of the midpoint 112 (the physical and electrical potential midpoint) of enhanced substring 108 may be substantially similar to the $V_{OC}$ of the midpoint 112 of standard substring 116a. Further, referring to FIG. 1, midpoints 112 of all substrings of mixed PV cell array 100a of FIG. 1 may occupy the end of each substring row proximate to the same backsheet short edge 110b. Midpoints 112 may be electrically connected with cross-ties 114. Cross-ties 112 may act to parallelize substring rows thereby increasing mismatch or partial shade condition mitigation. For example, referring to FIG. 1, assume a standard PV cell 106 in the row of standard substring 116b that routes from the negative terminal of standard substring 116b to midpoint 112 is shaded. Further, assume an enhanced PV cell 104 in the row of enhanced substring 108 that routes from the positive terminal of enhanced substring 108 to midpoint 112 is shaded. Absent cross-ties 114, entire standard substring 116b may be reduced, and entire enhanced substring 108 may be reduced. With substring cross-ties 114, only the row of standard substring 116b that routes from the negative terminal of standard substring 116b, and the row of enhanced substring 108 that routes from the positive terminal of enhanced substring 108 may be reduced due to the increased electrical parallelization of the substring rows.

As described, mixed PV cell array 100 and backsheet 102 may be substantially rectangular shaped (as depicted in FIG. 1) (e.g., having two long edges 110a and two short edges 110b). However, backsheet 102 and mixed PV array 100 may be substantially square in shape (e.g., having four substantially equal length edges 110). In such examples of square shaped backsheet 102 and/or square shaped PV cell arrays 100, reference in the present disclosure to long edges 110a and short edges 110b may be understood as reference to edges 110 generally.

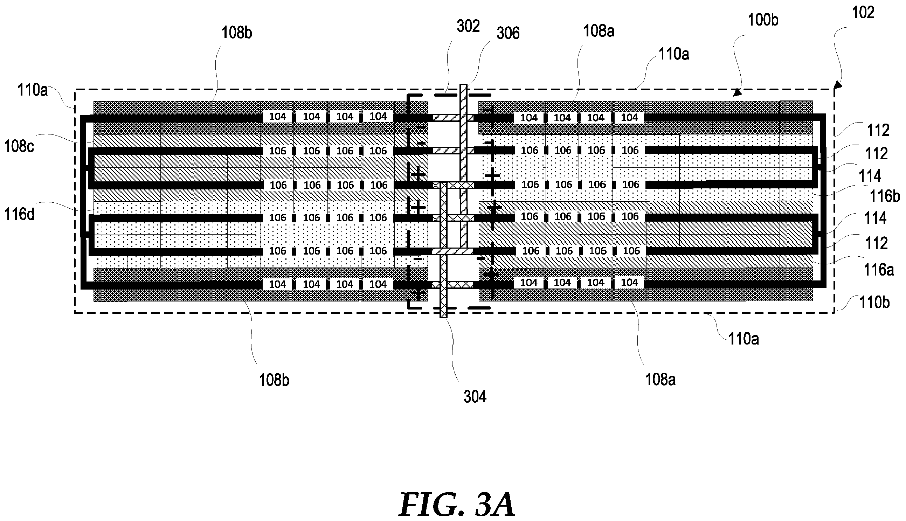

FIG. 3A depicts an example mixed PV cell array 100b according to one or more aspects of the present disclosure. Referring to FIG. 3A, mixed PV cell array of FIG. 1, may be duplicated producing two identical mixed PV cell arrays 100a. The two mixed PV cell arrays 100a may be electrically connected to each other yielding a larger mixed PV cell array 100b with two substantially similar mixed PV cell array halves. The two mixed PV cell array halves may be connected to each other in parallel, such that all substrings of the two halves may be electrically connected to each other in parallel.

Referring to FIG. 3A, the positive electrical lines are depicted with a cross-hatch pattern and the negative electrical lines are depicted with a diagonal pattern. Some or all of the electrical connections to connect the substrings in parallel may be disposed in junction box 302. Additionally or alternatively, some or all of the electrical connections to complete the electrical parallel connection of all of the substrings of mixed PV cell array 100b may take place outside of the junction box 302, for example on PV cell substrate and/or along the backsheet. Since, the mixed PV cell array halves may be mirror images of one another, substring negative terminals of one half may terminate opposite substring negative terminals of the opposing half. Conductors (e.g., ribbon wire, etc.) may be connected to reach substring terminal and its mirror image on the opposing half. Further, mixed PV module of mixed PV cell array 100b may include a positive bus 304 and a negative bus 306. Negative connections between negative substring terminals, may be connected to each other at negative bus 306. Similarly, positive connections between positive substring terminals, may be connected to each other at positive bus 304. Some or all of such connections may occur in junction box 302. Additionally or alternatively, some or all of such connections may occur outside of junction box 302.

FIG. 3A depicts two mixed PV cell array halves that are substantial mirror images of each other. It may be advantageous to have two mixed PV cell array halves with varying arrangements. For example, it may be desirable to arrange the substrings of one half such that the terminals terminate in the following order: -, -, +, +, -, +. However, it may be desirable to arrange the substrings of the opposing half in a different order, for example: -, +, -, +, -, +. This may be due to shading/mismatch concerns (as described herein) or other concerns. Such varying terminal arrangements (including all other possible arrangements) between the two opposing mixed PV cell array halves are contemplated herein.

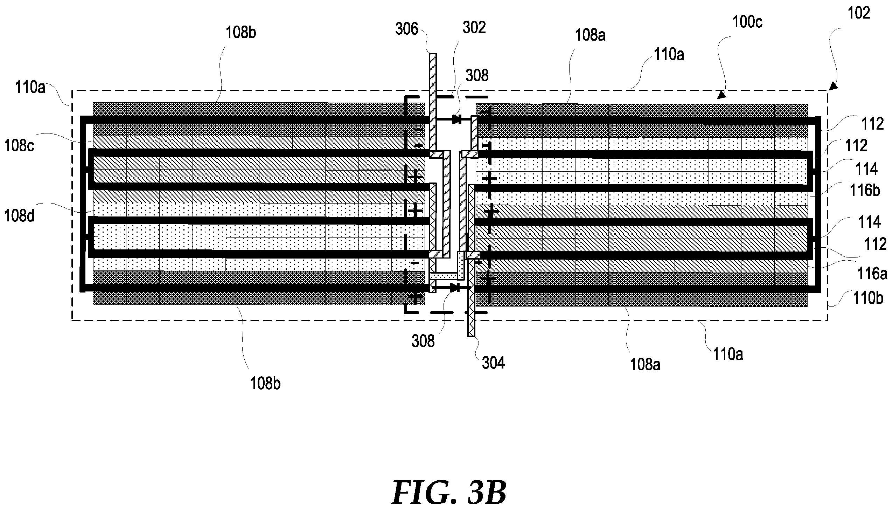

Arrangements including two duplicated PV cell array halves, for example those of FIG. 3A, may benefit from bypass diodes or similar. FIG. 3B depicts an example PV cell array 100c according to one or more aspects, having two series-connected halves. Referring to FIG. 3B, bypass diodes 308 may be electrically connected across each of the two PV cell array halves. Each of bypass diodes 308 may act to bypass a half of the mixed PV cell array 100c in certain cases of mismatch and or the partial shade condition.

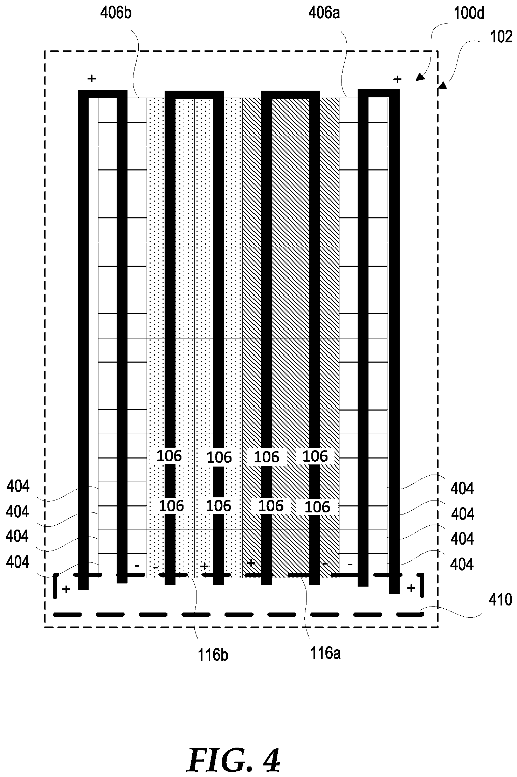

FIG. 4 depicts an example mixed PV cell array 100d according to one or more aspects of the present disclosure. Solid black lines through substrings in FIG. 4 may depict substring electrical and/or conductive paths and are used for purposes of example only. The conductive path may be through any number of different conductive media, for example, through PV cells, silver fingers, busbars, conductive backsheets, ribbon wire, etc. Referring to FIG. 4, mixed PV modules may include multiple substrings, some of which include differently sized PV cells. Full enhanced PV cells 104 and full standard PV cells 106 may be produced in different sizes (e.g., 156mm x 156 mm square, 158.75 mm x 158.75 mm square, 166 mm x 166 mm square, 182 mm x 182 mm square, 210 mm x 210 mm square). Further full PV cells of one size (e.g., 210mm x 210mm) may be cut into smaller PV cells. PV cells may be cut into $\frac{1}{N}$ cut PV cells where N is an integer. Additionally or alternatively, enhanced PV cells and standard PV cells may be produced in sizes substantially similar to those described in relation to cut PV cell herein. Such smaller produced PV cells are included in the discussion of cut PV cells herein. For example, a 210 mm x 210 mm full PV cell may be cut in half yielding two $\frac{1}{2}$ cut PV cells measuring 105 mm x 210 mm (additionally or alternatively PV cells measuring substantially 105 mm x 210 mm may be produced as ½ cut PV cells). In a further example, a 210 mm x 210 mm full PV cell may be cut into eights yielding eight $ cut PV cells measuring substantially 26.25 mm x 210 mm. In further examples, $\frac{1}{N}$ vertically cut PV cells may be $\frac{1}{N}$ horizontally cut as well. For example, a 210 mm x 210 mm full PV cell may be 1/8 cut vertically and 1/2 cut horizontally resulting in 16 cells (1/16 cut cells), each sized 25.25 mm × 105 mm. Such $\frac{1}{N}$ vertical and $\frac{1}{N}$ horizontal cut PV cells are included in the general discussion of $\frac{1}{N}$ cut PV cells. $\frac{1}{N}$ cut PV cells may produce substantially the same $V_{OC}$ as the full PV cell under similar operating and/or environmental conditions (e.g., irradiation, temperature, etc.). For example, $\frac{1}{2}$ cut PV cells, $\frac{1}{4}$ cut PV cells, $\frac{1}{8}$ cut PV cells, etc. may produce substantially the same $V_{OC}$ as the full PV cell from which they were cut under similar operating conditions. However, $\frac{1}{N}$ cut PV cells may produce substantially $\frac{1}{N}$ the $I_{SC}$ of the full PV cell under similar irradiation and/or operating conditions. For example, $\frac{1}{2}$ cut PV cells may produce $\frac{1}{2}$ the $I_{SC}$ of the full PV cell from which it was cut under similar operating conditions. Similarly, $ cut PV cells may produce $\frac{1}{8}$ the $I_{SC}$ of the full PV cell from which it was cut under similar operating conditions. In order to connect substrings in parallel, the substrings must produce substantially similar $V_{OC}$. Since $\frac{1}{N}$ cut PV cells produce substantially the same $V_{OC}$ as the full PV cell from which it was cut, a substring including X number of $\frac{1}{N}$ cut PV cells may produce substantially the same $V_{OC}$ as a substring including X number of full PV cells, where X = X, but may produce a different power level under similar operating conditions. Therefore, substrings including, for example, sixty full PV cells, may be electrically connected in parallel to substrings including sixty $\frac{1}{8}$ cut PV cells. The above holds true and is contemplated with respect to standard PV cells and enhanced PV cells alike.

Referring again to FIG. 4, mixed PV module may include multiple substrings, some of which may include PV cells of different sizes. Mixed PV cell array 100d may include four substrings, two $\frac{1}{2}$ cut enhanced substrings 406a and 406b of electrically serially connected $\frac{1}{2}$ cut enhanced PV cells 404 and two standard substrings 116a and 116b of full standard PV cells 106. $\frac{1}{2}$ cut enhanced PV cells 404 may produce substantially the same $V_{OC}$ as full enhanced PV cell 104 and full standard PV cell 106 but substantially $\frac{1}{2}$ the $I_{SC}$ of full PV cell 104 under similar irradiance conditions. $\frac{1}{2}$ cut enhanced substrings 406a and 406b may be disposed along opposing backsheet long edges 110a (e.g., backsheet long side). Standard substrings 116b and 116a, may be disposed between ½ cut enhanced substrings 406a and 406b. ½ cut enhanced substrings 406a and 406b may contain the same number of PV cells as standard substrings 116a and 116b but may be half the physical length since the enhanced PV cells may be ½ cut enhanced PV cells 404. As a result, the two ½ cut enhanced substrings 406a and 406b may produce substantially the same $V_{OC}$ as standard substrings 116a and 116b.

The substrings of FIG. 4 (½ cut enhanced substrings 406a and 406b, and standard substrings 116a and 116b) may be electrically connected to each other in parallel producing a total $V_{OC}$ ($V_{OCT}$) and a total $I_{sc}$ ($I_{SCT}$). For example, FIG. 4 depicts a mixed PV cell array with substrings including twenty PV cells per substring. Assuming a nominal $V_{OC}$ of 0.5V for each PV cell 404 and 106, each substring (1/2 cut enhanced substrings 406a and 406b, and standard substrings 116a and 116b) may have a substring $V_{OC}$ ($V_{OCS}$) where $V_{OCS}$ = (20) · (0.5V) = 10V. Mixed PV cell array 100d may include substrings with any number of PV cells per substrings (e.g., sixty, seventy-two, ninety-six, etc.). For example, each substring (e.g., 1/2 cut enhanced substrings 406a and 406b, and standard substrings 116a and 116b) may include sixty PV cells. Assuming the example nominal voltage of above, such substrings may have a $V_{OCS}$ = (60) · (0.5V) = 30V. Since the substrings may be connected together in parallel, the total $V_{OCT}$ may be substantially equal to the substring $V_{OCS}$ under similar conditions. Each substring may similarly produce a short circuit current $I_{SCS}$. The $I_{SCS}$ of each substring may be substantially similar to the $I_{SC}$ of the lowest producing PV cell in the substring (due to the mismatch condition as discussed herein). Where substrings are electrically connected in parallel, the mixed PV cell array 100d may have a total short circuit current ($I_{SCT}$) substantially equal to the sum of $I_{SCS}$ of all substrings in the mixed PV cell array 100d (the above examples assume ideal conditions with no losses).

FIG. 4 depicts the following arrangement of substring terminal polarity from right to left: +, -, -, +, +, -, -, +. Under some circumstances, such a layout may be advantageous. For instance, the negative terminal of ½ cut enhanced substring 406b may be adjacent to the negative terminal of standard substring 116b. Therefore, connecting the two substrings to effectuate a parallel connection between the two substrings may prove simplified as the two negative terminals may be directly connected without other conductor (e.g., ribbon wire, other wire, etc.) intersection. The same may hold true for the negative terminal of ½ cut enhanced substring 406a and the negative terminal of standard substring 116a. However, depending on environmental conditions surrounding mixed PV module installation, as discussed in more detail below, mismatch and partial shade condition mitigation may benefit from other terminal arrangements (e.g., +, -, +, -, +, -, +, -). Therefore, all possible terminal arrangements are contemplated herein.

FIG. 4, depicts a configuration with two standard substrings 116a and 116b disposed between two ½ cut enhanced substrings 406a and 406b. Mixed PV cell array may include more or less standard substrings disposed between ½ cut enhanced substrings 406a and 406b. For example, mixed PV array 100 may include three, four, five, etc. standard substrings between ½ cut enhanced substrings 406a and 406b. Further, each side (e.g., the right side and the left side) of mixed PV cell array may include multiple ½ cut enhanced substrings 406 disposed adjacent to one another. The configurations of FIG. 4 are depicted with respect to mixed PV cell array 100d.

Different enhanced substrings 406 of FIG. 4 may be differently enhanced. For example, one enhanced substring 406 may include bifacial suited PV cells and a transparent backsheet. Whereas, one additional enhanced substring may include monofacial and or bifacial suited PV cells and may be backed by a decreased transparency and reflective backsheet. Alternatively, all of the enhanced substrings 406 of FIG. 4 may be similarly enhanced (e.g., all enhanced substrings 406 may include bifacially suited PV cells backed by an increased transparency backsheet, or all enhanced substrings may include monofacial suited PV cells and may, for example, be backed by a decreased transparency reflective backsheet). The present disclosure is not limited to these combinations of substring enhancement, rather all combinations of enhancement are contemplated herein.

Standard substrings 116a and 116b of FIG. 4 may be monofacial suited PV cells backed by a decreased transparency backsheet or an increased transparency backsheet. Alternatively, standard substrings 116a and 116b of FIG. 4 may be bifacially suited PV cells backed by increased transparency backsheet. Two or more different standard substrings may be differently standardized.

Similar to arrangements of FIGS. 3A - 3B, in which aspects of FIG. 1 are duplicated and connected in parallel, are anticipated with regards to aspects of FIG. 4. Configurations of FIG. 4 may be duplicated defining two halves of a mixed PV cell array, each half substantially identical to configurations of FIG. 4. The two halves may be electrically connected such that all substrings are electrically connected in parallel. Additionally or alternatively, some or all of the substrings may be electrically serially connected. Some or all of the electrically serially connected substrings may be further connected in parallel. Similar to configurations of FIG. 3B, bypass diodes may be connected between the two PV cell array halves such that one or each half may be bypassed, for example, in the event of the mismatch condition.

While FIG. 4 illustrates a mixed PV cell array 100d a combination of full PV cells (e.g. 210mm x 210mm or 182mm x 182xx) and half-cut PV cells (e.g., 105mm x 210mm or 91mm x 182mm), it is conceived that a mixed PV cell array 100d or other mixed PV cell arrays disclosed herein may include only cut PV cells. For example, a mixed PV cell array may comprise one or more first substrings comprising serially connected ½ cut cells and one or more second substrings comprising serially connected ¼ cut cells coupled in parallel to the one or more first substring. In this case, all of the PV cells in the mixed PV cell array will have a substantially rectangular shape.

In some cases, one or more corners of square or rectangular PV cell may be chamfered, resulting in an imperfect square or rectangular shape. Nonetheless, in the entirely of the disclosure herein, "square" and "rectangle" may include these shapes with one or more chamfered corners.

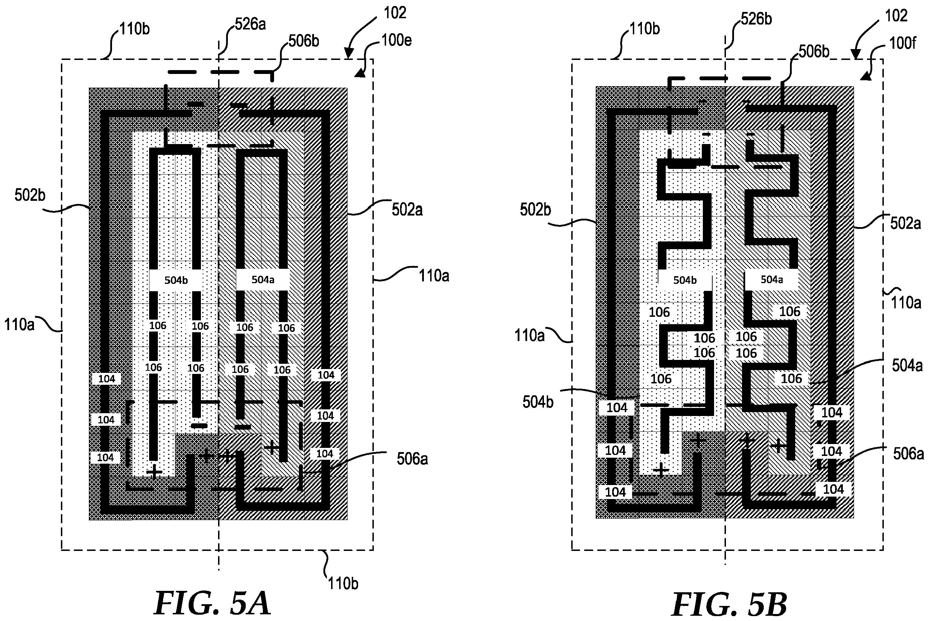

FIGS. 5A - 5B depict example mixed PV cell arrays 100 according one or more aspects of the present disclosure. Solid black lines in substrings in FIGS. 5A - 5B, may depict substrings electrical and/or conductive paths and are used for purposes of example only. The conductive path may be through any number of different conductive media, for example, through PV cells, silver fingers, busbars, conductive backsheets, ribbon wire, etc. Referring to FIG. 5A, mixed PV cell array 100e may include standard substrings 504a and 504b and enhanced substrings 502a and 502b. Each standard substrings 504a and 504b, and enhanced substrings 502a and 502b may include the same number of PV cells per substring. Enhanced substrings 502a and 502b, may include electrically serially connected enhanced PV cells 104, and may be disposed about substantially the full perimeter of mixed PV cell array 100e and backsheet 102 defining a perimeter of mixed PV cell array 100e of enhanced substrings 502a and 502b. Standard substrings 504a and 504b, and associated regions of backsheet 102 may be completely or substantially completely enclosed by the perimeter of enhanced substrings 502a and 502b.

Still referring to FIG. 5A, the perimeter of enhanced substrings 502a and 502b and associated backsheet regions may extend into the interior of mixed PV cell array 100e. Enhanced substrings 502 may extend from the mixed PV cell array perimeter to the PV cell array interior by one enhanced PV cell each. Additionally or alternatively, enhanced substrings 502 may not extend from the PV cell array 100e perimeter into the interior. Additionally or alternatively, enhanced substrings 502 may extend by more than one enhanced PV cell into the mixed PV cell array interior. This may be achieved by variously arraying PV cell (e.g., varying number of cells per row and column of enhanced substrings and standard substrings) and variously cutting PV cells as described herein. Each substring (e.g., standard substrings 504a and 504b and enhanced substrings 502a and 502b) may terminate at opposing ends in terminals of opposing polarities (e.g., positive and negative polarities). Enhanced substrings 502a and 502b may mirror each other and be arranged and disposed such that the terminals of the same polarity of each enhanced substring 502a and 502b may terminate proximate to one another and proximate to a backsheet short edge 110b. Each substring may route over substantially half of the perimeter of mixed PV cell array 100 and backsheet 102, and terminate in a negative terminal near an opposing short edge 110b of the backsheet 102. The substring path of standard substrings 504a and 504b may be substantially "U" shaped. Standard substring 504a and 504b may be disposed in two rows on backsheet 102. Each row may include substantially half of the standard PV cells 106 of the standard substring 504. Where standard substrings 504a and 504b contain an odd number of standard PV cells 106 (as depicted in FIGS. 5A-5B), one row may contain at least one more standard PV cell 106 than the other row. By virtue of the substantial "U" shape of the substring electrical path, the terminals of opposing polarities of standard substrings may terminate on the same half (e.g., the bottom half or top half) of backsheet 102. The electrical serial path of each enhanced substring 502a and 502b may proceed as follows: a first terminal of a first polarity may be disposed adjacent to the top short edge 110b (e.g., top short side and/or edge of the PV cell array 100e) and the longitudinal midline 526a of the PV cell array 100e. The path may extend from the longitudinal midline 526a toward a backsheet long edge 110a (e.g., PV cell array 100e long edge and/or side). The enhanced substring path may turn and extend, adjacent to a backsheet long edge 1 10a, to the bottom of mixed PV cell backsheet 102. At the bottom perimeter of backsheet 102, the enhanced substrings paths may turn and extend toward the longitudinal midline 526a. Substantially adjacent to the longitudinal midline 526a, the enhanced substring path may turn upward and extend toward the top of backsheet by one enhanced PV cell 104. Standard substrings 504a and 504a, and enhanced substrings 502a and 502b, may be arranged such that they terminate variously. For example, FIG. 5A depicts enhanced substrings 502a and 502a with their negative terminals upon the top half of backsheet 102 and mixed PV cell array 100e, and positive terminals disposed upon the bottom half of backsheet 102 and mixed PV cell array 100e. Additionally or alternatively, this arrangement may be inversed. According to yet other arrangements, the terminal of a first polarity (positive or negative) of one enhanced substring 502a or 502b may be disposed on one half of mixed PV cell array 100e (e.g., top half or bottom half) and the terminal of the same polarity of the remaining enhanced substring 502a or 502b, may be disposed on the opposing half (e.g., top or bottom).

The substrings of the configuration in FIG. 5A may be electrically connected to each other in parallel. Alternatively, some or all of the substrings of FIG. 5A may be electrically serially, and/or parallelly connected. For example, in one aspect, enhanced substrings 502a and 502b may be electrically serially connected to each other defining an enhanced substring string, and standard substrings 504a and 504b may be electrically connected to each other defining a standard substring string. In such an aspect, a standard substring string and an enhanced substring string may be electrically connected to each other in parallel.

It may be advantageous to achieve similar physical topologies of PV cells of FIG. 5A, with the additional feature of all terminals of the same polarities terminating proximate to one another. Such a configuration may allow, for example, amongst other things, simplified electrical parallel connections of substrings. Where substrings are electrically connected in parallel, terminals of the same polarity may be connected to one another. As such, such a configuration (of terminals of the same polarity terminating in close proximity to one another) may facilitate such connection. FIG. 5B depicts an example mixed PV cell array according to one or more aspects. Referring to FIG. 5A, due to the substantial "U" shape of the standard substring electrical path, the two terminals of each standard substring 504a and 504b may terminate in close proximity to one another. Referring to FIG. 5B, in order to achieve a configuration where one standard substring terminal terminates upon the bottom half of mixed PV cell array 100f and one terminal terminates upon the top half of mixed PV cell array 100f, standard substring paths may follow a square wave pattern as depicted.

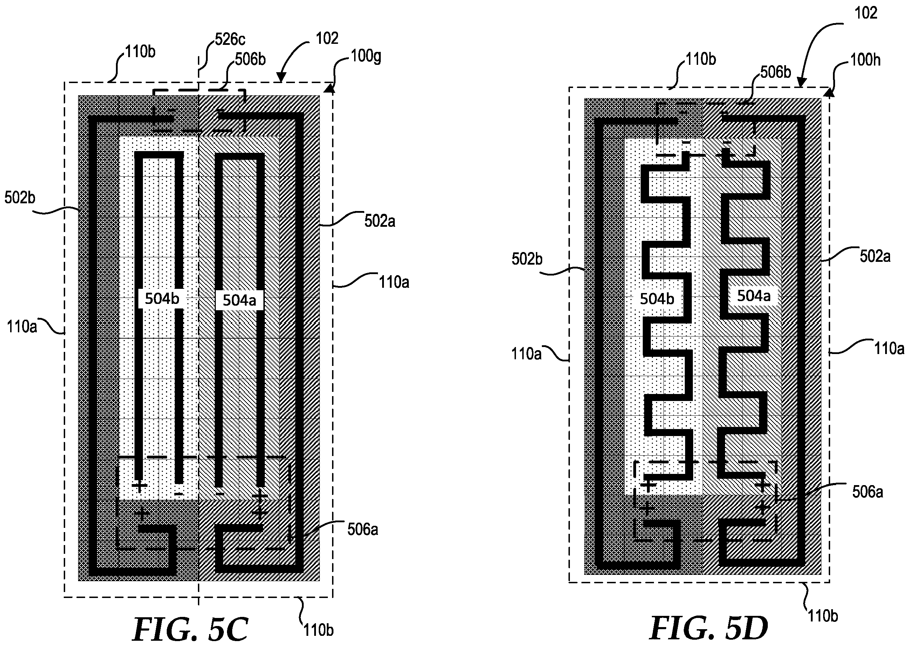

FIG. 5C depicts an example mixed PV cell array 100g according to one or more aspects of the present disclosure. It may be advantageous to achieve a mixed PV cell array 100g having a full perimeter of enhanced PV cells without overlap between enhanced PV cells and standard PV cells (for example the overlap of standard and enhanced PV cells of the bottom half of mixed PV cell array of FIGS. 4A - 4B). For example, as described, standard cells and enhanced cells may benefit from backsheet regions having varying transparencies and/or materials. Therefore, it may be advantageous to linearly delineate regions of backsheet 102 backing standard PV cells from regions backing enhanced PV cells. Referring to FIG. 5C, mixed PV cell array 100g may include two enhanced substrings 502a and 502b disposed substantially about the full perimeter of mixed PV cell array 100g. In order to achieve such a mixed PV cell array 100g configuration, enhanced substrings 502a and 502b may follow the electrical paths as depicted in FIG. 5C. Each enhanced substring 502a and 502b may terminate substantially adjacent to the longitudinal midline 526c and top short edge 110b. Each enhanced substring 502a and 502b may extend outward from the longitudinal midline 526c to the PV cell perimeter adjacent to the long edges 110a. Each enhanced substring 502a and 502b may extend following the PV cell array 100g perimeter proximate to the long edges 110a away from the top short edge 110b and toward the bottom short edge 110b. Each enhanced substring 502a and 502b may extend following the mixed PV cell array perimeter adjacent to the bottom short edge 110b toward the longitudinal midline 526c. Each enhanced substring may turn upward toward the top short edge 110 and extend adjacent to the longitudinal midline 526c and turn in toward itself.

Referring to FIG. 5C, standard substrings 504a and 504b electrical paths may be substantially "U" shaped as described herein. FIG. 5C depicts enhanced substrings 502a and 502b having their negative terminals disposed upon the top half of mixed PV cell array 100g and positive terminals disposed upon the bottom half of mixed PV cell array 100g. Alternatively, the position of the positive and negative terminals may be reversed. Further, it may be advantageous for a first terminal of one enhanced substring having a first polarity (e.g., positive or negative) to be disposed upon the top half of mixed PV cell array 100g and a first terminal of the opposing enhanced substring having the same polarity to be disposed on the opposing half of mixed PV cell array 100g. Additionally, FIG. 5C depicts standard substrings 504a and 504b having negative terminals disposed as the innermost terminals (in relation to long edges 110a), and positive terminals disposed as the outermost terminals (in relation to long edges 110a). Alternatively, these arrangements may be reversed. Further, the negative terminal of one standard substring 504a or 504b may be disposed as the innermost terminal of that particular substring, while the negative terminal of the remaining standard substring 504a or 504b may be disposed as the outermost terminal of the remaining standard substring 504a or 504b.

Still referring to FIG. 5C, standard substrings 504a and 504b and enhanced substrings 502a and 502b may be electrically connected to each other in parallel. Alternatively, some or all of the substrings of FIG. 5C may be electrically serially connected. For example , it may be advantageous to electrically serially connect enhanced substrings 502a and 502b defining an enhanced substrings string. Further, it may be advantageous to electrically serially connect standard substrings 504a and 504b defining standard substring string. According to such examples, standard substring strings and enhanced substring strings may be electrically connected in parallel.

As discussed, substrings of FIG. 5C may be electrically connected to each other in parallel. It may be advantageous for such electrical substring interconnection considerations (and other reasons) for all substrings to terminate in terminals of the same polarity in close proximity (or as close proximity as available) to one another. FIG. 5D depicts an example mixed PV cell array according to one or more aspects of the present disclosure. Referring to FIG. 5D, standard substrings 504a and 504b may be arranged such that all positive substring terminals terminate upon the bottom half of mixed PV array 100h, and all negative substring terminals of FIG. 5D terminate upon the top half of mixed PV array 100h. Alternatively, such an arrangement may be reversed (e.g., negative terminals terminate upon the bottom half of, and positive terminals terminate upon the top half of, mixed PV cell array 100h). Such an arrangement may be effectuated with a "square wave" shaped standard substring electrical path. In all other respects, the substrings, arrangements and electrical interconnections of FIG. 5D may be substantially similar to those described in relation to FIG. 5C.

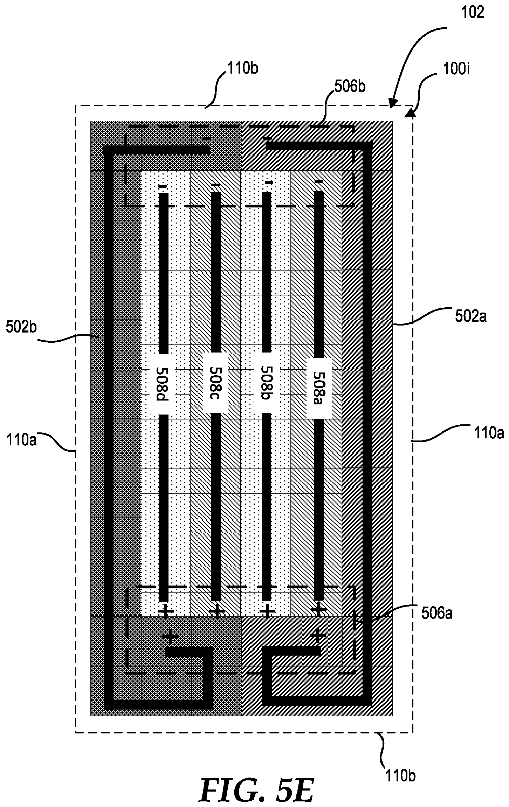

FIG. 5E depicts an example mixed PV cell array 100i according to one or more aspects of the present disclosure. Mixed PV cell array 100i may include $\frac{1}{N}$ cut standard PV cells. Referring to FIG. 5E, a mixed PV cell array with a substantially similar enhanced PV cell and enhanced substring arrangement to that of FIGS. 5C - 5D is depicted. Such a mixed PV cell array 100 may include ½ cut standard substrings 508a - 508d, each including a plurality of electrically serially connected ½ cut standard PV cells. The number of half cut standard PV cells in each ½ cut standard substring 508a-508b may be equal to one another, and equal to the number of enhanced PV cells in enhanced substrings 502a and 502b. Referring to FIG. 5E, ½ cut standard substrings 508a - 508d may be disposed within mixed PV cell array 100, and on backsheet 102, in substantially similar relation to that of standard substrings 502a and 502b to enhanced substrings 502a and 502b of FIG. 5C. Whereas standard substrings 504a and 504b of FIG. 5C are each disposed in mixed PV cell array 100g in two rows of standard PV cells each, ½ cut standard substrings 508a - 40d may each be disposed in single rows.

Still referring to FIG. 5E, since substrings of FIG. 5E (e.g., ½ cut standard substrings 508a - 508d and enhanced substrings 502a and 502b) may all include the same number of PV cells, each substring may produce substantially the same substring $V_{OCS}$ (substring open circuit voltage). Substrings of FIG. 5E may be electrically connected to each other in parallel. Alternatively, some or all of substrings of FIG. 5E may be electrically connected to each other in series and/or parallel. For example, two ½ cut standard substrings (e.g., 508a and 508b) may be electrically serially connected to each other defining a first ½ cut standard substring string. Further, the remaining two ½ cut standard substrings (e.g., 508c and 508d) may be similarly electrically serially connected to each other defining a second ½ cut standard substring string. Similarly, enhanced substrings 502a and 502b may be electrically serially connected to each other defining an enhanced substring string. The ½ cut standard substring strings, and the enhanced substring string may be electrically connected to each other in parallel. The arrangement of electrically serially connected ½ cut standard substrings in each ½ cut standard substring string may be varied.

Still referring to FIG. 5E, the substrings of FIG. 5E may be arranged such that the terminals of the substrings terminate variously. FIG. 5E depicts the substrings arranged such that the substrings (e.g., ½ cut standard substrings 508a - 508d and enhanced substrings 502a and 502b) terminate in a positive terminal upon the bottom half of PV cell array 100h, and the substrings further terminate in negative terminals upon the top half of mixed PV cell array 100h. Such an arrangement, in which terminals of the same polarity terminate on the same half of mixed PV cell array 100h (and therefore may be in close proximity to one another) may be advantageous according to some substring electrical interconnection schemes. For example, where all substrings are connected to each other in parallel, it may be advantageous for all terminals of the same polarity to terminate as physically close to each other as possible. This may reduce the length and/or amount of conductor (e.g., ribbon wire) required to effectuate the electrical connections. Alternatively, however, (for example, the electrical serial connection of multiple substrings defining substring strings and the subsequent electrical parallel connection of substring strings as described in relation to FIG. 5E above) it may be advantageous to arrange substrings of FIG. 5E such that terminals are disposed variously.

The inter-substring electrical connections of FIGS. 5A - 5E may be effectuated in first junction box 506a and second junction box 506b. Positive connections may be effectuated in first junction box 506a and negative connections may be effectuated in second junction box 506b. Additionally or alternatively, positive and negative connections may be effectuated in first junction box 506a and negative connections may be effectuated in second junction box 506b. Depending on the configuration, positive and/or negative connections may be effectuated in either junction box 506a or 506b in any combination. Further, the configuration of mixed PV cell array 100 and backsheet 102 of FIGS. 5A - 5E may only include a single junction box. Such a junction box may include all of the inter-substring electrical connections of mixed PV cell array 100 of FIGS 5A - 5E.

With reference to FIGS. 5A - 5E, different enhanced substrings of FIGS. 5A - 5E may be differently enhanced. For example, one or more enhanced substrings may include bifacial suited PV cells and a transparent backsheet. Whereas, one or more additional enhanced substrings may include monofacial and or bifacial suited PV cells and may be backed by a decreased transparency and reflective backsheet. Alternatively, all of the enhanced substrings of FIGS. 5A - 5E may be similarly enhanced (e.g., all substrings may include bifacially suited PV cells backed by an increased transparency backsheet). The present disclosure is not limited to these combinations of substring enhancement, rather all combinations of enhancement are contemplated herein.

Standard substrings of FIGS. 5A - 5E may be monofacial suited PV cells backed by a decreased transparency backsheet or an increased transparency backsheet. Alternatively, standard substrings of FIGS. 5A - 5E may be bifacially suited PV cells backed by increased transparency backsheet. Two or more different standard substrings may be differently standardized.

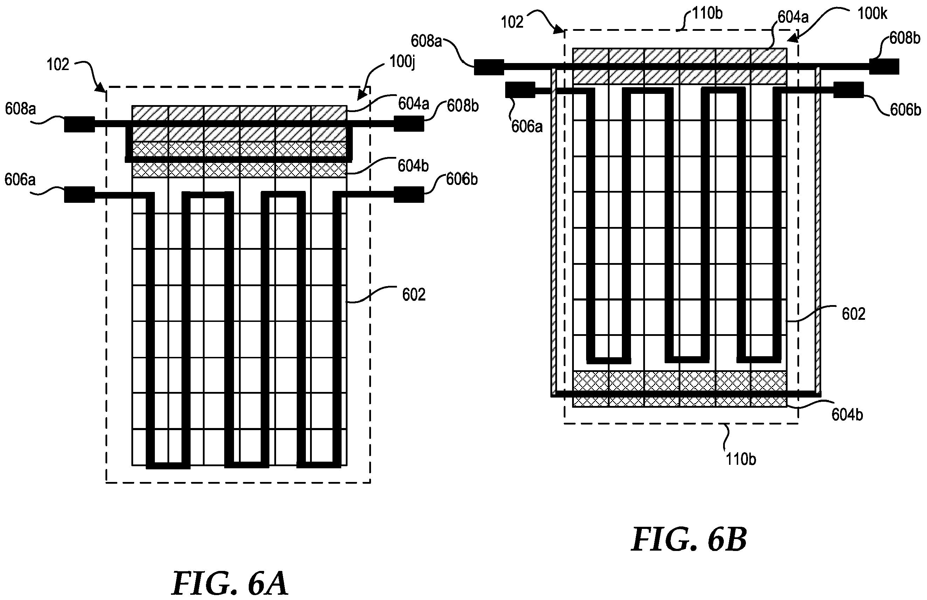

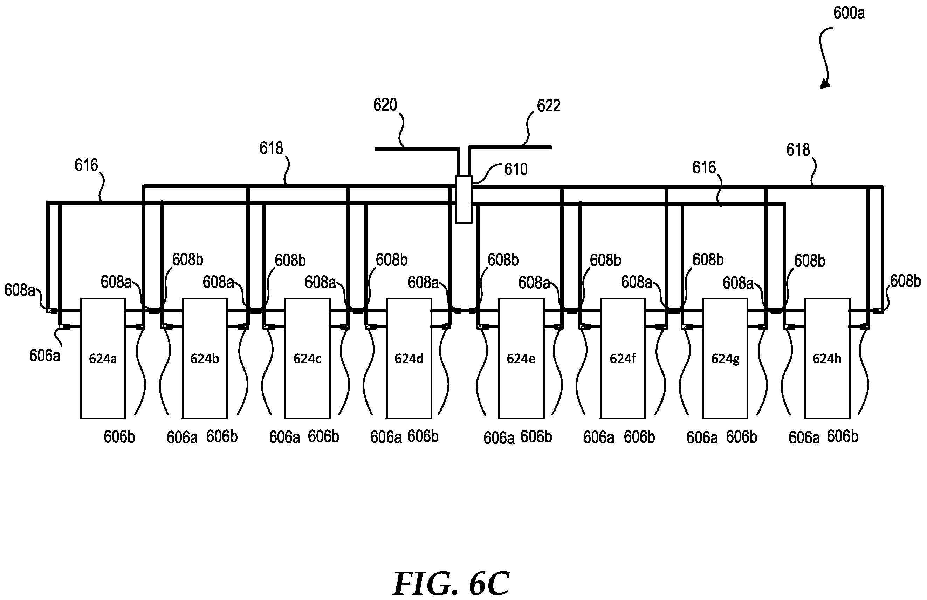

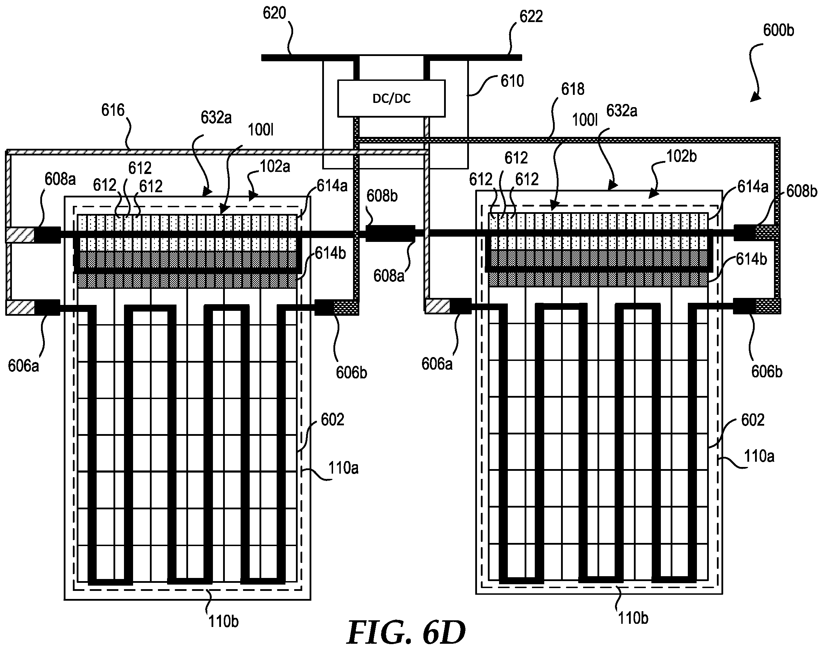

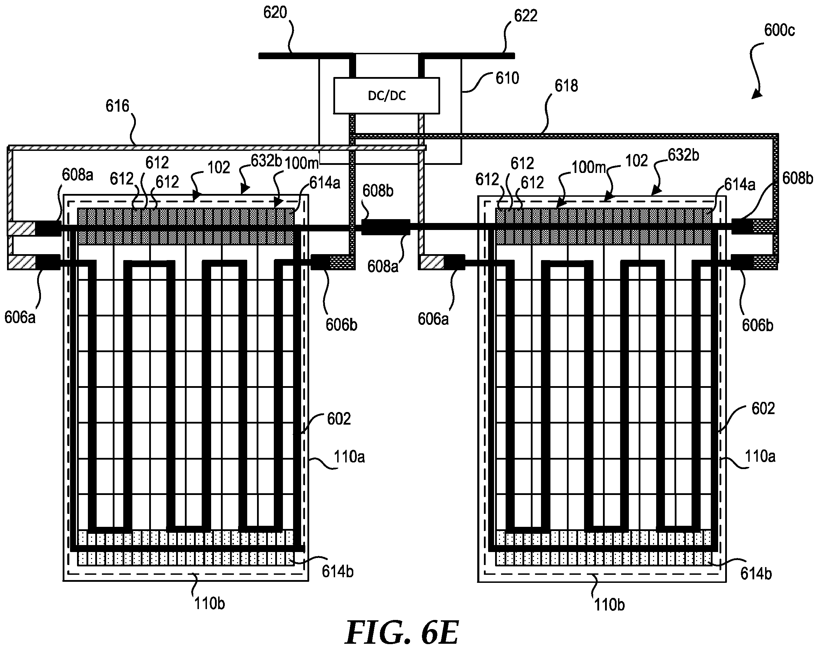

FIG. 6A depicts an example mixed PV cell array 100j according to one or more aspects of the present disclosure. Solid black lines through substrings in FIG. 6, may depict substring electrical and/or conductive paths and are for purposes of example only. The conductive path may be through any number of different conductive media, for example, through PV cells, silver fingers, busbars, conductive backsheets, ribbon wire, etc. Each substring of FIG. 6A may be depicted with or without patterns. Substring patterns of FIG. 6A may only serve to delineate between adjacent substrings unless explicitly described differently herein (as described in relation to FIG. 1 above). A mixed PV cell array 100j may include two portions, one portion may include standard PV cells and standard substrings and a second portion may include enhanced PV cells and enhanced substrings. FIGS. 1 - 5E depict mixed PV cell arrays 100 of an associated backsheet 102 including standard substrings and enhanced substring of the same size (e.g., including the same number of PV cells). Referring to FIG. 6A, mixed PV cell array 100j may include standard substring 602, enhanced substring 604a and enhanced substring 604b. Similar to other aspects of the present disclosure, standard substrings of FIGS. 6A - 6E may include monofacial suited PV cells and/or bifacial suited PV cells. Standard PV cells and standard substrings of FIGS. 6A - 6E may be backed by a decreased transparency backsheet or an increased transparency backsheet. Enhanced PV cells and enhanced substrings of FIGS. 6A - 6E may include monofacial suited and/or bifacial suited PV cells. Enhanced PV cells and enhanced substrings of FIGS. 6A - 6E may be backed by areas of decreased transparency and reflective backsheet, or areas of increased transparency backsheet. Standard substring 602 may include more PV cells than either enhanced substring 604a or 604b. Enhanced substrings 604a and 604b may include $\frac{1}{8}$ the number of PV cells of standard substring 602. Standard substring 602 may terminate in a positive terminal and a negative terminal or opposite polarities and across which the $V_{OCS}$ produced by standard substring 602 may be measured. First standard substring connector 606a may be connected to standard substring terminal of one polarity, and second standard substring connector 606b may be connected to standard substring terminal of the opposing polarity. First standard substrings connector 606a and second standard substrings connector 606b may include portions of complementary geometry that may be engaged with one another to connect first standard substring connector 606a to second standard connector 606b. Enhanced substrings 604a and 604b may be electrically connected to each other in parallel as an enhanced substring pair. The enhanced substring pair may terminate in a positive terminal and a negative terminal across which enhanced substring pair $V_{OCT}$ may be measured. A first enhanced substring pair connector 608a may be connected to an enhanced substring pair terminal of one polarity, and a second enhanced substring pair connector 608b may be connected to an enhanced substring pair terminal of an opposing polarity. First enhanced substring connector 608a and second enhanced substring connector 608b may include portions of complementary geometry that may be engaged with one another to connect first enhanced substring connector 608a to second standard connector 608b. Referring to FIG. 6A, enhanced substrings 604a and 604b, or enhanced substring pair, may not be electrically connected to standard substring 602 within mixed PV cell array 100j. For example, assuming a nominal PV cell voltage of 0.5V (for both standard PV cells and enhanced PV cells), standard substrings may have a $V_{OCS}$ = (48) (0.5V) = 24V, and enhanced substring 604a and 604b, and enhanced substring pair, may have a $V_{OCT}$ = (6) (0.5V) = 3V. Therefore, standard substring 602 and enhanced substring pair may not be directly electrically connected to each other in parallel due to the different electrical potentials.

FIG. 6B depicts an example mixed PV cell array 100k according to one or more aspects of the present disclosure. Solid black lines through substrings in FIG. 6B may represent substring electrical and/or conductive paths and are for purposes of example only. The conductive path may be through any number of different conductive media, for example, through PV cells, silver fingers, busbars, conductive backsheets, ribbon wire, etc. Each substring of FIG. 6B may be depicted with or without patterns. Substring patterns of FIG. 6B may only serve to delineate between adjacent substrings unless explicitly described differently herein (as described in relation to FIG. 1 above). Similar to the configuration of FIG. 6A, mixed PV cell array 100k may include two portions, one portion may include standard PV cells and standard substrings which may receive a first irradiance level, and a second portion may include enhanced PV cells and enhanced substrings which may receive a second irradiance level. FIGS. 1-5E depict mixed PV cell arrays 100 including standard substrings and enhanced substrings including the same number of PV cells per substring. Referring to FIG. 6A mixed PV cell array 100j may include standard substring 602, enhanced substring 604a and enhanced substring 604b. Standard substring 602 may include a greater number of PV cells than either enhanced substring 604a or 604b. Enhanced substrings 604a and 604b may include $\frac{1}{8}$ the number of PV cells of standard substring 602. Enhanced substrings 604a and 604b may be disposed adjacent to and parallel with opposing short edges 110b of mixed PV cell array and/or backsheet 102. Standard substring 602 may be disposed between enhanced substrings 604a and 604b. Standard substring 602 may terminate in a positive terminal and a negative terminal across which standard substring $V_{OCS}$ may be measured. First standard substring connector 606a may be connected to standard substring terminal of one polarity, and second standard substring connector 606b may be connected to standard substring terminal of the opposing polarity. First standard substrings connector 606a and second standard substrings connector 606b may include portions of complementary geometry that may be engaged with one another to connect first standard substring connector 606a to second standard connector 606b. Standard $V_{OCS}$ may similarly be measured between first standard substring connector 606a and second standard substring connector 606b. Enhanced substrings 604a and 604b may be electrically connected to each other in parallel as an enhanced substring pair. The enhanced substring pair may terminate in a positive terminal and a negative terminal across which enhanced substring pair $V_{OCT}$ may be measured. A first enhanced substring pair connector 608a may be connected to an enhanced substring pair terminal of one polarity and a second enhanced substring pair connector 608b may be connected to an enhanced substring pair terminal of an opposing polarity. First enhanced substrings connector 606a and second enhanced substrings connector 606b may include portions of complementary geometry that may be engaged with one another to connect first enhanced substring connector 606a to second enhanced connector 606b. Enhanced substring pair $V_{OCT}$ may similarly be measured between first enhanced substring pair connector 608a and second enhanced substring pair connector 608b. Referring to FIG. 6B, enhanced substrings 604a and 604b, or enhanced substrings pair, may not be electrically connected to standard substring 602 within mixed PV cell array 100. For example, assuming a nominal PV cell voltage of 0.5V (for both standard PV cells and enhanced PV cells), standard substrings may have a standard substring $V_{OCS}$ = (48) (0.5V) = 24V, and enhanced substring 604a and 604b, and enhanced substring pair, may have a $V_{OCT}$ = (6) (0.5V) = 3V. Therefore, standard substring 602 and enhanced substring pair may not be directly electrically connected to each other in parallel due to the different electrical potentials.

FIG. 6C depicts an example mixed PV module array 600a of mixed PV modules 624 of mixed PV cell arrays 100 of either FIGS. 6A and/or 6B. Referring to FIG. 6C, mixed PV module array 600a may include a plurality of mixed PV modules 624 (e.g., 624a, 624b, etc.). Mixed PV modules 624 may be the same, substantially similar to, and/or comprise mixed PV modules having PV cell arrays 100 of FIGS. 6A or 6B. First enhanced substring pair connector 608a (of one polarity) of one mixed PV module 624 (e.g., mixed PV module 624a) may connect to second enhanced substring pair connector 608b (of an opposing polarity) of another mixed PV module 624 (e.g., mixed PV module 624b), electrically serially connecting the enhanced substring pair of one mixed PV module 624 (e.g., 624a) to the enhanced substring pair of the other mixed PV module 624 (e.g., 624b) defining an enhanced substring pair string. Additional mixed PV modules 624 may be similarly added to enhanced substring pair string in mixed PV module array 600a. Mixed PV modules 624 may be added to enhanced substring pair string until a desired enhanced substring pair string length and associated $V_{OCT}$ is achieved. Such a desired enhanced substring pair string $V_{OCT}$ may be the same or substantially the same as the standard substring $V_{OCS}$ of a single standard substring 602 of a single mixed PV cell array 100 in mixed PV module array 600a. For example, assuming a standard PV cell and enhanced PV cell nominal $V_{OC}$ of 0.5V. Each mixed PV module 624 of mixed PV module array 600a may include a standard substring including, for example, forty-eight standard PV cells. Standard substring $V_{OCS}$ may equal (48) (0.5V) = 24V. Each mixed PV module 624 of mixed PV module array 600a may include two enhanced substrings including six enhanced substrings each electrically connected in parallel in an enhanced substring pair. Enhanced substring $V_{OCS}$ (assuming the nominal PV cell $V_{OC}$ of above) may then equal (6) (0.5V) = 3V. Since enhanced substrings may be connected in parallel to form enhanced substring pair, enhanced substring pair $V_{OCT}$ may equal enhanced substring $V_{OCS}$ (e.g., 3V in this example). In mixed PV module array 600a, enhanced substring pairs may be electrically connected in series until enhanced substring pair string $V_{OCT}$ equals the standard substring $V_{OCS}$ of a single standard substring 602 of a single mixed PV cell array 100 of mixed PV module 624. In the preceding example, enhanced substring pairs of eight mixed PV modules 624 may be serially connected in enhanced substring pair string such that enhanced substring pair string $V_{OCT}$ = (8) (3V) = 24V, equal to standard substring $V_{OCS}$ of 24V. Standard substrings and enhanced substring pair string may then be electrically connected in parallel. PV module array 600a may include varying mixed PV cell arrays 100. For example, PV module array 100 may include some mixed PV cell arrays 100 substantially similar to that of FIG. 6A, and some mixed PV cell arrays 100 substantially similar to that of FIG. 6B. Alternatively, PV module array 600a may include mixed PV arrays 100 of a single configuration.

Referring to FIG. 6C, standard substrings 602 of each mixed PV module 624 in mixed PV module array 600a may terminate in a first standard substring connector 606a of one standard substring terminal polarity and a second standard substring connector 606b of an opposing standard substring terminal polarity. Standard substrings 602 of all mixed PV modules 624 in mixed PV module array 600a may be electrically parallelly connected. Enhanced substring pair string may be electrically parallelly connected with all standard substrings 602 in mixed PV module array 600a. Mixed PV array harness 610 may be utilized to effectuate the parallel electrical connections of standard substrings 602 and the enhanced substring pair string. Additionally or alternatively, mixed PV array harness 610 may be utilized to effectuate the serial connections between enhanced substring pairs.

FIGS. 6A - 6B depict mixed PV modules having mixed PV cell arrays including standard substrings having forty-eight full standard PV cells, and enhanced substrings 604a and 604b having six enhanced PV cells. Standard substrings 602 may include any number of PV cells (e.g., twenty, thirty-two, thirty-six, sixty, seventy-two, ninety-six, etc.). Similarly, enhanced substrings 604a and 604b may include enhanced PV cells in any number that is a proper fraction of the number of the standard PV cells in standard substring 602. Mixed PV modules 624 and mixed PV cell arrays 100 of FIGS. 6A - 6B may include one, two, or more (e.g., three) enhanced substrings 604. According to the configurations including one enhanced substring per mixed PV cell array 100, enhanced substrings 604 of two or more mixed PV cell arrays 100 may be electrically connected in series as described in relation to enhanced substring pairs above, defining an enhanced substring string of mixed PV module array 600a. An enhanced substring string producing a substantially similar $V_{OCT}$ to standard substring 602 $V_{OCS}$ of each mixed PV cell array 100 of the mixed PV module array 600a, may be electrically connected in parallel with each of the standard substrings 602 of the mixed PV module array 600a. According to configurations including more than one (e.g., a plurality of) enhanced substring 604 per mixed PV cell array 100, each enhanced substring 604 may be the same length (e.g., including the same number of enhanced PV cells). The plurality of enhanced PV substrings 604 of a single mixed PV cell array 100 may be electrically connected with each other in parallel defining enhanced substring groups (e.g., enhanced substrings pairs of FIGS. 6A - 6B). Enhanced substring groups of two or more mixed PV cell arrays 100 may be electrically connected in series as described in relation to enhanced substring pairs above defining an enhanced substring group string of mixed PV module array 600a. An enhanced substring group string producing a substantially similar $V_{OCT}$ to standard substring 602 $V_{OCS}$ of each mixed PV cell array 100 of the mixed PV module array 600a, may be electrically connected in parallel with each of the standard substrings 602 of the mixed PV module array 600a.

The different configurations as described in relation to FIGS. 6A - 6C herein may be advantageous depending on mixed PV module 624 and mixed PV module array 600 (e.g., 600b or 600c) installation considerations. For example, assuming mixed PV modules 624 have a rectangular aspect ratio, it may be advantageous to install mixed PV modules 624 in a double stacked portrait arrangement (or a series or group of double stacked portrait arrangements). A double stacked portrait arrangement may include two adjacent rectangular mixed PV modules 624 wherein the short edges (e.g., sides) of each mixed PV module 624 abuts (or is adjacent to) one another (e.g., two stacked mixed PV modules 624, each in portrait orientation). In such an arrangement one short edge 110b of each of the double stacked portrait arranged mixed PV modules 624 may occupy outer edges of the double stacked portrait arrangement, and one short edge 110b of each of the double stacked portrait arranged mixed PV modules 624 may exist interiorly with regards to the double stacked portrait arrangement. In such an arrangement, the configurations of FIG. 6A may prove advantageous. In such a double stacked portrait arrangement, each mixed PV module 624 may be arranged such that the short edges 110, proximate to which the enhanced substrings 604 may be disposed, occur on the outer edges of the double stacked portrait arrangement (e.g., the mixed PV modules may be arranged such that the enhanced substrings may be disposed along the top and bottom edges of the double stacked portrait arrangement). Further, the short edges 110b of each mixed PV module 624, proximate to which standard PV cells are disposed, may abut one another interiorly near the middle of the double stacked portrait installation. For configurations including enhanced substrings 604 disposed on the long edges 110a of mixed PV module 624, a similar arrangement may be achieved with a double stacked landscape arrangement. In some installations, it may be advantageous to install numerous double stacked portrait arrangements alongside one another. The configurations of FIG. 6A may be advantageous given other installation requirements and are not limited to the above installations.

Other configurations may be advantageous considering other installation desires. For example, assuming mixed PV modules 624, it may be advantageous to install multiple mixed PV modules 624 in an array including a single row or column. In such installations the configurations of FIG. 6B may prove advantageous. In such installations, the edges proximate to which enhanced substrings are disposed (short edges 110b in FIG. 6B) may be installed to occur as the outside edges of the installation; and the edges proximate to which the standard substrings are disposed (long edges in FIGS. 6B) may be installed to abut one another interiorly with relation to the installation.

FIG. 6D depicts an example mixed PV module array 600b of mixed PV modules 632a according to one or more aspects of the present disclosure. Solid black lines through substrings in FIG. 6D may depict substring electrical and/or conductive paths and are used for purposes of example only. The conductive path may be through any number of different conductive media, for example, through PV cells, silver fingers, busbars, conductive backsheets, ribbon wire, etc. Each substring of FIG. 6D may be depicted with or without patterns. Substring patterns of FIG. 6D may only serve to delineate between adjacent substrings unless explicitly described differently herein (as described in relation to FIG. 1 above). FIGS. 6A - 6B depict mixed PV cell arrays 100 including standard substrings of forty-eight standard PV cells and enhanced substrings of six enhanced PV cells. Referring to FIG. 6D, standard substrings 602 and enhanced substrings 614a and 614b (and 604a and 604b) may include different numbers of PV cells and differently cut PV cells. Referring to FIG. 6D, standard substring 602 may include forty-eight full standard PV cells. Enhanced substrings 614a and 614b may include twenty-four $\frac{1}{4}$ cut enhanced PV cells 612. As described in more detail herein $\frac{1}{N}$ cut PV cells may produce substantially the same electrical potential as the full PV cell from which it was cut subject to similar environmental conditions (e.g., similar irradiance, temperature, etc.) (and substantially $\frac{1}{N}$ the $I_{sc}$ of the full PV cell from which it was cut under similar environmental conditions). Therefore, assuming an example nominal electrical potential of 0.5V for full standard PV cells and full enhanced PV cells, $\frac{1}{4}$ cut enhanced PV cells 612 may similarly produce substantially 0.5V. Standard substring 602 of forty-eight standard PV cells may produce substantially standard substring $V_{OCS}$ equal to (48)(0.5V) = 24V. Cut enhanced substrings 614a and 614b of twenty-four electrically serially connected $\frac{1}{4}$ cut enhanced PV cells 612 may produce $\frac{1}{4}$ cut enhanced substring $V_{OCS}$ substantially equal to (24)(0.5V) = 12V, substantially half that of standard substring $V_{OCS}$. Standard substring 602 may terminate in a positive terminal and a negative terminal across which standard substring $V_{OCS}$ may be measured. First standard substring connector 606a may be connected to standard substring terminal of one polarity, and second standard substring connector 606b may be connected to standard substring terminal of the opposing polarity. First standard substrings connector 606a and second standard substrings connector 606b may include portions of complementary geometry that may be engaged with one another to connect first standard substring connector 606a to second standard connector 606b. Standard $V_{OCS}$ may be measured between first standard substring connector 606a and second standard substring connector 606b. ¼ cut enhanced substrings 614a and 614b may be electrically connected to each other in parallel defining a cut enhanced substring pair. The cut enhanced substring pair may terminate in a positive terminal and a negative terminal across which cut enhanced substring pair $V_{OCT}$ may be measured. A first cut enhanced substring pair connector 608a may be connected to a cut enhanced substring pair terminal of one polarity and a second cut enhanced substring pair connector 608b may be connected to a cut enhanced substring pair terminal of an opposing polarity. First cut enhanced substring pair connector 606a and second cut enhanced substring pair connector 606b may include portions of complementary geometry that may be engaged with one another to connect first cut enhanced substring pair connector 606a to second cut enhanced substring pair connector 606b. Two 1/4 cut enhanced substrings 614a and 614b of mixed PV module may be electrically connected to each other in parallel defining a cut enhanced substring pair.

Still referring to FIG. 6D, mixed PV module array 600b may include two mixed PV modules 632a. First cut enhanced substring pair connector 608a (of one polarity) of one mixed PV module 632a may connect to second cut enhanced substring pair connector 608b (of an opposing polarity) of another mixed PV module 632a, electrically serially connecting the cut enhanced substring pair of one mixed PV module 632a to the cut enhanced substring pair of the other mixed PV module 632a, defining a cut enhanced substring pair string. Following connection, the cut enhanced substring pair string of mixed PV module array 600b may produce substantially the same total $V_{OCT}$ as substring $V_{OCS}$ of each standard substring 602. For example, assuming a full standard PV cell and full enhanced PV cell nominal $V_{OC}$ of 0.5V; each standard substring 602 of FIG. 6D may produce a standard substring $V_{OCS}$ = (48) (0.5V) = 24V; and each 1/4 cut enhanced substring 614a and 614b may produce a 1/4 cut enhanced substring $V_{OCS}$ = (24) (0.5V) = 12V. Similarly, cut enhanced substrings 614a and 614b may be electrically connected in parallel to form cut enhanced substring pairs. Therefore, cut enhanced substring pairs may produce substantially the same $V_{OCT}$ as $V_{OCS}$ of each cut enhanced substring 614a and 614b-12V (assuming example nominal voltage of above). Cut enhanced substring pair string (of electrically serially connected cut enhanced substring pair of mixed PV modules 632a) may produce a cut enhanced substring pair string $V_{OCT}$ equal to twice the cut enhanced substring pair $V_{OCT}$-cut enhanced substring pair string $V_{OCT}$ = (2)(12V) = 24V. Producing substantially the same electrical potential under similar environmental conditions (e.g., irradiance, temperature, etc.), cut enhanced substring pair string may be electrically connected in parallel with each standard substring 602 of mixed PV modules 632a in mixed PV module array 600b.

FIG. 6E depicts an example mixed PV module array 600c of mixed PV modules 632b according to one or more aspects of the present disclosure. Solid black lines through substrings in FIG. 6E may depict substring electrical and/or conductive paths and are for purposes of example only. The conductive path may be through any number of different conductive media, for example, through PV cells, silver fingers, busbars, conductive backsheets, ribbon wire, etc. Each substring of FIG. 6E may be depicted with or without patterns. Substring patterns of FIG. 6E may only serve to delineate between adjacent substrings unless explicitly described differently herein (as described in relation to FIG. 1 above) FIG. 6E depicts a configuration substantially similar to that of FIG. 6D and may be described substantially as the configuration of FIG. 6C unless explicitly described otherwise. 1/4 cut enhanced substrings 614a and 614b of FIG. 6D may be adjacent to one another, and disposed on a single half (e.g., the top half) of mixed PV cell array 100m, backsheet 102, and mixed PV module 632a. 1/4 cut enhanced substrings 614a and 614b of FIG. 6E, however, may be disposed variously. 1/4 cut enhanced substrings 614a and 614b of FIG. 6E may be disposed parallel with each other, each adjacent to an opposing short edge 110b of backsheet 102. Standard substring 602 of FIG. 6E may be disposed between 1/4 cut enhanced substrings 614a and 614b.

FIGS. 6D - 6E depict mixed PV modules 632 having mixed PV cell arrays 100 including standard substrings of forty-eight full standard PV cells and cut enhanced substrings 614a and 614b including twenty-four 1/4 cut enhanced PV cells each. Standard substrings 602 may include any number of PV cells (e.g., twenty, thirty-two, thirty-six, sixty, seventy-two, ninety-six, etc.). Further, standard substrings 602 may include any number of variously $\frac{1}{N}$ cut standard PV cells. Similarly, cut enhanced PV cells of 1/4 cut enhanced substrings 6014a and 614b may be variously $\frac{1}{N}$ cut (e.g., 1/2 cut, 1/3 cut, 1/4 cut, 1/8 cut, etc.); and 1/4 cut enhanced substrings 614a and 614b may include cut enhanced PV cells in any number that is a proper fraction of the number of the standard PV cells in standard substring 602. Mixed PV modules 632 and mixed PV arrays 100 of FIGS. 6D - 6E may include one, two, or more (e.g., three) cut enhanced substrings 614. According to the configurations including one cut enhanced substring per mixed PV array 100 of FIGS. 6D - 6E, cut enhanced substrings of two or more mixed PV modules 632 may be electrically connected in series as described in relation to cut enhanced substring pairs above, defining a cut enhanced substring string of a mixed PV module array 630. A cut enhanced substring string producing a substantially similar $V_{OCT}$ to standard substring 602 $V_{OCS}$ of each mixed PV module 632 of the mixed PV module arrays 630 of FIGS. 6D - 6E, may be electrically connected in parallel with each of the standard substrings 602 of the same mixed PV module arrays 630. According to configurations including more than one (e.g., a plurality of) cut enhanced substrings 614 per mixed PV module 632, each cut enhanced substring 614 may be the same length (e.g., including the same number of cut enhanced PV cells). The plurality of cut enhanced substrings 614 of a single mixed PV module 632 of mixed PV cell array 100 of FIGS. 6D - 6E may be electrically connected with each other in parallel, defining cut enhanced substring groups (e.g., cut enhanced substrings pairs of FIGS. 6D). Cut enhanced substring groups of two or more mixed PV modules 632 or mixed PV cell arrays 100 may be electrically serially connected as described in relation to cut enhanced substring pairs above, defining a cut enhanced substring group string of mixed PV module array 630. A cut enhanced substring group string producing a substantially similar $V_{OCT}$ to that of standard substring 602 $V_{OCS}$ of each mixed PV module 632 of the mixed PV module array 630 of FIGS. 6E - 6D, may be electrically connected in parallel with each of the standard substrings 602 of the same mixed PV module array 630.

Mixed PV modules 632 and 624, mixed PV cell arrays 100, and backsheets 102 of FIGS. 6A - 6E may be substantially rectangular (as depicted in FIGS. 6A - 6E) having two long edges 110a and two short edges 110b. As depicted in FIGS. 6A - 6E, enhanced substrings 604 and 614 (e.g., enhanced substrings 604 and ¼ cut enhanced substrings 614), may be disposed parallel with the short edges 110b of backsheet 102. Enhanced substrings 604 and 614 of FIGS. 6A - 6E may be disposed parallel with the long edges 110a of backsheet 102. Enhanced substrings disposed parallel with long edges 110a of backsheet 102 and mixed PV modules 632 and 624 may function substantially similar to enhanced substrings disposed parallel with short edges 1 10b, as described in relation to FIGS. 6A - 6E, in all other respects. Mixed PV modules of FIGS. 6A - 6E may have a substantially square aspect ratios having four substantially equal length edges. According to such examples, features described in relation to long edges 110a or short edges 110b may be considered to describe the feature in relation to any of the equal length edges.

The different configurations as described in relation to FIGS. 6D - 6E herein may be advantageous depending on mixed PV module 632 and mixed PV module array 600 (e.g., 600b or 600c) installation considerations. For example, assuming mixed PV modules 632 have a rectangular aspect ratio, it may be advantageous to install mixed PV modules 632 in a double stacked portrait arrangement (or a series or group of double stacked portrait arrangements). A double stacked portrait arrangement may include two adjacent rectangular mixed PV modules 632 wherein the short edges of each mixed PV module 632 abuts (or is adjacent to) one another (e.g., two stacked mixed PV modules 632, each in portrait orientation). In such an arrangement one short edge 110b of each of the double stacked portrait arranged mixed PV modules 632 may occupy outer edges of the double stacked portrait arrangement, and one short edge 110b of each of the double stacked portrait arranged mixed PV modules 632 may exist interiorly with regards to the double stacked portrait arrangement. In such an arrangement, the configurations of FIG. 6D may prove advantageous. In such a double stacked portrait arrangement, each mixed PV module 632 may be arranged such that the short edges 110, proximate to which the enhanced substrings 614 may be disposed, occur on the outer edges of the double stacked portrait arrangement (e.g., the mixed PV modules may be arranged such that the enhanced substrings may be disposed along the top and bottom edges of the double stacked portrait arrangement). Further, the short edges 110b of each mixed PV module 632, proximate to which standard PV cells are disposed, may abut each other interiorly near the middle of the double stacked portrait installation. For configurations including enhanced substrings 614 disposed on the long edges 110a of mixed PV module 632, a similar arrangement may be achieved with a double stacked landscape arrangement. In some installations, it may be advantageous to install numerous double stacked portrait arrangements alongside one another. The configurations of FIG. 6D may be advantageous given other installation requirements and are not limited to the above installations.

Other configurations may be advantageous considering other installation desires. For example, assuming mixed PV modules 632, it may be advantageous to install multiple mixed PV modules 632 in an array including a single row or column. In such installations the configurations of FIG. 6E may prove advantageous. In such installations, the edges proximate to which enhanced substrings are disposed (short edges 110b in FIG. 6E) may be installed to occur as the outside edges of the installation; and the edges proximate to which the standard substrings are disposed (long edges in FIGS. 6E) may be installed to abut one another interiorly with relation to the installation.

With reference to FIGS. 6A - 6E different enhanced substrings of FIGS. 6A - 6E may be differently enhanced. For example, one or more enhanced substrings 604a, 604b, 614a, and/or 614b may include bifacial suited PV cells and a transparent backsheet. Whereas, one or more additional enhanced substrings 604a, 604b, 614a, and/or 614b may include monofacial and or bifacial suited PV cells and may be backed by a decreased transparency and reflective backsheet. Alternatively, all of the enhanced substrings of FIGS. 6A - 6E may be similarly enhanced (e.g., all substrings may include bifacially suited PV cells backed by an increased transparency backsheet). The present disclosure is not limited to these combinations of substring enhancement, rather all combinations of enhancement are contemplated herein.

Standard substrings of FIGS. 6A - 6E may be monofacial suited PV cells backed by a decreased transparency backsheet or an increased transparency backsheet. Alternatively, standard substrings of FIGS. 6A - 6E may be bifacially suited PV cells backed by increased transparency backsheet. Two or more different standard substrings may be differently standardized.

With reference now to FIGS. 6C - 6E, mixed PV module arrays 600a - 600c may include wiring harness 610. Wiring harness 610 may facilitate the electrical interconnection of some or all of the mixed PV modules 624a - 624h and 632a and 632b of mixed PV module arrays 600a - 600c. First standard substring connectors 606a of each mixed PV module 624 and 632 may be connected to a first electrical bus 616 of a first polarity. Second standard substring connectors 606b of each mixed PV module 624 and 632 may be connected to a second electrical bus 618 of a second polarity. Similarly, first enhanced substring connector 608a of the first mixed PV module 624a in mixed PV module array 600a and PV modules 632a and 632b of PV module arrays 600b and 600c respectively, may be connected to first electrical bus 616 of a first polarity; and second enhanced substring connector 608b of the last mixed PV module 624h in mixed PV module array 600a, and last mixed PV module 632a and 632b of mixed PV module arrays 600b -600c, may be connected to second electrical bus 618 of a second polarity. First electrical bus 616 and second electrical bus 618 may be connected to wiring harness 610. First electrical bus 616 and second electrical bus 618 may be disposed in wiring harness 610. Alternatively, first electrical bus 616 and second electrical bus 618 may be separate from wiring harness 610. Wiring harness may further include power electronics (PEs) 1202 as discussed in more detail herein. PEs may, among other functions, assist in maximum power point tracking (MPPT), DC/DC conversion, DC/AC inversion, communication etc. as described in more detail in relation to PEs herein. First mixed PV module array terminal 620 or lead may avail the power produced by mixed PV module array 600a, 600b or 600c of a first polarity and second mixed PV module array terminal 622 or lead may avail the power produced by mixed PV module array 600a, 600b or 600c of a second polarity.

Multiple wiring harnesses 610 of multiple mixed PV module array 600a, 600b and/or 600c may be variously electrically connected resulting in larger mixed PV module arrays. For example, wiring harness 610 of mixed PV module array 600b may be electrically connected in parallel with wiring harness 610 of mixed PV module array 600c. According to another example, wiring harness 610 of mixed PV module array 600a may be wired in series with wiring harness 610 of mixed PV module array 600c. Any number and variation of arrays 600 may be electrically connected in any combination of series, parallel, and/or series-parallel (where each connection is appropriate, for example, parallel connection may be made between arrays or wiring harnesses 610 having similar $V_{OC}$) or other electrical connection schemes known to those of ordinary skill in the art.

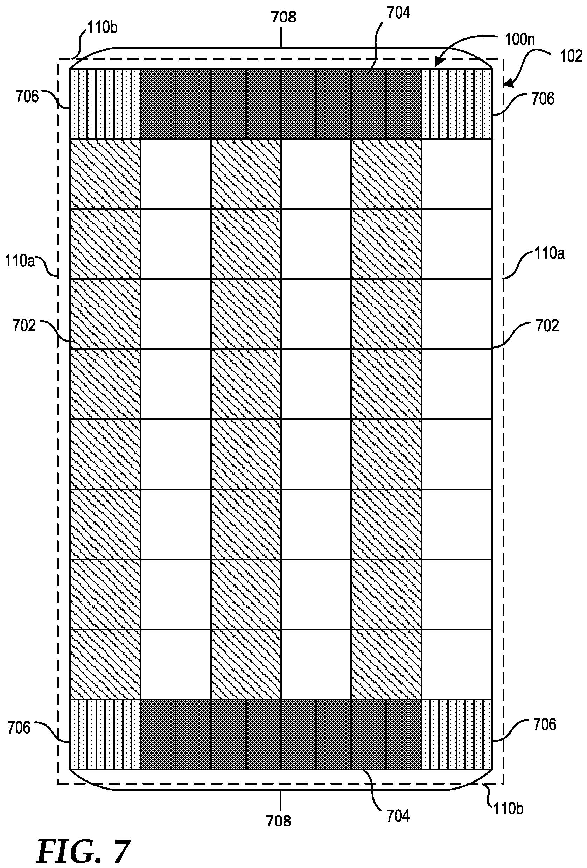

FIG. 7 depicts an example mixed PV cell array 100n according to one or more aspects of the present disclosure. Each substring of FIG. 7 may be depicted with or without patterns. Substring patterns of FIG. 7 may only serve to delineate between adjacent substrings (as described in relation to FIG. 1 above) unless explicitly described differently herein. With reference to FIG. 7, mixed PV cell arrays 100 may include substrings of variously $\frac{1}{N}$ cut PV cells. It may be appreciated that N number of $\frac{1}{N}$ cut PV cells, may occupy substantially the same space as a full PV cell. Referring to FIG. 7, mixed PV cell array 100n may include multiple standard substrings 702 including electrically serially connected standard PV cells. Standard substrings 702 may have a length (e.g., a number of standard PV cells per standard substring 702). For example, standard substrings may include eight standard PV cells per standard substring 702. The number eight is intended as example only. Rather, it may be advantageous to have more or less standard PV cells (e.g., six, twenty, etc.) per standard substring 702. Mixed PV cell array 100n may further include ½ cut enhanced substrings 704 including electrically serially connected ½ cut enhanced PV cells. ½ cut enhanced substrings 704 may include the same number of PV cells as standard substrings 702. For example, ½ cut enhanced substrings 704 may include eight ½ cut enhanced PV cells per ½ cut enhanced substring 704. The number eight is intended as an example only. Rather, it may be advantageous to have more or less ½ cut enhanced PV cells (e.g., six, twenty, etc.) per ½ cut enhanced substring 704. Mixed PV module may further include 1/8 cut enhanced substrings 706 including electrically serially connected 1/8 cut enhanced PV cells. 1/8 cut enhanced substrings 706 may include the same number of PV cells as standard substrings 702 and ½ cut enhanced substrings 704. For example, 1/8 cut enhanced substrings 706 may include eight 1/8 cut enhanced PV cells per 1/8 cut enhanced substring 706. The number eight is intended as an example only. Rather, it may be advantageous to include more or less 1/8 cut enhanced PV cells (e.g., six, twenty, etc.) per 1/8 cut enhanced substring 706. ½ and 1/8 cut enhanced PV cells may be substantially similar to enhanced PV cells in all other respects unless otherwise explicitly described herein. As described, substrings (e.g., standard substring 702, ½ cut enhanced substring 704, and 1/8 cut substring 706) including the same number of PV cells may produce substantially the same substring $V_{OCS}$ as described herein.

With reference to FIG. 7, mixed PV cell array 100n and backsheet 102 may be rectangular shaped having two long edges 110a and two short edges 110b. Enhanced PV substrings (e.g., ½ cut enhanced substrings 704 and 1/8 cut enhanced substrings 706) may be disposed proximate to and parallel with short edges 110b. An enhanced substring group 708 may be disposed proximate to and along each short edge 110b. A 1/8 cut enhanced substring 706 may be disposed at each corner of mixed PV cell array 100n and backsheet 102. A ½ cut enhanced substring 704 may be disposed between each 1/8 cut enhanced substring 706 and along short edges 110b. Standard substrings 702 may be disposed between enhanced substrings groups 708. Each standard substring 702 may begin proximate to one enhanced substring group 708 and terminate proximate the opposing enhanced substring group 708 routing parallel with the long edges 110a of backsheet 102. Under particular conditions, such an arrangement may prove advantageous. For example, the corners of a PV cell array or PV module may receive the most irradiance. This may be a consequence of two exposed edges at each corner (allowing, for example, increased reflected irradiance around both exposed edges). Therefore, by arranging independent substrings on each corner, the corner substrings may experience increased production (without being inhibited by mismatched lesser irradiated PV cells). Subsequently, such substrings may be connected to the other substrings of the mixed PV cell array 100n in parallel increasing substring production.

With reference to FIG. 7, as described, all substrings (e.g., standard substrings 702, ½ cut enhanced substrings 704, and 1/8 cut enhanced substrings 706) may include the same number of PV cells (e.g., eight PV cells per substring). As described, $\frac{1}{N}$ cut PV cells may produce substantially the same $V_{OC}$ as the full PV cell from which it was cut. Therefore, the substrings of the mixed PV cell array 100 of FIG. 7 may have substantially similar $V_{OCS}$. The substrings of the mixed PV cell array 100n may then be electrically connected in parallel. Alternatively, some or all of the substrings of FIG. 7 may be variously electrically connected. For example, the ½ cut enhanced substrings 704 may be electrically connected to each other in series. Further, the 1/8 cut enhanced substrings 706 may be electrically connected resulting in two sets of two electrically serially connected 1/8 cut enhanced substrings 706. Finally, standard substrings 702 may be electrically serially connected in serial sets of two standard substrings. The sets of serially connected substrings may then be connected in parallel. Other electrical connections and arrangements are contemplated herein.

Different enhanced substrings (even of a single enhanced substring group) may be differently enhance. For example, 1/8 cut enhanced substrings 706 of enhanced substring group 708 may include bifacial suited PV cells and a transparent backsheet. Whereas ½ cut enhanced substring 704 may include monofacial and or bifacial suited PV cells and may be backed by a decreased transparency and reflective backsheet. Alternatively, all of the enhanced substrings of FIG. 7 may be similarly enhanced (e.g., all substrings may include bifacially suited PV cells backed by an increased transparency backsheet). The present disclosure is not limited to these combinations of substring enhancement, rather all combinations of enhancement are contemplated herein.

Standard substrings of FIG. 7 may be monofacial suited PV cells backed by a decreased transparency backsheet or an increased transparency backsheet. Alternatively, standard substrings of FIG. 7 may be bifacially suited PV cells backed by increased transparency backsheet.

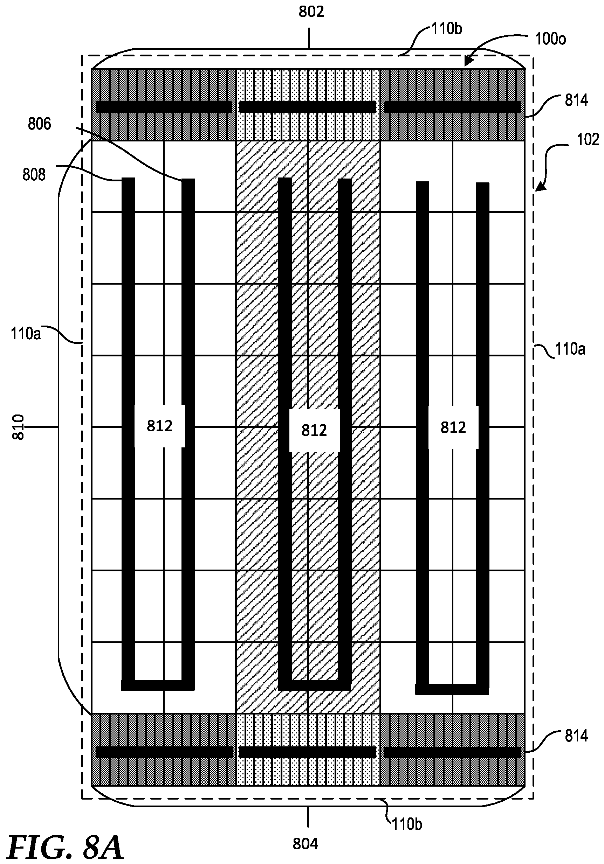

FIG. 8A depicts an example mixed PV cell array 100o according to one or more aspects of the present disclosure. Each substring of FIG. 8A - 8E may be depicted with or without patterns. Substring patterns of FIGS. 8A - 8E may only serve to delineate between adjacent substrings (as described in relation to FIG. 1 above) unless explicitly described differently herein. Solid black lines through substrings in FIGS. 8A - 8E may depict substring electrical and/or conductive paths and are intended for purposes of example only. The conductive path may be through any number of different conductive media, for example, through PV cells, silver fingers, busbars, conductive backsheets, ribbon wire, etc. Like other examples described herein, mixed PV cell arrays 100 may include PV cells of different sizes. Referring to FIG. 8A, mixed PV array 100o may include at least two areas, areas including enhanced substrings and areas including standard substrings. Referring to FIG. 8A, mixed PV cell array 100o and backsheet 102 may be substantially rectangular in shape with a two long edges 110a and two short edges 110b.

Referring to FIG. 8A, mixed PV cell array 100o may include two groups of enhanced substrings, first enhanced substring group 802 and second enhanced substring group 804. Each enhanced substring group may be disposed parallel with and adjacent to a backsheet short edge 110b and may include three 1/8 cut enhanced substrings 814, each including a string of sixteen electrically serially connected 1/8 cut enhanced PV cells. Mixed PV cell array 100o may further include three standard substrings 812, each including a string of sixteen electrically serially connected standard PV cells. The standard substrings 812 may be disposed between the enhanced substring groups 802 and 804. Each standard substring 812 may include a first terminal 806 (of a first electrical polarity (e.g., positive)) and a second terminal 808 (of an opposing electrical polarity (e.g., negative)) at opposing substring ends. The terms first and second are merely referential and may be used interchangeably and are not intended to be limiting. The path of standard substring 812 may be substantially "U" shaped. Stated differently, each standard substring 812 may be disposed in two rows (or columns depending on orientation) on backsheet 102. The path of standard substring 812 may extend from first terminal 806, proximate to the first enhanced substring group 802, to the standard substring midpoint, proximate to the second enhanced substring group 804. The path of standard substring 812 may then turn and begin the second row. The second row may extend from the standard substring midpoint proximate to the second enhanced substrings group 804, to the second terminal 808 proximate to the first enhanced substring group 802. Alternatively, the path may begin and end (at the first and second terminal) proximate to the second enhanced group 804, and the substring midpoint may occur proximate to the first enhanced substring group 802. The substrings (e.g., six 1/8 cut enhanced substrings 814, and three standard substring 812) may be electrically connected in parallel with one another. Alternatively, the substrings may be variously electrically connected. For example, some of the substrings may be electrically connected in series and some may be connected in parallel. For example, first group of 1/8 cut enhanced substrings 802 may be electrically serially connected. Additionally, second group of 1/8 cut enhanced substrings may be electrically serially connected. Further, the standard substrings 812 may be electrically serially connected. The three groups of electrically serially connected substrings may then be connected to each other in parallel. The substrings may be alternatively variously electrically connected.

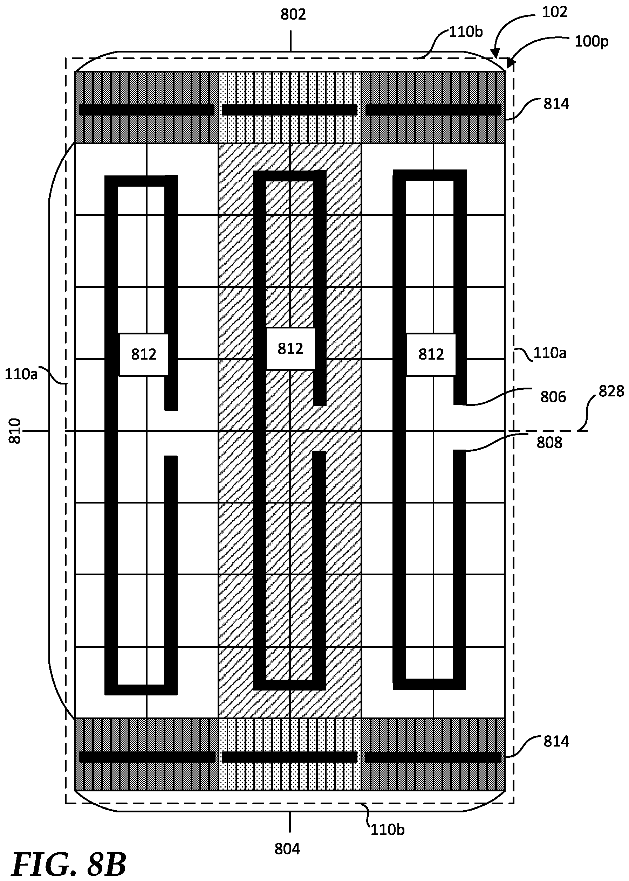

FIG. 8B depicts an example mixed PV cell array 100p according to one or more aspects of the present disclosure. FIG. 8B depicts a substantially similar mixed PV cell array 100 and PV cell module to that of FIG. 8A with differently shaped standard substring paths. FIG. 8B may considered to depict the configuration of FIG. 8A in all other respects and unless otherwise explicitly described herein. Referring to FIG. 8B, standard substring paths may be substantially "C" shaped. Stated differently, each standard substring may include two rows (or columns depending on orientation of the mixed PV cell array 100p). The first standard substring terminal 806 and second standard substring terminal 808, may terminate near the physical transversal midline 828 of standard substring 812. Standard substring 812 may extend from first standard substring terminal 806 toward first enhanced substring group 802. Proximate to first enhanced substring group, standard substring 812 may turn and begin the second row of standard substring 812. The second row may extend from proximate to the first enhanced substring group 802 toward second enhanced substring group 804, and end proximate to second enhanced substring group 804. Standard substring 812 may turn back to the first row proximate to second enhanced substring group 804 and extend from second enhanced substring group 804 to second standard substring terminal 808 proximate to the transversal midline 828 of standard substring 812. FIG. 8B, depicts each standard substring 812 terminating in the right most row of each substring. Standard substrings may terminate variously; some or all standard substrings 812 may terminate in the rightmost row, some or all standard substrings may terminate in the leftmost row. The substrings (e.g., six 1/8 cut enhanced substrings 814, and three standard substring 812) may be electrically connected in parallel with one another. Alternatively, the substrings may be variously electrically connected. For example, some of the substrings may be electrically connected in series and some may be connected in parallel. For example, first group of 1/8 cut enhanced substrings 802 may be electrically serially connected. Additionally, second group of 1/8 cut enhanced substrings may be electrically serially connected. Further, the standard substrings 812 may be electrically serially connected. The three groups of electrically serially connected substrings may then be connected to each other in parallel. The substrings may be variously electrically connected.

Standard substring paths may follow various shapes. For example, substring paths may be square-wave shaped (e.g., standard substrings of FIGS. 5B and 5D). Additionally, FIGS. 8A - 8B depict symmetric substrings, having a physical rectangular shape. Alternatively, however, enhanced substrings can be asymmetrically shaped and disposed variously. Additionally, FIGS. 8A - 8B depict standard substrings 812 routed parallel with mixed PV module long edge 110a. Standard substrings 812 may be routed parallel with mixed PV module short edge 110b.

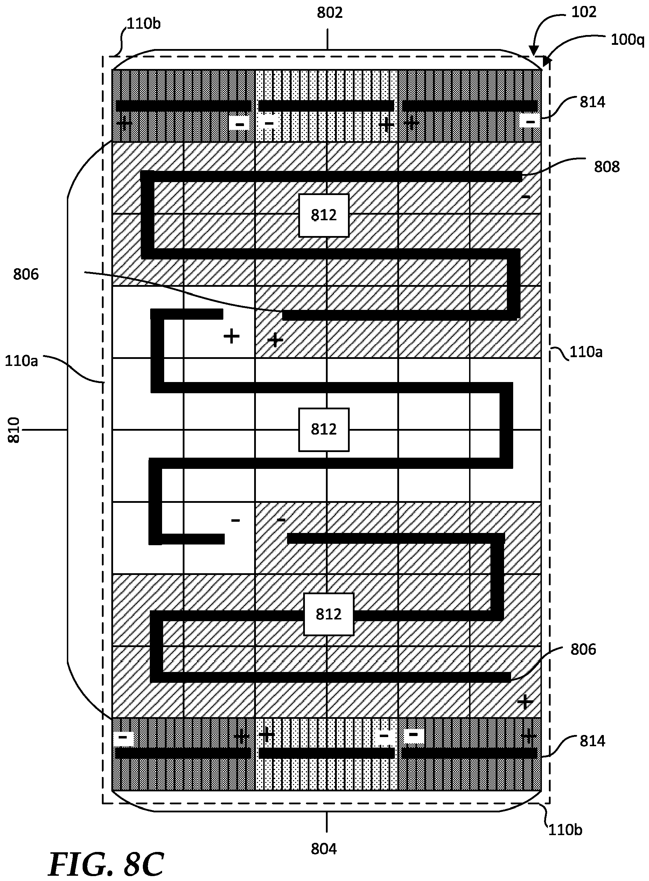

FIG. 8C depicts an example mixed PV cell array 100q according to one or more aspects of the present disclosure. FIG. 8C depicts a substantially similar mixed PV cell array 100 to those of FIG. 8A - 8B unless explicitly described herein. Referring to FIG. 8C, standard substrings 812 may be asymmetrically shaped, and variously shaped within a single mixed PV cell array. The standard substring 812 may begin at an extremity of the standard substring group 810 (e.g., the bottom right most corner of the standard substring group 801) and extend parallel with the enhanced substring groups 802 and 804 and proximate to one enhanced substring group (e.g., second enhanced group 804) and snake toward the opposing enhanced substring group. The substrings (e.g., 1/8 cut enhanced substrings 814, and standard substrings 812) may be electrically connected in parallel with one another. FIG. 8C depicts the standard substring arranged in such a way to simplify parallel electrical connection between the substrings. FIG. 8C depicts substrings terminals of the same polarity terminating proximate to one another. As such, parallel electrical connection between such substrings may be simplified by connecting the terminals of the same polarity of adjacent substrings. However, substring may be arranged to terminate variously. For example, it may be desirable to electrically serially connect all standard substrings 812. In such a configuration, it may be desirable to arrange the standard substrings 812 such that terminals of opposing polarity terminate proximate to one another. Such an arrangement may facilitate serial electrical connection (by connecting adjacent terminals of opposing polarities). Various electrical connection between substring and substring groups are contemplated herein. For example, first group of 1/8 cut enhanced substrings 802 may be electrically serially connected; second group of 1/8 cut enhanced substrings may be electrically serially connected; the standard substrings 812 may be electrically serially connected. The three groups of electrically serially connected substrings may then be connected to each other in parallel. The substrings may be alternatively connected and arranged.

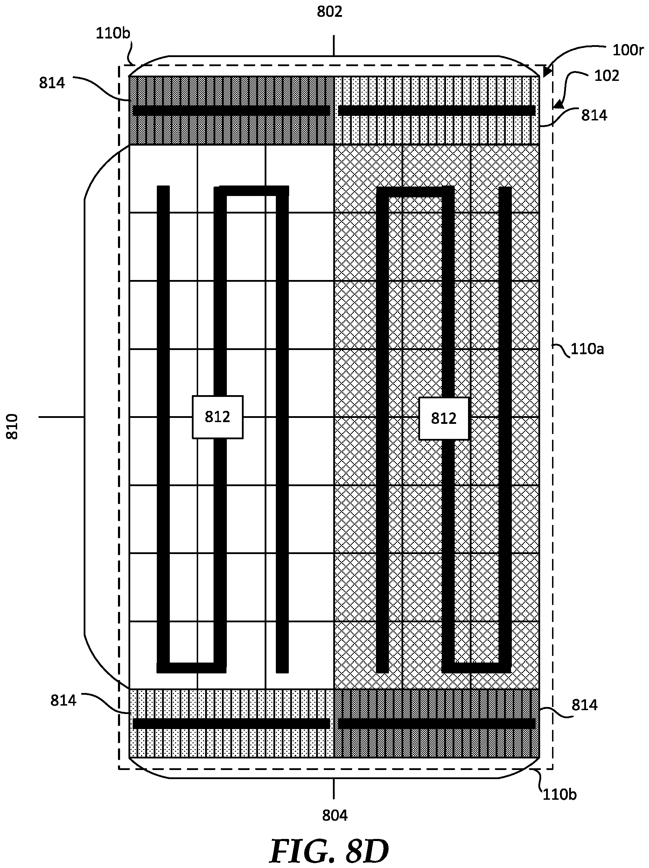

FIGS. 8A - 8C depict aspects including three substrings per group (e.g., three 1/8 cut enhanced substrings 814 per enhanced substring group 802 and 804 and three standard substrings 812 per standard substring group 810). Groups may include more or less substrings per group. For example, each group may include two (e.g., configuration of FIG. 8D below), four, five, or six substrings. Additionally, FIGS. 8A - 8C depict substrings that may include sixteen PV cells each. Substrings may include more or less PV cells per substring. For example, substrings may include twenty-four, thirty-two, etc. PV cells per substring. Additionally, FIGS. 8A - 8C depict groups of substrings that may include the same number of substrings. Substring groups (e.g., 802, 804, and 810) may include varying number of substrings. For example, enhanced substring groups 802 and 804 may include four, 1/8 cut enhanced substrings 814, and standard substring group 810 may include three standard substrings 812. Additionally, FIGS. 8A - 8C depict enhanced substrings groups 802 and 804 disposed along short edges 110b of the mixed PV cell array 100 and backsheet. Enhanced substring groups may be disposed adjacent to and parallel with the long edge 110a of mixed PV cell array 100 and backsheet 102. Additionally, FIGS. 8A - 8C depict 1/8 cut enhanced PV cells and full standard PV cells. Enhanced PV cells of the configurations of FIGS. 8A - 8C may be full enhanced PV cells or variously 1/N cut enhanced PV cells.

FIG. 8D depicts an example mixed PV cell array 100r according to one or more aspects of the present disclosure. FIG. 8D depicts a substantially similar mixed PV cell array 100 to those of FIGS. 8A -8C with two substrings per substrings group. Referring to FIG. 8D, mixed PV cell array 100r may include two enhanced substring groups 802 and 804 and a standard substring group 810. Each enhanced substring group 802 and 804 may include two 1/8 cut enhanced substrings 814. The two enhanced substring groups 802 and 804 may be disposed, along with their associated backsheet regions, proximate to and parallel with opposing short edges 110b. Standard substring group 810 may include two standard substrings 812. Standard substring group, and its associated backsheet region, may be disposed between enhanced substring groups 802 and 804. Standard substrings 812 paths may extend parallel with the backsheet long edges 110a. Referring to FIG. 8D, standard substrings 812 and 1/8 cut enhanced substrings 814 may include twenty-four PV cells each. Standard substrings 812 and enhanced substrings 814 may include more or less PV cells per substring. For example, each substring may include sixteen, thirty-two, forty, etc. PV cells per substring. The substrings (e.g., 1/8 cut enhanced substrings 814, and standard substring 812) may be electrically connected in parallel with one another. Alternatively, the substrings may be variously electrically connected. For example, some of the substrings may be electrically connected in series and some may be connected in parallel. For example, first group of 1/8 cut enhanced substrings 802 may be electrically serially connected. Additionally, second group of 1/8 cut enhanced substrings may be electrically serially connected. Further, standard substrings 812 may be electrically serially connected. The three groups of electrically serially connected substrings may then be connected to each other in parallel. The substrings may be variously electrically connected.

Different enhanced substrings of FIGS. 8A - 8D (even of a single enhanced substring group) may be differently enhanced. For example, one (or more) 1/8 cut enhanced substrings 814 of enhanced substring group 802 and/or 804 may include bifacial suited PV cells and a transparent backsheet area. Whereas another one (or more) 1/8 cut enhanced substring 814 of enhanced substring group 802 and/or 804 may include monofacial and or bifacial suited PV cells and may be backed by a decreased transparency and reflective backsheet. Alternatively, all of the enhanced substrings of FIGS. 8A - 8D may be similarly enhanced (e.g., all substrings may include bifacially suited PV cells backed by an increased transparency backsheet). The present disclosure is not limited to these combinations of substring enhancement, rather all combinations of enhancement are contemplated herein.

Standard substrings of FIGS. 8A - 8D may be monofacial suited PV cells backed by a decreased transparency backsheet or an increased transparency backsheet. Alternatively, standard substrings of FIGS. 8A - 8D may be bifacially suited PV cells backed by increased transparency backsheet. Two different standard substrings 812 of the same standard substring group 810 may include differently standardized substrings.

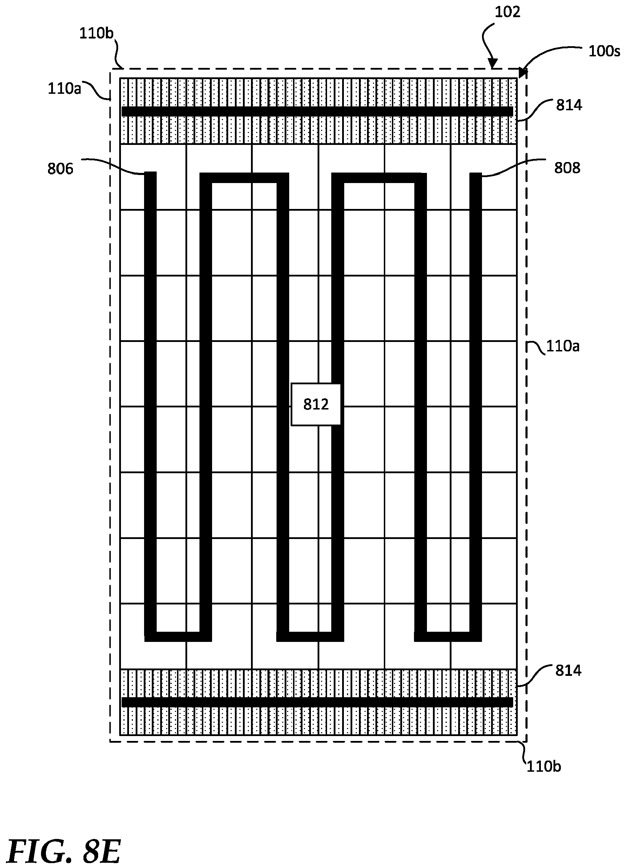

FIG. 8E depicts an example mixed PV cell array 100s according to one or more aspects. Like other examples described herein, mixed PV arrays and mixed PV modules may include PV cells of different sizes. Mixed PV cell array 100 may include at least two areas, areas including enhanced substrings and areas including standard substrings. As described herein, areas of the backsheet 102 upon which enhanced substrings may be disposed, may include material of increased transparency as compared to the areas upon which standard substrings may be disposed.

With reference now to FIG. 8E, mixed PV cell array 100s may include two 1/8 cut enhanced substrings 814, each disposed adjacent to and parallel with opposing edges of mixed PV cell array 100s and backsheet 102. Each 1/8 cut enhanced substring may be disposed adjacent to and parallel with short edges 110b. Mixed PV cell array may further include standard substring 812. Standard substring 812 and corresponding backsheet (e.g., lower transparency etc.) may be disposed between the two 1/8 cut enhanced substrings 814 and corresponding backsheet. 1/8 cut enhanced substrings 814 and standard substring 812 may each include the same number of PV cells. For example, each substring (e.g., each 1/8 cut enhanced substring 814 and standard substring 812) may include forty-eight PV cells per substring.

$\frac{1}{N}$ cut PV cells may produce substantially the same $V_{OC}$ as the full PV cell from which it was cut subject to similar environmental conditions (e.g., irradiance, temperature, etc.) as described herein. Therefore, each substring (e.g., both 1/8 cut enhanced substring 814 and standard substring 812) may produce substantially similar substring $V_{OCS}$. 1/8 cut substrings 814 and standard substring 812 may be electrically connected to each other in parallel. Alternatively, the substrings, or a portion thereof, may be electrically serially connected. FIG. 8E depicts substrings having forty-eight PV cells each. However, the number of PV cells in substrings of FIG. 8E may vary. For example, the substrings of FIG. 8E may include forty, fifty-six, sixty-four etc. or any other number of PV cells. FIG. 8E depicts a mixed PV array with 1/8 cut enhanced substrings 814 proximate to and parallel with short edges 110b. Alternatively, 1/8 cut enhanced substrings 814 (and associated backsheet regions) may be disposed proximate to and parallel with long edges 110a. In some examples, some configurations may have a substantially square aspect ratio. In such configurations, 1/8 cut enhanced substrings and associated higher transparency backsheet regions may be disposed proximate to and parallel with any two opposing edges.

Different enhanced substrings 814 of FIG. 8E may be differently enhanced. For example, 1/8 cut enhanced substring 814 disposed adjacent to the top short edge 110b of backsheet 102 may include bifacial suited PV cells and a transparent backsheet. Whereas 1/8 cut enhanced substring 814 disposed adjacent to the bottom short edge 110b of backsheet 102 may include monofacial and or bifacial suited PV cells and may be backed by a decreased transparency and reflective backsheet. Alternatively, all of the enhanced substrings of FIG. 8E may be similarly enhanced (e.g., all substrings may include bifacially suited PV cells backed by an increased transparency backsheet). The present disclosure is not limited to these combinations of substring enhancement, rather all combinations of enhancement are contemplated herein.

Standard substring 812 of FIG. 8E may be monofacial suited PV cells backed by a decreased transparency backsheet or an increased transparency backsheet. Alternatively, standard substring 812 of FIG. 8 may be bifacially suited PV cells backed by increased transparency backsheet.

As described above, (in reference to FIG. 7) aspects herein relate to mixed PV cell arrays 100 having variously different sized PV cells. FIG. 9 depicts an example mixed PV cell array 100t according to one or more aspects of the present disclosure. Each substring of FIG. 9 may be depicted with or without patterns. Substring patterns of FIG. 9 may only serve to delineate between adjacent substrings (as described in relation to FIG. 1 above) unless explicitly described differently herein. Mixed PV cell array 100t of FIG. 9 may be substantially rectangular having two long edges 110a and two short edges 110b. Referring to FIG. 9, mixed PV cell array 100t may include substrings of PV cells that are variously cut and arranged such that substrings of the same number of PV cells may be arranged, patterned, and nested to conform to a symmetric polygonal shape. Enhanced PV cells, and associated backsheet 102 regions, may be disposed around the entire backsheet 102 perimeter and mixed PV cell array 100t perimeter. Referring to FIG. 9, mixed PV cell arrays may include 1/3 cut enhanced substrings 902, ¼ cut enhanced substrings 904, 1/6 cut enhanced substrings 906, and standard substrings. 1/3 cut enhanced substrings 902, ¼ enhanced substrings 904, 1/6 cut enhanced substring 906 and standard substrings 910 may all include the same number of PV cells per substring. Mixed PV cell array 100t may include one standard substring 910 which may be disposed in the center of mixed PV array 100t and may be surrounded by variously cut enhanced substrings. Standard substrings 910 may be substantially rectangular having a width and a length, and may be disposed in rows routed parallel with backsheet long edge 110a. Alternatively, standard substring may be disposed in rows parallel with mixed PV array short edge 110b. Mixed PV cell array 100t may include two 1/6 cut enhanced substrings 906. Each 1/6 cut enhanced substring 906 may have a length and a width. The length of each 1/6 cut enhanced substring 906 may be substantially equal to the width of standard substring 910. One 1/6 cut enhanced substring 906 may be disposed parallel with PV cell array short edge 110b and adjacent to and above standard substring 910. One 1/6 cut enhanced substring 906 may be disposed parallel with PV cell array short edge 110b and adjacent to and below standard substring 910. Each 1/6 cut enhanced substring 906 may extend substantially the width of standard substring 910.

Referring to FIG. 9, mixed PV cell array 100t may further include two 1/3 cut enhanced substrings 902. Each 1/3 cut enhanced substring 902 may have a length and a width. The length of each 1/3 cut enhanced substring 902 may be (by virtue of its PV cells being 1/3 cut) substantially equal to the length of standard substring 910 plus the width of both 1/6 cut enhanced substrings 906. One 1/3 cut enhanced substring 902 may be disposed parallel with PV cell array long edge 110a and adjacent to and to the right of standard substring 910. The other 1/3 cut enhanced substring 902 may be disposed parallel with PV cell array long edge 110a and adjacent to and to the left of standard substring 910. Each 1/3 cut enhanced substring 902 may extend substantially the length of standard substring 910 plus the width of both 1/6 cut enhanced substrings 906. Mixed PV cell array 100t may include two 1/4 cut enhanced substrings 904. Each 1/4 cut enhanced substring 904 may have a length and a width. The length of each 1/4 cut enhanced substring 904 may be substantially equal to the width of standard substring 910 plus the width of both 1/3 cut enhanced substrings 902 (e.g., the width of standard substring 910 plus two full PV cells). One 1/4 cut enhanced substring 90 may be disposed parallel with PV cell array short edge 110b and adjacent to and above 1/6 cut enhanced substring 906. The other 1/4 cut enhanced substring 904 may be disposed parallel with PV cell array short edge 110b and adjacent to and below 1/6 cut enhanced substring 906. Each 1/4 cut enhanced substring 906 may extend substantially the length of PV cell array short edge. Standard substring 910, 1/6 cut substrings 906, ¼ cut substrings 904, and 1/3 cut substrings may be electrically connected to each other in parallel. Alternatively, the substrings of FIG. 9, or a portion thereof, may be electrically serially connected. FIG. 9 depicts substrings having twenty-four PV cells each. However, in different configurations, the number of PV cells in substrings of FIG. 9 may vary.

FIG. 9 depicts an example of an example mixed PV cell array 100t, where standard and enhanced PV cells are variously cut and arranged such that substrings of the same length may be nested and patterned within and around one another. Further according to such configurations, enhanced PV cells and substrings may substantially surround standard PV cells and substrings. Such configurations may be practiced with variously cut and arranged enhanced and standard PV cells and are not limited to the example depicted in FIG. 9. For example, a similar pattern to that of FIG. 9 may be achieved by cutting each PV cell of FIG. 9 in half. Such a pattern may include substrings having forty-eight ½ cut standard PV cells; forty-eight 1/6 cut enhanced PV cells; forty-eight 1/12 cut enhanced PV cell; and forty-eight 1/8 cut enhanced PV cells. The above example depicts how such configuration may be practiced with a different number of PV cells per substring and differently cut PV cells, other variations are similarly contemplated herein. For example, such configurations may be practiced with five, six, or more different sized PV cells (instead of four differently sized PV cells as depicted in FIG. 9. Further, such configurations may be practiced with varying patterns and nesting.

Different enhanced substrings 814 of FIG. 9 may be differently enhanced. For example, 1/3 cut enhanced substring 902 may include bifacial suited PV cells and a transparent backsheet. Whereas, 1/4 cut enhanced substring 904 may include monofacial and or bifacial suited PV cells and may be backed by a decreased transparency and reflective backsheet. Alternatively, all of the enhanced substrings of FIG. 9 may be similarly enhanced (e.g., all substrings may include bifacially suited PV cells backed by an increased transparency backsheet). The present disclosure is not limited to these combinations of substring enhancement, rather all combinations of enhancement are contemplated herein.

Standard substring 910 of FIG. 9 may be monofacial suited PV cells backed by a decreased transparency backsheet or an increased transparency backsheet. Alternatively, standard substring 910 may be bifacially suited PV cells backed by increased transparency backsheet.

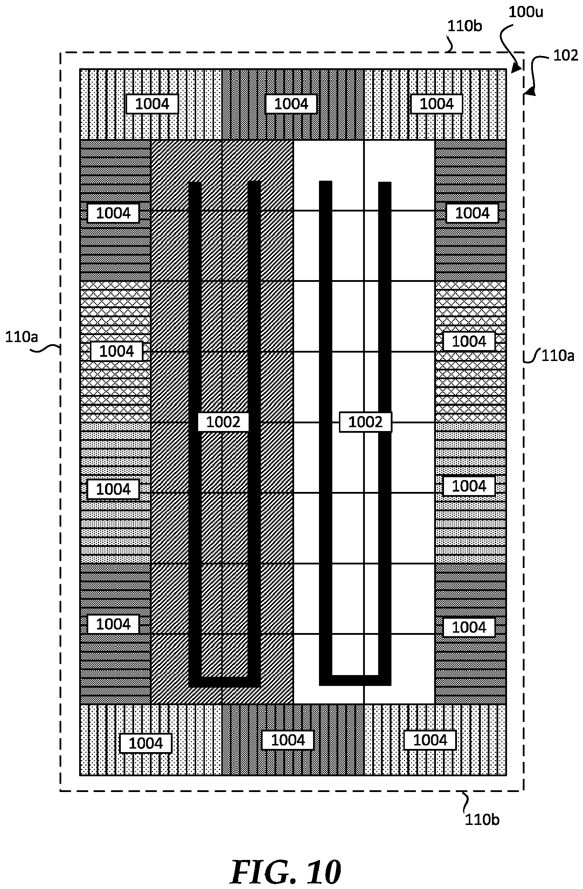

As described, mixed PV cell arrays 100 may include variously cut and arranged PV cells to effectuate mixed PV cell arrays 100 and mixed PV modules having mixed PV cell arrays 100 of different characteristics (e.g., power production, partial shade/mismatch tolerance, etc.). FIG. 10 depicts an example mixed PV cell array 100u according to one or more aspects of the present disclosure. Each substring of FIG. 10 may be depicted with or without patterns. Substring patterns of FIG. 10 may only serve to delineate between adjacent substrings (as described in relation to FIG. 1 above) unless explicitly described differently herein. Mixed PV cell array 100u may be substantially rectangular having two long edges 110a and two short edges 110b. As described, enhanced substrings and corresponding backsheet regions may be disposed around the perimeter of mixed PV cell array 100u and backsheet 102. Referring to FIG. 10, mixed PV cell array 100u may include two standard substrings 1002 including electrically serially connected, full standard PV cells. Mixed PV cell array 100u may further include a plurality of 1/8 cut enhanced substrings 1004 disposed around the entire perimeter of PV cell array 100u and surrounding standard substrings 1002. Each 1/8 cut enhanced substring 1004 may include electrically serially connected 1/8 cut enhanced PV cells. 1/8 cut enhanced PV cells may be rectangular with two short edges 1/8 the length of a full PV cell edge, and two 1/8 cut long edges being substantially similar in length to that of the length of a full PV cell edge. Each standard substring 1002 and each 1/8 cut enhanced substring 1004 may include the same number of PV cells. For example, referring to FIG 10., each substring (e.g., 1002 and 1004) may include 16 PV cells electrically serially connected to one another. Each standard substring 1002 may be disposed in PV cell array 100u and on backsheet 102 as two rows of eight standard PV cells each. Standard substrings may be disposed adjacent to one another resulting in four rows of standard PV cells of eight standard PV cells per row.

Still referring to FIG. 10, 1/8 cut enhanced substrings 1004 may be disposed around the perimeter of mixed PV cell array 100u. Each 1/8 cut enhanced substring 1004 may include the same number of 1/8 cut PV cells, which may be equal to the number of standard PV cells per standard substring 1002. Mixed PV cell array 100u may include three 1/8 cut enhanced substrings 1004 disposed parallel with and adjacent to each backsheet short edge 110b. 1/8 cut enhanced substrings disposed adjacent to Backsheet short edges 110b may be arranged such that the 1/8 cut short edges of each 1/8 cut PV cells therein are parallel with the backsheet short edges 110b. Additionally, mixed PV cell array 100u may include eight additional 1/8 cut enhanced substrings, four 1/8 cut enhanced substrings parallel with each Backsheet long edge 110a. Eight 1/8 cut enhanced PV cells together may be the same height as a single full enhanced or standard PV cell. Therefore, four 1/8 cut enhanced substrings 1004 having sixteen 1/8 cut enhanced PV cells each may extend the length of a row of standard substring 1002 having eight full standard PV cells. 1/8 cut enhanced substrings disposed adjacent to backsheet long edges 110a may be arranged such that the 1/8 cut short edges of each 1/8 cut PV cell therein may be parallel with the backsheet ling edges 110a.

In an alternative aspect, two 1/8 cut substrings 1004 may be disposed adjacent to and parallel with each backsheet short edge 110b. In such an aspect, the two 1/8 cut substrings 1004 may extend in length, the width of the standard substrings 1002. In such an aspect, five 1/8 cut enhanced substrings 1004 may be disposed adjacent to and parallel with each backsheet long edge 110a.

FIG. 10 depicts a mixed PV cell array 100u having two standard substrings 1002. Such PV cell arrays 100u may include more or less standard substrings 1002 (e.g., one, three, five, etc.). FIG. 10 depicts a mixed PV cell array 100u in which substrings include sixteen PV cells each. Substrings of such configurations may include any varying number of PV cells per substring (e.g., twenty, sixty, thirty-six, fifty-four, etc.). FIG. 10 depicts enhanced substrings of 1/8 cut enhanced PV cells. Enhanced substrings of such configurations may be practiced with full or any variously cut enhanced PV cells (e.g., ¼ cut enhanced PV cells, 1/16 cut enhanced PV cells, etc.). FIG. 10 depicts a mixed PV cell array 100u having fourteen cut enhanced substrings around the perimeter of the PV cell array 100u. Such configurations may be practiced with any number of substrings around the perimeter (e.g., twenty-eight 1/16 cut enhanced substrings).

Different enhanced substrings 1004 of FIG. 10 may be differently enhanced. For example, one or more 1/8 cut enhanced substring 1004 may include bifacial suited PV cells and a transparent backsheet. Whereas, one or more additional 1/8 cut enhanced substring 1004 may include monofacial and or bifacial suited PV cells and may be backed by a decreased transparency and reflective backsheet. Alternatively, all of the enhanced substrings of FIG. 10 may be similarly enhanced (e.g., all substrings may include bifacially suited PV cells backed by an increased transparency backsheet). The present disclosure is not limited to these combinations of substring enhancement, rather all combinations of enhancement are contemplated herein.

Standard substrings 1002 of FIG. 10 may be monofacial suited PV cells backed by a decreased transparency backsheet or an increased transparency backsheet. Alternatively, standard substrings 1002 of FIG. 10 may be bifacially suited PV cells backed by increased transparency backsheet. Two different standard substrings 1002 may include differently standardized substrings.

Arrangements herein may additionally or alternatively decrease manufacturing difficulty by utilizing conductive backsheets as described herein. Such arrangements may be achieved with rear contact PV cells (e.g., metal wrap through (MWT), interdigitated back contact (IBC), etc.) and conductive backsheets.

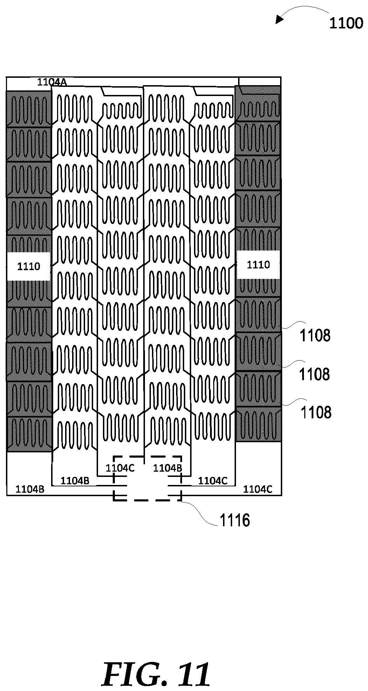

FIG. 11 depicts an example conductive backsheet 1100 of PV cell array 100a of FIG. 1 according to one or more aspects of the present disclosure. Conductive backsheet 1100 may be fabricated from any conductive material (e.g., copper, silver, etc.). Conductive backsheet 1100, may be cut (depicted as black lines in FIG. 11) via, for example, laser cutter, plasma cutter, etc., in particular patterns to form conductive regions (depicted as white spaces between cuts) as desired. Conductive regions may be categorized as conductive pads 1108 configured to electrically join adjacent rear contact PV cells 1102 (e.g., conductive pads 1108 configured to electrically serially connect two adjacent rear contact PV cells 1102) and conductive traces 1104 and configured to transmit electrical power (e.g., conductive traces 1104A, 1104B, 1104C, 1104D, etc.). The terms conductive pads 1108 and conductive traces 1104 are merely example terms of the more general conductive regions and should not be construed to limit the scope of the present disclosure. Conductive pads 1108 may terminate in conductive traces 1104 and conductive traces 1104 may terminate in conductive pads 1108. Additionally or alternatively, conductive regions may function as both conductive pads 1108 and conductive traces 1104 or function as neither. All PV cells of the present disclosure (e.g., PV cells of FIGS. 1 - 10) may be rear contact PV cells. Conductive backsheet 1100 may be cut forming regions that effectuate the mixed PV cell arrays of the present disclosure (e.g., PV cell arrays 100 of FIGS. 1 - 10). Rear contact PV cells 1102 may be electrically attached to conductive backsheet 1100 by, for example, conductive paste, forming a desired conductive backsheet mixed PV cell array 1000 as described herein. Such conductive backsheets 1100 may facilitate the integration of electronics (e.g., power electronics as discussed in further detail herein), with a conductive backsheet PV module by directly integrating circuitry and circuit paths with the conductive backsheet 1100.

Conductive backsheet 1100 may be of uniform thickness. Alternatively, conductive backsheet 1100 may be of nonuniform thickness. Advantages of a nonuniform thickness backsheet 1100 may be realized for conductive traces 1104 or pads 1108 requiring increased current carrying capabilities. For example, referring to FIG. 11, conductive trace 1104A may be routed from a first half of enhanced substring 1110 across the width of the array to the second half of enhanced substring 1110. Conductive trace 1104A may carry current produced by one half of enhanced substring 1110 across substantially the width of the PV cell array. Therefore, it may be advantageous for conductive trace 1104A (and other conductive traces 1104) to be of sufficient cross section to carry the produced current without creating excessive resistance. Further, conductive traces 1104 may be routed alongside, underneath (e.g., conductive trace 1104B), above (e.g., conductive trace 1104A), etc. substrings adding "dead space" to the conductive backsheet PV cell array 1100 where rear contact PV cells may not be disposed. Therefore, increasing the width of a conductive trace 1104 may increase the "dead space" and overall size of a conductive backsheet PV cell array, and decreasing the width of a conductive trace 1104 may cause increased resistance to current flow along the conductive trace 1104.

To relieve this conflict, conductive backsheet may be of nonuniform thickness. For example, conductive backsheet 1100 may be one thickness for conductive pads 1108 and areas backing rear contact PV cells and may be another thickness (e.g., thicker) for areas of longer conductive traces 1104. Conductive backsheet 1100 may have multiple different areas of multiple different thicknesses depending on the application. Nonuniform thickness conductive backsheets 1100 may be patterned from a nonuniform thickness stock conductive backsheet. Additionally or alternatively, layers of conductive material may be added to a uniform or otherwise nonuniform thickness conductive backsheet 1100. For example, conductive material may be deposited on the backside of conductive trace 1104A, thereby increasing the cross-sectional area of the conductive trace 1104A and resulting in a nonuniform thickness conductive backsheet 1100.

Conductive backsheet may comprise a printed circuit board (PCB) type design. PCB type conductive backsheets 1100 may comprise a single layer, or multiple layers, of conductive material disposed on a single layer, or multiple layers of a dielectric substrate (e.g., fiberglass, a prepreg, etc.). Conductive regions and circuits may be etched or otherwise patterned into the conductive layers. Additionally or alternatively, conductive regions may be deposited on a dielectric substrate (with e.g., chemical vapor deposition, atomic layer deposition, etc.). Multiple layers of conductive material may be used. For example, a two conductive layer PCB style conductive backsheet 1100 may have a top conductive layer, a middle dielectric layer and a bottom conductive layer. Conductive layers (e.g., top conductive layer and bottom conductive layer) may be electrically connected through for example via holes where desired. Such PCB type conductive backsheet 1100 design may minimize or substantially eliminate conducive pathway "dead space." For example, the top conductive layer may only contain the conductive regions (e.g., conductive pads 1108) functioning to serially connect the rear contact PV cells of each substring, but may not contain the conductive traces 1104 to interconnect the substrings. According to such examples of the present disclosure, substrings may be disposed substantially proximate to one another without "dead space" for the conductive traces 1104. The conductive traces 1104, to interconnect the substrings, may be disposed on the bottom conductive layer. The conductive regions (e.g., conductive pads 1108) at the terminal of each or some substrings may connect to conductive regions (e.g., conductive traces 1104) on the bottom conductive layer. The top conductive layer and bottom conductive layer may electrically connect to each other with, for example, via holes through the dielectric substrate. The top and/or bottom conductive layers may contain conductive regions to effectuate other electrical connections as necessary (e.g., integrating electronics as discussed herein). Utilizing such a PCB type conductive backsheet may allow for conductive traces 1104 of varied cross-sectional area and reduce or substantially eliminate conductive trace "dead space," by utilizing multiple layers of conductive material. PCB type conductive backsheets may contain 1, 2 or more layers of conductive material, each layer may be separated by a dielectric (e.g., fiberglass, a prepreg, etc.). Such PCB type conductive backsheets may facilitate the integration of electronics (e.g., power electronics as discussed in further detail herein), with a conductive backsheet PV module by directly integrating circuitry with the PCB type conductive backsheet.

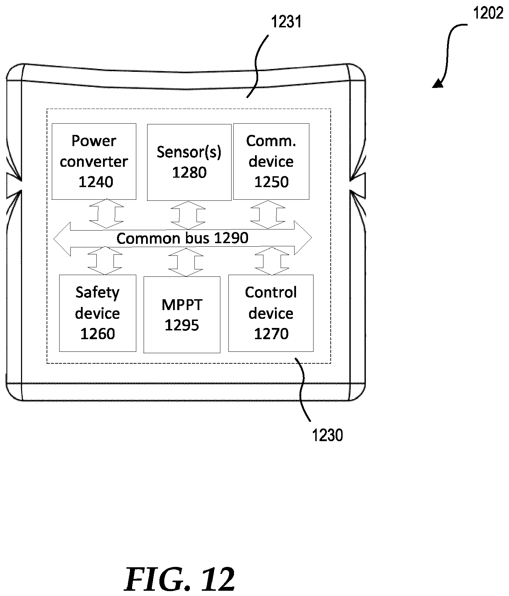

Conductive backsheet PV modules may include junction box 1116. Conductive traces 1104 are depicted routing into junction box 1116, however, the connections within junction box 1116 are not depicted. Therefore, conductive traces are just depicted to terminate in junction box 1116. In operation, connections of one or more conductive traces 11104 would be effectuated (not shown) in junction box 1116. Some or all substrings interconnections may be effectuated in junction box 1116. Alternatively, PE 1202, as shown in FIG. 12, may be added to PV cell array of conductive backsheet 1100 in junction box 1116. PV module leads may be disposed in junction box 1116 and may avail the power produced by the PV module of conductive backsheet PV cell array to be utilized as described herein (e.g., connected to additional PV modules, used at a load, sent to the grid, etc.). Conductive backsheet PV modules may include one or more junction boxes. A multi junction box conductive backsheet PV module may utilize the multiple junction boxes substantially similarly to that which is described in relation to junctions boxes 506a and 506b and other multi junction box PV modules herein.

Aspects of the present disclosure may relate to the manufacture and production of mixed PV cell arrays 100 and mixed PV modules. Backsheet 102 may be produced as described above and/or obtained. Substrings may be produced. Each PV cell may have leads of opposing polarities (e.g., positive and negative leads). Tabs, or conductor wire (e.g., ribbon wire) may be connected to the leads of one or both polarities. This may be done automatically by means of, for example, a tabbing machine or tabbing system. A machine may automatically pick a desired PV cell (e.g., full standard PV cell, ¼ cut enhanced PV cell, etc.) and place it to be tabbed. The machine may or may not pick the desired PV cell from numerous PV cell options. For example, an assortment of PV cells may be arranged. Such an assortment may include, for example, a stack of (or otherwise arranged) full standard PV cells, a stack of (or otherwise arranged) full enhanced PV cells, a stack of (or otherwise arranged) ½ cut enhanced PV cells, etc.). The machine may choose from the appropriate stack or arrangement as determined by the substring being produced. The machine (or a machine) may place the picked desired PV cell and place it such that it may be tabbed. The machine (or a machine) may lay conductor over the desired PV cell lead and solder, or otherwise electrically connect, the conductor to the PV cell lead defining a tabbed PV cell. This process may be repeated for the desired number of PV cells for a tabbed substring. The tabbed PV cells may be placed such that the tabs connected to the leads of a first polarity of a first PV cell may align with the leads of the opposing polarity of a second PV cell. The tabs may be soldered to the second PV cell creating a string of PV cells. This process may be repeated until the desired substring (or string) length is achieved.

Additionally or alternatively, the PV cells of the present disclosure may be shingled PV cells. Such PV cells may be overlaid to form the electrical connections. For example, the leads of one polarity of one PV cell may be overlaid over leads of the opposing polarity of an adjacent PV cell. The electrical connection between the adjacent PV cells may be accomplished with, for example, electrically conductive adhesive or paste. For such shingled PV cells, similar machines as the above may be utilized to form shingled substrings. For example, a machine may pick a desired first shingled PV cell from an appropriate stack or arrangement of shingled PV cells. A machine may place the shingled PV cell on a surface (e.g., backsheet 102) and apply a layer of electrically conductive adhesive to a topside shingled PV cell lead of a first polarity. The machine may then pick a second shingled PV cell (from the desired stack or arrangement) and place a backside lead of an opposing polarity of the second shingled PV cell on to the electrically conductive adhesive and topside shingled PV cell lead of the first shingled PV cell, thereby creating a string of two shingled PV cells. This process may be repeated until a desired length of shingled substring is reached.

The substrings (e.g., tabbed substrings, and/or shingled substrings) may be placed and positioned on backsheet 102 or other substrate in the desired position for the desired mixed PV cell array. This process may be repeated for all substrings in a mixed PV cell array. The electrical connections to complete the PV cell array may subsequently be completed. A frontside encapsulant and/or glass may be added on top of the mixed PV cell array. A PV module frame may be added. Post processing may be applied (e.g., in an oven, laminating machine, etc.). Additional steps may be practiced to complete a mixed PV module (e.g., adding PEs 1202, junction box, etc.). Additionally, some of the steps mentioned may be omitted. The steps mentioned above to produce a mixed PV module may be practiced in any order.

Further aspects of the present disclosure may relate to the manufacture and production of conductive backsheet mixed PV cell arrays 1000 and conductive backsheet mixed PV modules herein. An uncut, or otherwise unitary conductive backsheet 1100 may be obtained. The conductive backsheet 1100 may be cut (e.g., via laser cutter, plasma cutter, etc.) into patterns and conductive regions to effectuate the electrical interconnectivity and spatial arrangement of a desired conductive backsheet PV cell array 1000 and integrated electronics as described herein. Additionally or alternatively, the conductive backsheet 1100 may be etched (by, e.g., acidic etching solution) into patterns and conductive regions to effectuate the electrical interconnectivity and spatial arrangement of a desired conductive backsheet PV cell array 1000 and integrated electronics as described herein. Additionally or alternatively, conductive material may be deposited on a backsheet in patterns and conductive regions which may create the conductive backsheet 1100 that effects the electrical interconnectivity and spatial arrangement of a desired conductive backsheet PV cell array 1000 and integrated electronics as described herein. The above methods of creating a conductive backsheet 1100 are examples only and not intended to limit the scope of the present disclosure. Other methods of conductive backsheet 1100 production will be known to those of ordinary skill in the art and are contemplated herein.

Conductive backsheet 1100 may be placed on top of additional layers. For example, a conductive backsheet 1100 may be placed on top of an encapsulant (e.g., ethylene vinyl acetate (EVA)) sheet or other encapsulant. Additionally or alternatively, conductive backsheet 1100 may be placed on top of backsheet 102 to effectuate a conductive backsheet, mixed rear contact PV cell array. The conductive backsheet 1100 and encapsulant may be placed over or under a protective and/or electrically insulating backsheet (e.g., a double fluoropolymer backsheet, a single fluoropolymer backsheet, non-fluoropolymer backsheet (e.g., polyethylene terephthalate (PET) and ethylene vinyl acetate (EVA)), etc.). Backsheet 102 may be the same as the encapsulant. The PV cells may be placed on top of, and electrically connected to, the conductive backsheet 1100. For example, conductive adhesive may be placed on top of the conductive backsheet 1100 on the desired areas for rear contact PV cell 1102 electrical connection. The rear contact PV cells 1102 may be placed on the conductive adhesive on the conductive backsheet 1100. An insulating layer may be placed between the conductive adhesive and rear contact PV cells 1102. The rear contact PV cells may be placed and positioned as desired on the conductive backsheet 1100 by, for example, an automated manipulator, a pick and place machine, a person, etc. Power electronics (e.g., optimizer, micro-inverter, etc.) and/or passive electronics (e.g., bypass diodes, blocking diodes, etc.) may be added to the conductive backsheet 1100. A top encapsulant and/or glass may be added on top of the conductive backsheet PV cell array 1000. A PV module frame may be added. Post processing may be applied (e.g., in an oven, laminating machine, etc.). Additional steps may be practiced to complete a mixed PV module (e.g., adding one or more junction boxes, etc.). Additionally, some of the steps mentioned may be omitted. The steps mentioned above to produce a conductive backsheet mixed PV module may be practiced in any order.

PV modules of the present disclosure may have a single junction box (e.g., junction box 130, 302, 410, 506a, 506b, 1116) where electrical connections may be disposed and effected as described herein. Substring electrical interconnections as described herein, even where not depicted, may be effectuated in a junction box of a PV module. Further, PV modules may have a positive and a negative terminal or leads connected to the positive and negative busses respectively of the PV cell arrays 100. The leads may emerge from or be integrated with a junction box (e.g., first junction box 506a and/or second junction box 506b). PV modules may include two junction boxes (e.g., first junction box 506a and second junction box 506b). Substring interconnections may be made in either the first junction box and/or the second junction box. PV module leads may be integrated with either the first junction box and/or the second junction box. For example, the positive lead may connect to the positive bus of PV module in the first junction box and emerge from and/or be integrated with the first junction box; and the negative lead may connect to the negative bus of PV module in the second junction box and emerge from and/or be integrated with the second junction box. Either lead may be integrated with and/or emerge from either the first junction box or the second junction box. Alternatively, both leads may emerge from and/or be integrated with a single of the two junction boxes. Further, either of the two junction boxes may house and/or integrate power electronics (PEs) (e.g., PE 1202 as shown in FIG. 12) or other electronics as described in further detail herein.

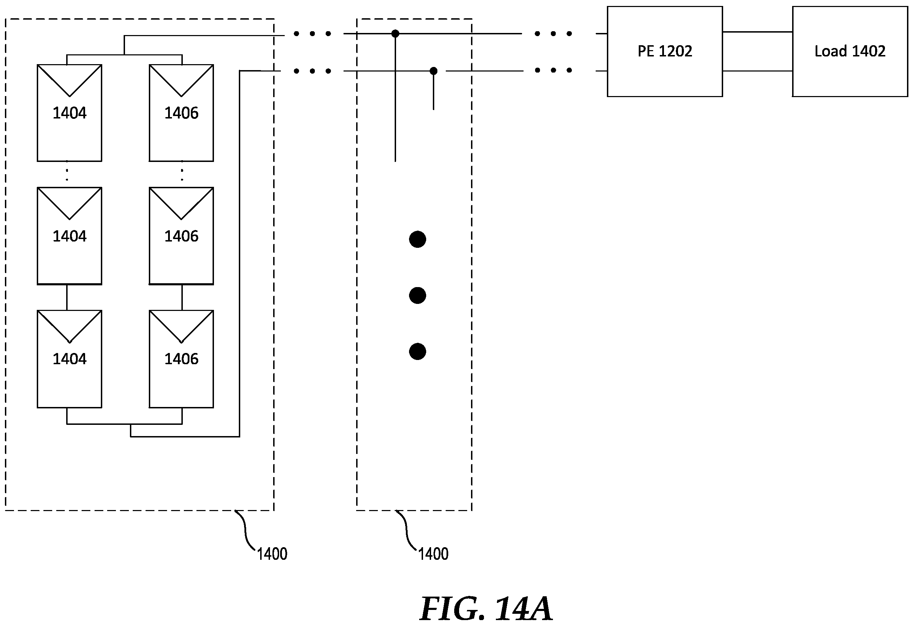

PV modules may only include one junction box (e.g., junction box 130, 302, 410, etc.). Even where not depicted, PV module may include one or more junction boxes. All or some substring interconnections may be effectuated in such junction boxes. PV module leads may be integrated with the one or more junction boxes. PV module leads may avail the power produced by the PV cell array 100 and PV module to be either electrically connected to additional PV modules in a PV module array, to be utilized (e.g., at load 1402 described in reference to FIG. 14A - 14B). PEs 1202 may be integrated with one or more junction boxes as described herein.

In addition to static reconfiguration of substrings as discussed herein, the substrings and PV modules may be variously actively optimized, utilized, converted, and/or inverted using power electronics (PEs) 1202. PEs 1202 may act at the substring level, the multi-substring level (e.g., PE acting on 2, 3, 4, etc. substrings), the PV module level, and/or the multi-PV module level (e.g., PE acting on 2, 3, 4, etc. PV modules). Reference is now made to FIG. 12, which depicts an example PE 1202 according to one or more aspects. PE 1202 may include a casing 1231. The casing 1231 may house circuitry 1230 (depicted functionally). Additionally or alternatively, the PE 1202 may be disposed directly on a conductive backsheet 1100 or PV module substrate. PE 1202 may be epoxy coated or otherwise encapsulated (e.g., utilizing a resin) on the conductive backsheet Additionally or alternatively, PE 1202 may be housed in a junction box. Additionally or alternatively, casing 1231 and junction box may be one and the same. PE 1202 may include power converter 1240. Power converter 1240 may include a direct current-direct current (DC/DC) converter such as a buck, boost, buck+boost, flyback, Cuk, and/or forward converter. Power converter 1240 may include a direct current - alternating current (DC/AC) converter (e.g., an inverter, or a micro-inverter designed to convert a smaller portion of power from DC to AC) instead of, or in addition to, a DC/DC converter. Positive and negative terminals of the PV generator may be electrically connected to input terminals of power converter 1240, and power converter 1240 may be configured to converter DC electrical power generated by the PV generator to a different form of electrical power, for example, to DC power at a different voltage or current level, or to AC power.

Circuitry 1230 may include Maximum Power Point Tracking (MPPT) circuit 1295, configured to extract increased power from the PV generator (e.g., PV cells, substrings, mixed PV cell arrays, mixed PV modules, mixed PV module arrays etc.) to which PE 1202 is coupled. MPPT circuit 1295 may track the characteristics of the power being produced by a PV generator, for example, the I-V curve (current-voltage curve), and adjust the load (impedance) presented to the PV generator to keep the power transfer at its substantially maximum power point (MPP). In some embodiments, power converter 1240 may include MPPT 1295, rendering a separate MPPT circuit 1295 unnecessary. Circuitry 1230 may further include control device 1270 such as a microprocessor, Digital Signal Processor (DSP) and/or a Field Programmable Gate Array (FPGA). Control device 1270 may control and/or communicate with other elements of circuitry 1230 over common bus 1290. Control device 1270 may control power converter 1240 to perform the functions of MPPT circuit 1295, by receiving voltage and/or current measurements at the input and/or output of the power converter 1240, and based on those measurements, control the power converter 1240 to adjust its input voltage or current, or adjust its output voltage or current such that power generated by the PV generator is increased. In some embodiments, circuitry 1230 may include circuitry and/or sensors/sensor interfaces 1280 configured to measure parameters directly or receive measured parameters from connected sensors on or near the PV generator, such as the voltage and/or current output by the module, the power output by the module, the irradiance received by the module and/or the temperature on or near the module. In some embodiments, circuitry 1230 may include communication device 1250, configured to transmit and/or receive data and/or commands to/from other devices. Communication device 1250 may communicate using, for example, Power Line Communication (PLC) technology, acoustic communications technologies, or wireless technologies such as BlueTooth™, ZigBee™, Wi-Fi™, cellular communication or other wireless methods.

Circuitry 1230 may include safety devices 1260 (e.g. fuses, circuit breakers and Residual Current Detectors, etc.). For example, fuses may be connected in series with some or all of conductors (e.g., in series with a power path from the terminals of the PV generator to the output of the junction box). As another example, PE 1202 may include a circuit breaker, with control device 1270 configured to activate the circuit breaker and disconnect PE 1202 from a PV string or a PV generator in response to detecting a potentially unsafe condition or upon receiving a command (e.g. via communication device 1250) from a system control device. As yet another example, PE 1202 may include a bypass circuit featuring a switch, with control device 1270 configured to activate the bypass circuit in response to detecting a potentially unsafe condition or upon receiving a command (e.g. via communication device 1250) from a system control device 1270. The bypass circuit, when activated, may short-circuit the input and/or output terminals of PE 1202 (e.g., connected to the positive and negative terminals of the PV generator). Additionally or alternatively, the bypass circuit may disconnect the input terminals from the output terminals of PE 1202.

PEs 1202 may also be utilized to mitigate adverse effects of mismatch or the partial shade conditions, such as "hot-spotting" as described herein. PEs 1202 may monitor the performance and power characteristics of a PV generator (e.g., PV cell, substring, mixed PV cell array, mixed PV module, mixed PV module array). The PEs 1202 may detect, based on the PV generator performance (e.g., I-V curve) and power characteristics, that a portion of the overall PV generator (e.g., a single PV cell in a PV module or a single PV cell in a substring) is being reversed biased and/or "hot-spotting" due to reduced irradiance from, for example, the partial shading condition. The PEs 1202 may then operate to mitigate the reverse bias or "hot-spotting." PEs 1202 may counteract such PV generator reverse bias in a number of ways. For example, the PEs 1202 may alter the amount of current being drawn from the overall PV generator (e.g., mixed PV module, substring) to match the current being produced by the reduced PV generator (e.g., the shaded PV cell). In that way, the reduced PV generator may no longer be reverse biased (or may be less reverse biased) and the negative effects such as "hot-spotting" may be mitigated. Additionally or alternatively, PEs 1202 may bypass the reduced PV generator (e.g., substring). PEs 1202 may be able to act on a more granular level. For example, PEs 1202 may be integrated with, or have control of a PV cell array on a substring level (as discussed in further detail below). In such examples, PEs 1202 acting on substring levels may or may not be integrated with additional PEs 1202 acting on a less granular level, for example on a PV module 100 level. In such examples, multiple PEs 1202 may be acting on the same system at different levels of granularity. Further in such examples, PEs 1202 may be able to detect on a substring level, based on power characteristics and performance, whether a portion of the substring is experiencing the mismatch condition and/or "hot-spotting" due to for example, reduced irradiance or partial shading. The PEs may then either move the portion to a safe operating point (for e.g., by reducing the current draw to match the reduced portion), or alternatively, bypass the reduced portion. In another aspect, PEs may utilize thermocouples to detect when a PV generator is "hot-spotting" and act on the PV generator accordingly, as described herein.

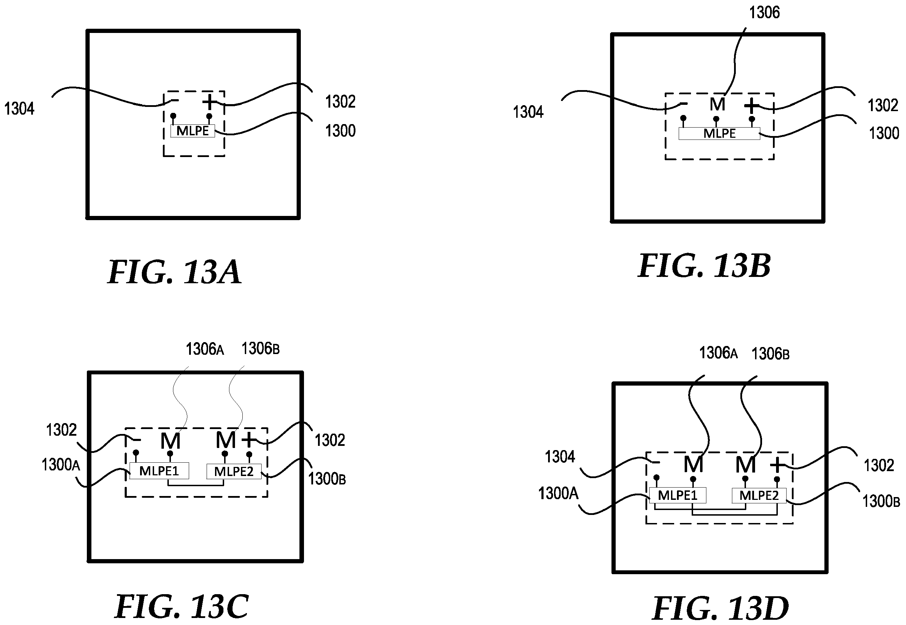

PEs may be utilized on a module level, where the power production of an entire PV module may be acted upon. After being acted upon, the power from a PV module may be joined with that of other PV modules electrically connected in any of various methods including for example in series, in parallel, in series-parallel, etc. If the direct current (DC) power has not yet been inverted at a more granular level (e.g., the substring level), the power may then be inverted to AC and utilized (e.g., at load 1402). Alternatively, the power may not be inverted and it may be utilized (e.g., at load 1402). FIGS. 13A - 13D depict various examples of module level power electronic (MI,PE) 1300 integration according to one or more aspects of the present disclosure. MI,PE 1300 may perform the same (or substantially the same) and include some or all of the same components as PE 1202 as described herein. For purposes of this disclosure MI,PE 1300 may be considered a type of PE 1202. MI,PE 1300 may include a casing (e.g., substantially similar to casing 1231). The casing may house PE 1202 components (e.g., power converter 1240, sensor(s)1280, communication device 1250, safety device 1260, components to effectuate MPPT 1295, control device 1270, etc.) as described in relation to FIG 12. MLPEs 1300 may be disposed in a junction box, on a module, on a PV cell substrate, on a conductive backsheet (e.g., conductive backsheet 1100), or may be connected to PV module leads and added to a PV module 100 that previously lacked MLPE 1300. Referring to FIG. 13A, MLPE 1300 may be electrically connected to a PV module positive terminal 1302 or lead and PV module negative terminal 1304 or lead. The MLPE 1300 may monitor, collect data, communicate the data, optimize, and/or invert the power, bypass substrings, etc. and avail the power with positive and negative terminals or leads. Referring to FIG. 13B, MI,PE 1300 may be electrically connected to PV module positive terminal 1302 or lead, PV module negative terminal 1304 or lead and substring midpoint terminal 1306. Substring midpoint terminal 1306 may be the terminal of the electric potential midpoint of some or all substring midpoints in the mixed PV cell array 100. Referring to FIGS. 13C-13D, configurations may utilize multiple MLPEs 1300, for example, MLPE1 1300A and MLPE2 1300B. The use of multiple MLPEs 1300 may allow for increased granularity in optimization, data tracking, communication, switching, monitoring, inverting, etc. For example, referring to FIG. 13C, two MLPEs 1300 may be utilized. Each of MLPE1 1300A and MLPE2 1300B may be connected to electric potential midpoints 1306A and 1306B respectively of subsets of the substrings. MLPE1 and MLPE2 may then operate on the PV module and power generated by the PV module 100 as described herein. MLPE1 1300A and MLPE2 1300B may be connected in series. Alternatively, and referring to FIG. 13D, MLPE1 1300A and MLPE2 1300B may be connected in parallel.

It may be advantageous to integrate PEs 1202 on a more or less granular level. For example, it may be advantageous to integrate PEs 1202 on a substring 101 level, a multi-substring level (e.g., 1, 2, 3, etc. substring acted on by a single PE), a PV module level, and/or a multi-PV module level (e.g., 1, 2, 3, etc. PV modules acted on by a single PE 1202). For example, in a commercial PV power station (e.g., solar park, solar farm, etc.) in an open area, partial shading may be less of a concern and cost savings may be more of a concern. In such examples PEs may be utilized on a less granular level, for example, one PE 1202 for every 3, 4, 5, etc. PV modules. In such examples, the PEs may operate substantially as described above (e.g., monitoring, optimizing, mitigating mismatch, mitigating "hot-spotting," inverting, communicating etc.) but on a less granular level. Additionally or alternatively, "central" PEs 1202 (e.g., one PE 1202 for every 3, 4, 5, etc. PV modules) may be able to optimize, control, communicate on a more granular level. For example, a "central" PE 1202 (e.g., connected to four PV modules), may still be able optimize each of the four modules separately. Such a scheme may be effectuated by, for example, smart switching by the PE 1202 between the PV modules. Additionally or alternatively, it may be advantageous to mix levels of granularity. For example, it may be advantageous to have some control with a PE 1202 at the substring level and have additional control with an additional PE 1202 at the PV module level.

FIG. 14A depicts an example mixed PV module 1400 and example mixed PV cell array circuit with PE 1202 integration on the PV module, or multi-module level. As described herein, a PV module 1400 may contain a mixed PV cell array 100 of multiple electrically parallel connected standard substrings 1404 and enhanced substrings 1406. Mixed PV modules 1400 may then be connected to PE 1202, and PE 1202 may act upon, track, optimize, convert, invert, communicate with/to, etc. the mixed PV module 1400. Additionally or alternatively, mixed PV module 1400 may be connected to other mixed PV modules 1400 in one of various methods of electrical connection, for example, series, parallel, series-parallel, etc. The multi-module arrangement may then be connected to PE 1202 as described herein and PE 1202 may act upon, track, optimize, convert, invert, communicate with/to, etc. multi-module arrangement. PE 1202 may be connected to the mixed PV module 1400 or multi-module arrangement in one of various methods of electrical connection including, for example, in series, parallel, etc. A PE 1202 connected to a multi-module arrangement may control each mixed PV module 1400 in the arrangement separately, and/or the entire arrangement together. PE 1202 attached on the module or multi-module level may be able to act on a more granular level, for example, on each individual substring 1404 or 1406. For example, each substring 1404 and 1406 may be electrically connected to a single PE 1202 in a junction box disposed on the PV module. PE 1202 may then be able to act on each substring by either smart switching between substrings to act on each substring discretely. For example, if PE 1202 detects a decrease in production from mixed PV module 1400, it may be able to discretely switch through the substrings 1404 and 1406 to determine the mismatched and/or reduced substring. The PE 1202 may then act to mitigate the mismatch by, for example, bypassing the reduced substring or moving the substring to a safe operating point (by, for example, only drawing the amount of current such that the reverse bias of the reduced PV generator (e.g., PV cell, substring) is mitigated or substantially eliminated. Additionally or alternatively, in such an aspect, PE 1202 may be able to accommodate and/or process all substrings 1404 and 1406 at substantially the same time. PE 1202 may then periodically check the bypassed or reduced substring to determine whether its maximum operating point has changed. PE 1202 may avail the power from the PV generator to load 1402. Load 1402 may include, for example, the grid, an appliance, a battery, etc.

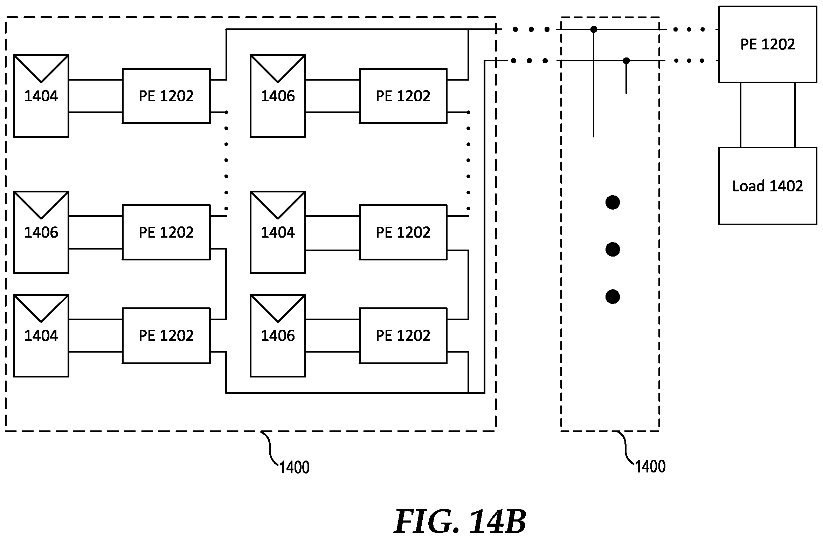

As described herein, in some instances, it may be advantageous to integrate PEs 1202 on a more granular level, for example, the substring or multi-substring level. FIG. 14B depicts an example mixed PV module 1400 and example mixed PV cell array circuit with PE 1202 integration on the standard substring 1404 and enhanced substring 1406 level and mixed PV module 1400 or multi-PV module level. Referring to FIG. 14B, each substring may have a dedicated PE 1202. For example, a mixed PV module 1400 may have six substrings electrically connected in parallel. Each substring 1404 and 1406 in a mixed PV cell array 100 or mixed PV module 1400 may have a dedicated PE 1202. The PE 1202 may act directly on the substring substantially as described in relation to PEs 1202 herein (e.g., MPPT, control, communication, DC/DC conversion, inversion, etc.). For example, if a PV cell in a substring (e.g., enhanced substring 1406) is shaded and is "hot spotting," PE 1202 acting on the particular substring may only draw current to match that which is produced by the shaded PV cell. Mixed PV modules 1400 with substring level PEs 1202 may then be connected to additional PV modules in one of various methods of electrical connection, for example, series, parallel, series-parallel, etc. The multi-module arrangement may then be connected to PE 1202 as described herein; and PE 1202 may act upon, track, optimize, convert, invert, communicate with/to, etc. multi-module arrangement. A PE 1202 connected to a multi-module arrangement may control each mixed PV module 1400 in the arrangement separately, and/or the entire arrangement together. PE 1202 may avail the power from the PV generator to load 1402. Load 1402 may include, for example, the grid, an appliance, a battery, etc. Additionally or alternatively, mixed PV module 1400 may be connected to an additional PE 1202 before being connected to additional PV modules. PE 1202 may act on the mixed PV module 1400 substantially as described in relation to PE 1202 herein (e.g., MPPT, control, communication, DC/DC conversion, inversion, etc.). Such a PE 1202 integrated on the mixed PV module 1400 level may operate on the entire module (e.g., the power of all the substrings) or on a more granular level (e.g., on the substrings). For example, PE 1202 directly connected to standard substring 1404, may effectuate MPPT on standard substring 1404. PE 1202 connected to mixed PV module 1400 may then additionally effectuate MPPT on the PV module level, invert the power of the module, DC/DC convert the power, communicate data, invert the power, etc. Power may then be made available to a load 1402 (e.g., the grid, an appliance, a battery, etc.) either directly from the PV module or from the PE 1202 connected to the mixed PV module 1400. Additionally or alternatively, it may be advantageous to further process, and/or utilize the power before making it available to load 1402.

All standard substrings described herein (e.g., standard substrings 116a and 116b of FIGS. 1, 3A - 3B, 4; standard substrings 504a and 504b of FIGS. 5A - 5D; standard substring 602 of FIGS. 6A - 6E; standard substring 702 of FIG. 7; standard substring 812 of FIGS. 8A - 8E; and standard substring 910 of FIG. 9) may include substantially similar standard PV cells and may be substantially similar to each other in all respects unless explicitly described herein. All Enhanced substrings described herein (e.g., enhanced substring 108 of FIG. 1; enhanced substrings 108a and 108b of FIGS. 3A - 3B; enhanced substrings 502a and 502b of FIGS. 5A - 5E; and enhanced substrings 604a and 604b of FIGS. 6A - 6B) may include substantially similar enhanced PV cells and may be substantially similar to each other in all respects unless explicitly described herein. All ½ cut enhanced substrings described herein (e.g., ½ cut enhanced substrings 406a and 406b of FIG. 4; ½ cut enhanced substring 704 of FIG. 7) may include substantially similar ½ cut enhanced PV cells and may be substantially similar to each other in all respects unless explicitly described herein. All 1/4 cut enhanced substrings described herein (e.g., 1/4 cut enhanced substrings 614a and 614b of FIG. 6D - 6E; and 1/4 cut enhanced substring 904 of FIG. 9) may include substantially similar 1/4 cut enhanced PV cells and may be substantially similar to each other in all respects unless explicitly described herein. All 1/8 cut enhanced substrings described herein (e.g., 1/8 cut enhanced substrings 706 of FIG. 7; and 1/8 cut enhanced substrings 814 of FIGS. 8A - 8E) may include substantially similar 1/8 cut enhanced PV cells and may be substantially similar to each other in all respects unless explicitly described herein. Additionally, all standard PV cells (including full standard PV cells, ½ cut standard PV cells and all other X/N cut standard PV cells (where X and N are integers) may be substantially similar to each other in all respects unless explicitly described herein. Additionally, all enhanced PV cells (including full enhanced PV cells, ½ cut enhanced PV cells and all other X/N cut enhanced PV cells (where X and N are integers) may be substantially similar to each other in all respects unless explicitly described herein.

The configurations and figures of the present disclosure have been described and depicted in terms of mixed PV cell arrays (having standard and enhanced PV cells) and backsheets (having multiple regions of varying transparency). The PV cell and substring arrangements of the present disclosure may be practiced with standard PV cells only or enhanced PV cells only, and uniform backsheets.

Mixed PV cell arrays of FIGS. 1-10 may be practiced with various X/N cut standard PV cells, and X/N cut enhanced PV cells (where X and N are integers) such that configurations as otherwise described are maintained.

Mixed PV cell arrays 100 of the present disclosure may be practiced with or without backsheets 102, and backsheets 102 of the present disclosure may be practiced with or without mixed PV cell arrays. Neither mixed PV cell arrays 100 nor backsheets 102 should be understood to limit one another unless explicitly specified by the claims.

Discussion and description of backsheets 102 herein may be considered to describe uniform backsheets 102 (as described above) and mixed backsheet 210 unless explicitly stated or described otherwise.

Standard substrings of the present disclosure may include monofacial suited PV cells and/or bifacial suited PV cells. Standard PV cells and standard substrings of the present disclosure may be backed by a decreased transparency backsheet or an increased transparency backsheet. Enhanced PV cells and enhanced substrings of the present disclosure may include monofacial suited and/or bifacial suited PV cells. Enhanced PV cells and enhanced substrings of the present disclosure may be backed by areas of decreased transparency and reflective backsheet, or areas of increased transparency backsheet.

In the context of photovoltaic devices and systems, as described herein, it will be understood that where reference is made to material properties of components in relation to their interactions with light, e.g. transparency, opaqueness, reflectivity, absorption, et cetera, this may indicate the material property in relation to an interaction with solar radiation, e.g. interaction with light in a solar spectrum received from the sun (on earth and/or space), and especially a part of the solar spectrum that is used by the specific photovoltaic device or system. For example, the bandgap of a solar panel is usually in a wavelength range between 400 nm and 1100 nm, or a different wavelength range dependent on the specific device or system used. For example, where it is stated that a component is transparent, this may indicate that a certain percentage of light in said wavelength range, e.g. more than 50%, preferably more than 90%, passes the component. Similarly, for an opaque component, the percentage of light in said wavelength range passing the component may be less than 50%, preferably less than 10%, most preferably less than 1%. Similarly, for a reflective component, the percentage of light in said wavelength range reflected off the component may be more than 50%, preferably more than 90%. Similarly, for a non-

reflective component, the percentage of light in said wavelength range reflected off the component may be less than 50%, preferably less than 10%, most preferably less than 1%. Similarly, for an absorbing component, the percentage of light in said wavelength range absorbed by the component may be more than 50%, preferably more than 90%. Further, where light related material properties of two components are compared, it will be understood that the comparison may hold in particular for said wavelength range. For example, where it is stated that a degree of transparency or reflectivity of a first component is higher than that of a second component, this may indicate that a percentage of light in said wavelength range passing, or reflected by, the first component is higher than passing, or reflected by, the second component, e.g. higher by at least 10%, at least 50%, at least a factor two, three, or more. This may apply mutatis mutandis for other comparisons of light related properties, e.g. of opaqueness, absorption, et cetera. For example, these properties may be measured with normal incident light.

Several alternative examples have been described and depicted herein. A person of ordinary skill in the art would appreciate the features of the individual examples and/or configurations, and the possible combinations and variations of the components. A person of ordinary skill in the art would further appreciate that any of the example configurations maybe provided in any combination with the other example configurations disclosed herein. The present examples, therefore, are to be considered in all aspects as examples and not restrictive, and the invention is not to be limited to the details given herein. Terms such as "top," "bottom," "left, "right," "front," back," "outward," "inward," "leftmost," "rightmost," "upward," "downward," and the like, as used herein, are relative terms intended for purposes of example only and do not limit the scope of the disclosure. Additionally, terms such as "rows" should not be limited to the horizontal orientation only but may be understood to include the vertical orientation (for example, where example orientations and/or configurations are rotated). Similarly, terms such as "columns" should not be limited to the vertical orientation only but may be understood to include the horizontal orientation (for example, where orientations and/or configurations are rotated). Nothing in this specification should be construed as requiring specific three-dimensional orientation of structures in order to fall within the scope of the disclosure, unless explicitly specified by the claims. Additionally, the term "plurality" as used herein, indicates any number greater than one, either disjunctively or conjunctively, as necessary, up to an infinite number. Accordingly, while the specific examples have been depicted and described, numerous modifications come to mind without significantly departing from the spirit of the disclosure and the scope of protection is only limited by the scope of the accompanying claims.

Here follows a list of clauses highlighting various aspects of the disclosure.

Clause 1: A photovoltaic module comprising:

a first plurality of photovoltaic cells arranged in one or more first substrings; and
a second plurality of photovoltaic cells arranged in one or more second substrings,
wherein the first plurality of photovoltaic cells and second plurality of photovoltaic cells comprise differently sized photovoltaic cells.

Clause 2: A photovoltaic module comprising:

a first plurality of photovoltaic cells arranged in one or more first substrings; and
a second plurality of photovoltaic cells arranged in one or more second substrings,

wherein the first plurality of photovoltaic cells are configured to receive a first irradiance and the second plurality of photovoltaic cells are configured to receive a second irradiance,
wherein the first irradiance level is greater than the second irradiance level.

Clause 3: The photovoltaic module of any preceding clause, e.g. clause 2, wherein at least one of the one or more first substrings is electrically connected in parallel to at least one of the one or more second substrings.

Clause 3a: The photovoltaic module of any preceding clause, wherein the number of cells in the first plurality of photovoltaic cells is equal to the number of cells in the second plurality of photovoltaic cells.

Clause 3b: The photovoltaic module of any preceding clause, wherein an open circuit voltage of the first substring is about the same as an open circuit voltage of the second substring.

Clause 4: The photovoltaic module of any preceding clause, e.g. clause 2, further comprising:
a backsheet,
wherein one or more first portions of the backsheet have a first degree of transparency and one or more second portions of the backsheet have a second degree of transparency that is less than the first degree of transparency.

Clause 5: The photovoltaic module of any preceding clause, e.g. clause 4, wherein the first one or more substrings are disposed above the one or more first portions of the backsheet, and the second one or more substrings are disposed above the one or more second portions of the backsheet.

Clause 6: The photovoltaic module of any preceding clause, e.g. clause 2, wherein the first plurality of photovoltaic cells and the second plurality of photovoltaic cells each comprise:

a frontside face; and
a backside face,
wherein the first plurality of photovoltaic cells are configured to be irradiated on the frontside face and the backside face of the first plurality of photovoltaic cells, and the second plurality of photovoltaic cells are configured to be irradiated on the frontside face of the second plurality of photovoltaic cells.

Clause 7: The photovoltaic module of any preceding clause, e.g. clause 2, further comprising:
a backsheet,
wherein one or more first portions of the backsheet have a first degree of reflectivity and one or more second portions of the backsheet have a second degree of reflectivity that is less than the first degree of reflectivity.

Clause 8: The photovoltaic module of any preceding clause, e.g. clause 7, wherein the first one or more substrings are disposed above the one or more first portions of the backsheet, and the second one or more substrings are disposed above the one or more second portions of the backsheet.

Clause 9: A photovoltaic module comprising:

a first plurality of photovoltaic cells arranged in one or more first substrings,
wherein each of the first plurality of photovoltaic cells has a first frontside face and a second backside face; and
a second plurality of photovoltaic cells arranged in one or more second substrings,

wherein each of the second plurality of photovoltaic cells has a first frontside face and a second backside face,
wherein the first plurality of photovoltaic cells are configured to be irradiated on the first frontside face and the second backside face of each of the first plurality of photovoltaic cells, and the second plurality of photovoltaic cells are configured to be irradiated on the first frontside face of each of the second plurality of photovoltaic cells.

Clause 10: A photovoltaic module comprising:
a backsheet,

wherein one or more first portions of the backsheet have a first degree of transparency and one or more second portions of the backsheet have a second degree of transparency that is greater than the first degree of transparency;
a first plurality of photovoltaic cells arranged in at least one first substring portion of electrically serially connected photovoltaic cells along the one or more first portions of the backsheet; and
a second plurality of photovoltaic cells arranged in at least one second substring portion of electrically serially connected photovoltaic cells along the one or more second portion of the backsheet.

Clause 11: The photovoltaic module of any preceding clause, e.g. clause 10, wherein at least one of the first substring portions is electrically connected in parallel to at least one of the second substring portions.

Clause 12: The photovoltaic module of any preceding clause, e.g. clause 10, wherein each photovoltaic cell of the second plurality of photovoltaic cells has a current collection device on a frontside face of the photovoltaic cells and a current collection device on a backside face of the photovoltaic cells.

Clause 13: The photovoltaic module of any preceding clause, e.g. clause 10, further comprising:
a conductive backsheet fabricated to form a plurality of conductive regions and disposed on at least a portion of the one or more first or second portions of the backsheet,
wherein at least one of the one or more first or second substrings are disposed on the conductive backsheet.

Clause 14: The photovoltaic module of any preceding clause, e.g. clause 10, further comprising:

a conductive backsheet fabricated to form a plurality of conductive regions disposed on at least a portion of the one or more first portions of the backsheet,
wherein at least one of the one or more first substrings are disposed on the conductive backsheet.

Clause 15: The photovoltaic module of any preceding clause, e.g. clause 10, wherein each photovoltaic cell of the first plurality of photovoltaic cells is of a substantially square shape, having a square edge length, and
wherein each photovoltaic cell of the second plurality of photovoltaic cells are of a substantially rectangular shape, wherein two long rectangular edges have a length substantially equal to the square edge length, and two short rectangular edges having a length substantially equal to 1/N of the square edge length, wherein N is an integer.

Clause 16: The photovoltaic module of any preceding clause, e.g. clause 10, wherein each photovoltaic cell of the first plurality of photovoltaic cells have a surface area S, and
wherein each photovoltaic cell of the second plurality of photovoltaic cells have a surface area substantially equal to 1/N of S, wherein N is an integer.

Clause 17: The photovoltaic module of any preceding clause, e.g. clause 10, wherein the at least one first substring portion defines at least one inner substring portion, and the at least one second substring portion defines at least one outer substring portion,

wherein the at least one outer substring portion comprises at least two outer substring portions, and
wherein the at least two outer substring portions are disposed along opposite edges of the backsheet.

Clause 18: The photovoltaic module of clause, 17 wherein the at least two outer substring portions are electrically connected to each other in series defining at least one outer substring.

Clause 19: The photovoltaic module of any preceding clause, e.g. clause 18, wherein at least one of the outer substrings is electrically connected in parallel to at least one of the inner substring portions.

Clause 20: The photovoltaic module of any preceding clause, e.g. clause 17, wherein the at least two outer substring portions are electrically connected in parallel to each other and to at least one of the at least one inner substring portions.

Clause 21: The photovoltaic module of any preceding clause, e.g. clause 17, wherein each photovoltaic cell of the at least one outer substring portion comprises a shingled photovoltaic cell.

Clause 22: The photovoltaic module of any preceding clause, e.g. clause 10, wherein each of the at least one first substring portions further comprise:

a first substring terminal; and
a second substring terminal,
wherein each of the at least one second substring portions further comprise:
a third substring terminal; and
a fourth substring terminal,
wherein an open-circuit voltage across the first and second substring terminals is greater than the open-circuit voltage across the third and fourth substring terminals.

Clause 23: The photovoltaic module of any preceding clause, e.g. clause 22, further comprising:

a first connector coupled to the third substring terminal; and
a second connector coupled to the fourth substring terminal,
wherein the first and second connectors are configured to be mechanically complementary to each other.

Clause 24: The photovoltaic module of any preceding clause, e.g. clause 10, wherein each of the at least one second substrings comprises a fraction of the number of photovoltaic cells of each of the at least one first substrings

Clause 25: The photovoltaic module of any preceding clause, e.g. clause 10, wherein the at least one second substring defines at least one outer substring and the at least one first substring defines at least one inner substring,
wherein the at least one outer substring comprises:

a first outer substring portion; and
a second outer substring portion,
wherein the first and second outer substring portions are electrically connected to each other in parallel

Clause 26: The photovoltaic module of any preceding clause, e.g. clause 10, wherein the at least one first substring portion defines at least one inner substring portion, and the at least one second substring portion defines at least one outer substring portion,

wherein the at least one outer substring portion comprises at least two outer substring portions, and
wherein at least two outer substring portions are electrically connected to each other in parallel defining at least one outer substring array.

Clause 27: The photovoltaic module of any preceding clause, e.g. clause 26, wherein each of the at least one inner substring portions comprises:

a first substring terminal; and
a second substring terminal,
wherein each of the at least one outer substring array comprises:
a third substring terminal; and
a fourth substring terminal,
wherein an open-circuit voltage across the first and second substring terminals is greater than the open-circuit voltage across the third and fourth substring terminals.

Clause 28: A photovoltaic module comprising:

a first plurality of photovoltaic cells arranged in one or more first substrings disposed along an inner portion of the photovoltaic modules,

a second plurality of photovoltaic cells arranged in one or more second substrings disposed along an outer portion of the photovoltaic modules,

wherein the one or more second substrings are electrically connected in parallel to the one or more first substrings, and where the one or more first substrings are disposed in two rows and substantially U shaped and the one or more second substrings are disposed in single rows and substantially I shaped.

Clause 29: The photovoltaic module of any preceding clause, e.g. clause 28, wherein the second plurality of photovoltaic cells are arranged in a single substring having a first portion and a second portion, wherein the first portion is disposed along a first edge of the photovoltaic module, and the second portion is disposed along a second edge of the photovoltaic module that is opposite the first edge of the photovoltaic module, the first and second portions being electrically connected in series.

Clause 30: The photovoltaic module of any preceding clause, e.g. clause 28, wherein the second plurality of photovoltaic cells are arranged in two substrings, wherein a first substring is disposed along a first edge of the photovoltaic module, and a second substring is disposed along a second edge of the photovoltaic module that is opposite the first edge of the photovoltaic module, the first and second portions being electrically connected in parallel.

Clause 31: The photovoltaic module of any preceding clause, e.g. clause 30, wherein each of the second plurality of photovoltaic cells are smaller than each of the first plurality of photovoltaic cell.

Clause 32: A photovoltaic module comprising:
a photovoltaic cell array comprising:

one or more first substrings configured to produce a first power level under operating conditions, each of the one or more first substrings comprising a first plurality of serially connected photovoltaic cells; and
one or more second substrings configured to produce a second power level different from the first power level under the operating conditions, each of the one or more second substrings comprising a second plurality of serially connected photovoltaic cells.

Clause 33: The photovoltaic module of any preceding clause, e.g. clause 32, wherein at least one of the one or more first substrings is electrically connected in parallel to at least one of the one or more second substrings.

Clause 33a: The photovoltaic module of any preceding clause, e.g. clause 32, wherein at least one of the one or more first substrings comprises a number of serially connected photovoltaic cells, equal to a number of serially connected photovoltaic cells of at least one of the one or more second substrings.

Clause 34: The photovoltaic module of any preceding clause, e.g. clause 32, further comprising:

a backsheet,
wherein one or more first portions of the backsheet have a first degree of transparency and one or more second portions of the backsheet have a second degree of transparency that is less than the first degree of transparency, and wherein the one or more first substrings are disposed above the one or more first portions of the backsheet, and the one or more second substrings are disposed above the one or more second portions of the backsheet.

Clause 35: The photovoltaic module of any preceding clause, e.g. clause 32, further comprising:

a backsheet,
wherein one or more first portions of the backsheet have a first degree of reflectivity and one or more second portions of the backsheet have a second degree of reflectivity that is less than the first degree of reflectivity, and wherein the one or more first substrings are disposed above the one or more first portions of the backsheet, and the one or more second substrings are disposed above the one or more second portions of the backsheet.

Clause 36: The photovoltaic module of any preceding clause, e.g. clause 32, wherein each of the first plurality of photovoltaic cells has a current collection device on a frontside face and a current collection device on a backside face.

Clause 37: The photovoltaic module of any preceding clause, e.g. clause 32, further comprising:
a conductive backsheet comprising a plurality of conductive regions configured to electrically serially connect at least a portion of the second plurality of photovoltaic cells.

Clause 38: The photovoltaic module of any preceding clause, e.g. clause 32, wherein each of the second plurality of photovoltaic cells has a substantially square shape comprising four sides, each of the four sides having a substantially same square side length, and
wherein each of the first plurality of photovoltaic cells has a substantially rectangular shape comprising two long sides and two short sides, wherein each of the two long sides has a length substantially the same as the square side length, and each of the two short sides has a length substantially equal to 1/N of the square side length, wherein N is an integer greater than one.

Clause 39: The photovoltaic module of any preceding clause, e.g. clause 32, wherein each of the second plurality of photovoltaic cells has a surface area, S, and
wherein each of the first plurality of photovoltaic cells has a surface area substantially equal to 1/N of S, wherein N is an integer greater than one.

Clause 40: The photovoltaic module of any preceding clause, e.g. clause 32, wherein the one or more first substrings comprise at least two first substring portions, each first substring portion disposed along opposing photovoltaic cell array sides, and wherein the one or more second substrings are disposed between the two first substring portions.

Clause 41: The photovoltaic module of any preceding clause, e.g. clause 40, wherein each of the first substrings portions is electrically serially connected to each other.

Clause 42: The photovoltaic module of any preceding clause, e.g. clause 40, wherein each of the first substring portions is electrically connected in parallel to each other defining a first substring group.

Clause 43: The photovoltaic module of any preceding clause, e.g. clause 42, wherein the one or more second substrings further comprise:

a first substring terminal; and
a second substring terminal,
and wherein the first substring group further comprises:
a third substring terminal; and
a fourth substring terminal,
wherein an open-circuit voltage across the first and second substring terminals is greater than an open-circuit voltage across the third and fourth substring terminals.

Clause 44: The photovoltaic module of any preceding clause, e.g. clause 32, wherein each of the one or more first substrings comprises a lesser quantity of photovoltaic cells than each of the one or more second substrings.

Clause 45: A photovoltaic module comprising:
a photovoltaic cell array comprising:

a first plurality of photovoltaic cells arranged in one or more first substrings; and
a second plurality of photovoltaic cells arranged in one or more second substrings,
wherein the first plurality of photovoltaic cells and second plurality of photovoltaic cells comprise differently sized photovoltaic cells.

Clause 46: The photovoltaic module of any preceding clause, e.g. clause 45, wherein the one or more first substrings are electrically connected in parallel to the one or more second substrings.

Clause 47: The photovoltaic module of any preceding clause, e.g. clause 45, wherein the photovoltaic cell array further comprises a third plurality of photovoltaic cells arranged in one or more third substrings,
wherein the third plurality of photovoltaic cells comprise differently sized photovoltaic cells from the first and second plurality of photovoltaic cells.

Clause 48: A photovoltaic module comprising:

a first plurality of photovoltaic cells arranged in one or more first substrings disposed along an inner portion of the photovoltaic modules,
a second plurality of photovoltaic cells arranged in one or more second substrings disposed along an outer portion of the photovoltaic modules,
wherein the one or more second substrings are electrically connected in parallel to the one or more first substrings, and where the one or more first substrings are disposed in two rows and substantially U shaped and the one or more second substrings are disposed in single rows and substantially I shaped.

Clause 49: The photovoltaic module of any preceding clause, e.g. clause 48, wherein the second plurality of photovoltaic cells are arranged in a single substring having a first portion and a second portion, wherein the first portion is disposed along a first edge of the photovoltaic module, and the second portion is disposed along a second edge of the photovoltaic module that is opposite the first edge of the photovoltaic module, the first portion and second portion being electrically connected in series.

Clause 50: The photovoltaic module of any preceding clause, e.g. clause 48, wherein the second plurality of photovoltaic cells are arranged in two substrings, wherein a first substring is disposed along a first edge of the photovoltaic module, and a second substring is disposed along a second edge of the photovoltaic module that is opposite the first edge of the photovoltaic module, the first portion and second portion being electrically connected in parallel.

Clause 51: The photovoltaic module of any preceding clause, e.g. clause 48, wherein each of the second plurality of photovoltaic cells is smaller than each of the first plurality of photovoltaic cell.

Clause 52: A configuration of mixed photovoltaic cell arrays and mixed photovoltaic modules, e.g. comprising one or more of the photovoltaic module according to any of the preceding clauses.

Clause 53: The configuration or according to clause 52, or photovoltaic module according to any preceding clause, having substrings of monofacial photovoltaic cells and bifacial photovoltaic cells.

Clause 54: The configuration according to clause 52, or photovoltaic module according to any preceding clause, having substrings of differently sized and/or cut photovoltaic cells.

Clause 55: The configuration or photovoltaic module according to any preceding clause, wherein substrings of electrically serially connected photovoltaic cells are connected to one another in parallel and/or series-parallel.

Clause 55: The configuration or photovoltaic module according to any preceding clause, wherein mixed photovoltaic cell arrays are disposed upon mixed photovoltaic module backsheets having various regions of varying levels of transparency.

Clause 56: Use of the configuration or photovoltaic module according to any preceding clause.

**Claims**

1. A photovoltaic module comprising:
a photovoltaic cell array comprising:

   one or more first substrings configured to produce a first power level under operating conditions, each of the one or more first substrings comprising a first plurality photovoltaic cells; and
   one or more second substrings configured to produce a second power level different from the first power level under the operating conditions, each of the one or more second substrings comprising a second plurality of serially connected photovoltaic cells.

2. The photovoltaic module of claim 1, wherein the first plurality of photovoltaic cells is serially connected and/or the second plurality of photovoltaic cells is serially connected.

3. The photovoltaic module of claim 1 or 2, wherein at least one of the one or more first substrings is electrically connected in parallel to at least one of the one or more second substrings.

4. The photovoltaic module of any of the preceding claims, further comprising:

   a backsheet,
   wherein one or more first portions of the backsheet have a first degree of transparency and one or more second portions of the backsheet have a second degree of transparency that is less than the first degree of transparency, and/or wherein one or more first portions of the backsheet have a first degree of reflectivity and one or more second portions of the backsheet have a second degree of reflectivity that is less than the first degree of reflectivity; and
   wherein the one or more first substrings are disposed above the one or more first portions of the backsheet, and the one or more second substrings are disposed above the one or more second portions of the backsheet.

5. The photovoltaic module of any of the preceding claims, wherein each of the first plurality of photovoltaic cells has a current collection device on a frontside face and a current collection device on a backside face.

6. The photovoltaic module of any of the preceding claims, further comprising:
a conductive backsheet comprising a plurality of conductive regions configured to electrically serially connect at least a portion of the second plurality of photovoltaic cells.

7. The photovoltaic module of any of the preceding claims, wherein each of the second plurality of photovoltaic cells has a substantially square shape comprising four sides, each of the four sides having a substantially same square side length, and wherein each of the first plurality of photovoltaic cells has a substantially rectangular shape comprising two long sides and two short sides, wherein each of the two long sides has a length substantially the same as the square side length, and each of the two short sides has a length substantially equal to 1/N of the square side length, wherein N is an integer greater than one.

8. The photovoltaic module of any of the preceding claims, wherein each of the second plurality of photovoltaic cells has a surface area, S, and wherein each of the first plurality of photovoltaic cells has a surface area substantially equal to $1/N$ of S, wherein N is an integer greater than one.

9. The photovoltaic module of any of the preceding claims, wherein each of the one or more first substrings comprises an equal quantity of photovoltaic cells as each of the one or more second substrings.

10. The photovoltaic module of any of the preceding claims, wherein the one or more first substrings comprise at least two first substring portions, each first substring portion disposed along opposing photovoltaic cell array sides, and wherein the one or more second substrings are disposed between the two first substring portions.

11. The photovoltaic module of the preceding claim, wherein each of the first substrings portions is electrically serially connected to each other; or wherein each of the first substring portions is electrically connected in parallel to each other defining a first substring group.

12. The photovoltaic module of the preceding claim, wherein the one or more second substrings further comprise:

a first substring terminal; and
a second substring terminal,
and wherein the first substring group further comprises:
a third substring terminal; and
a fourth substring terminal,
wherein an open-circuit voltage across the first and second substring terminals is greater than an open-circuit voltage across the third and fourth substring terminals.

13. The photovoltaic module of any of the preceding claims, wherein each of the one or more first substrings comprises a lesser quantity of photovoltaic cells than each of the one or more second substrings.

14. The photovoltaic module of any of the preceding claims, wherein the first plurality of photovoltaic cells and second plurality of photovoltaic cells comprise differently sized photovoltaic cells.

15. The photovoltaic module of any of the preceding claims, wherein:

the first plurality of photovoltaic cells are arranged in the one or more first substrings disposed along an inner portion of the photovoltaic modules,

the second plurality of photovoltaic cells are arranged in the one or more second substrings disposed along an outer portion of the photovoltaic modules,
wherein the one or more second substrings are electrically connected in parallel to the one or more first substrings, and where the one or more first substrings are disposed in two rows and substantially U shaped and the one or more second substrings are disposed in single rows and substantially I shaped.

16. The photovoltaic module of any of the preceding claims,

wherein the second plurality of photovoltaic cells are arranged in a single substring having a first portion and a second portion, wherein the first portion is disposed along a first edge of the photovoltaic module, and the second portion is disposed along a second edge of the photovoltaic module that is opposite the first edge of the photovoltaic module, the first portion and second portion being electrically connected in series; or wherein the second plurality of photovoltaic cells are arranged in two substrings, wherein a first substring is disposed along a first edge of the photovoltaic module, and a second substring is disposed along a second edge of the photovoltaic module that is opposite the first edge of the photovoltaic module, the first portion and second portion being electrically connected in parallel; or wherein each of the second plurality of photovoltaic cells is smaller than each of the first plurality of photovoltaic cell.

FIG. 1

**FIG. 2**

*FIG. 3A*

EP 4 207 317 A1

*FIG. 3B*

EP 4 207 317 A1

**FIG. 4**

**FIG. 5A**

**FIG. 5B**

EP 4 207 317 A1

**FIG. 5C**

**FIG. 5D**

**FIG. 5E**

*FIG. 6A*

*FIG. 6B*

**FIG. 6C**

*FIG. 6D*

FIG. 6E

FIG. 7

FIG. 8A

FIG. 8B

**FIG. 8C**

**FIG. 8D**

*FIG. 8E*

**FIG. 9**

**FIG. 10**

1100

1104A

1110

1110

1108

1108

1108

1104C    1104B

1104B    1104B    1104C    1104C

1116

**FIG. 11**

FIG. 12

## FIG. 13A

1304
1302
1300
MLPE

## FIG. 13B

1306
1304
M
1302
1300
MLPE

## FIG. 13C

1306A  1306B
1302
1300A
M  M
MLPE1  MLPE2
1302
1300B

## FIG. 13D

1306A  1306B
1304
1300A
M  M
MLPE1  MLPE2
1302
1300B

*FIG. 14A*

*FIG. 14B*

Europäisches
Patentamt

European
Patent Office

Office européen
des brevets

# EUROPEAN SEARCH REPORT

**Application Number**

EP 22 21 7226

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | KR 2016 0082013 A (KOREA ENERGY RESEARCH INST [KR]) 8 July 2016 (2016-07-08) <br> * abstract; figures 3,4,5,6,7,8,9 * <br> * paragraphs [0001], [0012] – [0021], [0028] – [0037], [0049] – [0054], [0061] – [0077], [0080] * <br> ----- | 1-6, 9-12,15 | INV. <br> H01L31/05 <br> H01L31/0352 <br> H01L31/054 <br> H02S40/22 <br> H02S40/30 <br> H02S40/34 |
| X | WO 2020/121043 A1 (MORGAN SOLAR INC [CA]; CAELERS STEPHEN [CA]) 18 June 2020 (2020-06-18) <br> * abstract; figures 2,3,4,5,11,13,14,15 * <br> * lines 88-90,92-102, paragraphs 1,3-4,7,10-12,14-19,28-30,51-53,61-63,65-68,72 * <br> ----- | 1-16 | |
| X | CN 111 725 344 A (HEFEI SUNGROW NEW ENERGY TECH CO LTD) 29 September 2020 (2020-09-29) <br> * abstract; figures 2,5a,5b,6a,6b,7,8,9,10,11 * <br> * paragraphs [0076] – [0085], [0088] – [0128] * <br> ----- | 1-3,5, 9-12,15, 16 | |
| X | CN 213 242 565 U (JIANGSU LONGI LEYE PHOTOVOLTAIC TECH CO LTD) 18 May 2021 (2021-05-18) <br> * abstract; figures 1,2,5 * <br> * paragraphs [0001], [0002] – [0003], [0004] – [0018], [0034] – [0055], [0058] * <br> ----- <br> -/-- | 1-3,7,8, 10,11, 13,14 | |

| TECHNICAL FIELDS SEARCHED (IPC) |
|---|
| H01L <br> H02S |

The present search report has been drawn up for all claims

| Place of search | Date of completion of the search | Examiner |
|---|---|---|
| Berlin | 8 May 2023 | Sagol, Bülent Erol |

EPO FORM 1503 03.82 (P04C01)

**page 1 of 2**

Europäisches
Patentamt

European
Patent Office

Office européen
des brevets

# EUROPEAN SEARCH REPORT

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | DELINE CHRIS ET AL: "Estimating and parameterizing mismatch power loss in bifacial photovoltaic systems", PROGRESS IN PHOTOVOLTAICS: RESEARCH AND APPLICATIONS, [Online] vol. 28, no. 7, 6 March 2020 (2020-03-06), pages 691-703, XP055905894, Hoboken, USA ISSN: 1062-7995, DOI: 10.1002/pip.3259 * the whole document * ----- | 1-6, 9-12,15, 16 | |

**TECHNICAL FIELDS SEARCHED (IPC)**

The present search report has been drawn up for all claims

| Place of search | Date of completion of the search | Examiner |
|---|---|---|
| Berlin | 8 May 2023 | Sagol, Bülent Erol |

CATEGORY OF CITED DOCUMENTS

X : particularly relevant if taken alone
Y : particularly relevant if combined with another
   document of the same category
A : technological background
O : non-written disclosure
P : intermediate document

T : theory or principle underlying the invention
E : earlier patent document, but published on, or
   after the filing date
D : document cited in the application
L : document cited for other reasons

......................................................................
& : member of the same patent family, corresponding
   document

EPO FORM 1503 03.82 (P04C01)

## ANNEX TO THE EUROPEAN SEARCH REPORT
## ON EUROPEAN PATENT APPLICATION NO.

EP 22 21 7226

This annex lists the patent family members relating to the patent documents cited in the above-mentioned European search report.
The members are as contained in the European Patent Office EDP file on
The European Patent Office is in no way liable for these particulars which are merely given for the purpose of information.

08-05-2023

| Patent document cited in search report | Publication date | Patent family member(s) | | Publication date |
|---|---|---|---|---|
| KR 20160082013 A | 08-07-2016 | NONE | | |
| WO 2020121043 A1 | 18-06-2020 | CA | 3122226 A1 | 18-06-2020 |
| | | CN | 111327266 A | 23-06-2020 |
| | | CN | 210183284 U | 24-03-2020 |
| | | EP | 3895222 A1 | 20-10-2021 |
| | | US | 2022077817 A1 | 10-03-2022 |
| | | WO | 2020121043 A1 | 18-06-2020 |
| CN 111725344 A | 29-09-2020 | NONE | | |
| CN 213242565 U | 18-05-2021 | NONE | | |

EPO FORM P0459

For more details about this annex : see Official Journal of the European Patent Office, No. 12/82

**REFERENCES CITED IN THE DESCRIPTION**

**Patent documents cited in the description**

- US 63295177